# EUROPEAN PATENT APPLICATION

(11) **EP 4 289 916 A1**
(43) Date of publication of application: **13.12.2023**
(21) Application number: 23165470.8
(22) Date of filing: 30.03.2023
(51) Int. Cl.: C09K 11/00, H10K 85/00, C07F 5/02

(54) **CONDENSED CYCLIC COMPOUND, LIGHT-EMITTING DEVICE INCLUDING THE SAME, AND ELECTRONIC APPARATUS INCLUDING THE LIGHT-EMITTING DEVICE**

(30) Priority: 07.06.2022 KR 20220069107
(71) Applicant: Samsung Display Co., Ltd., Yongin-si, Gyeonggi-do 17113 (KR)
(72) Inventor: Kim, Seran, 17113 Giheung-gu, Yongin-si, Gyeonggi-do (KR); Kim, Hoilim, 17113 Giheung-gu, Yongin-si, Gyeonggi-do (KR); Yoo, Dongsun, 17113 Giheung-gu, Yongin-si, Gyeonggi-do (KR)
(74) Representative: Dr. Weitzel & Partner

(57) **Abstract**

Provided are a light-emitting device including a condensed cyclic compound represented by Formula 1, an electronic apparatus including the light-emitting device, and the condensed cyclic compound. Formula 1 is the same as described in the present specification.

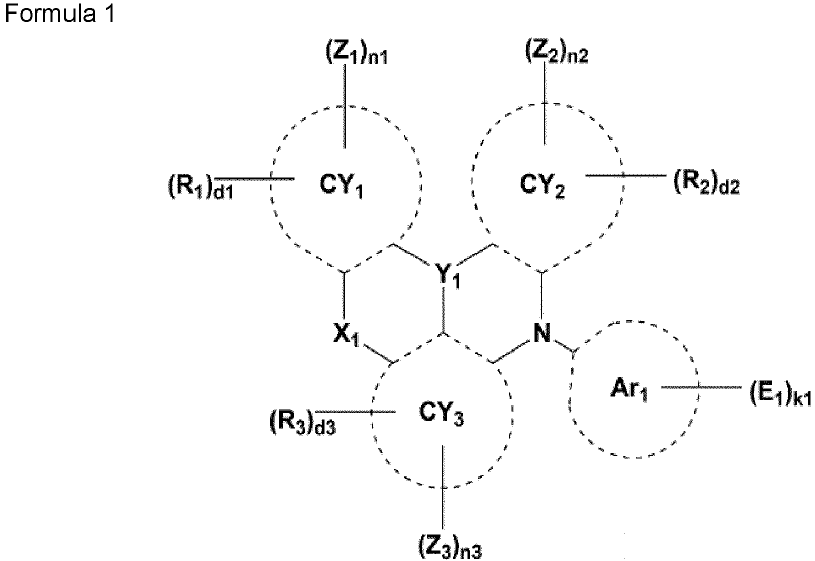

## Description

### BACKGROUND

### 1. Field

The present invention relates to a condensed cyclic compound, a light-emitting device including the same, and an electronic apparatus including the light-emitting device.

### 2. Description of the Related Art

From among light-emitting devices, organic light-emitting devices are self-emissive devices that, as compared with other devices of the related art, have wide viewing angles, high contrast ratios, short response times, and excellent characteristics in terms of luminance, driving voltage, and response speed, and produce full-color images.

In an example, an organic light-emitting device may have a structure in which a first electrode is arranged on a substrate, and a hole transport region, an emission layer, an electron transport region, and a second electrode are sequentially formed on the first electrode. Holes provided from the first electrode may move toward the emission layer through the hole transport region, and electrons provided from the second electrode may move toward the emission layer through the electron transport region. Carriers, such as holes and electrons, may recombine in such an emission layer region to produce excitons. These excitons transition from an excited state to the ground state to thereby generate light.

### SUMMARY

A condensed cyclic compound according to the present invention is defined by the features of claim 1. The dependent claims describe preferred embodiments and and a light-emitting device including the condensed cyclic compound, and an electronic apparatus including the light-emitting device.

Additional aspects of embodiments will be set forth in part in the description which follows and, in part, will be apparent from the description, or may be learned by practice of the presented embodiments of the disclosure.

According to the present invention, provided is a condensed cyclic compound.

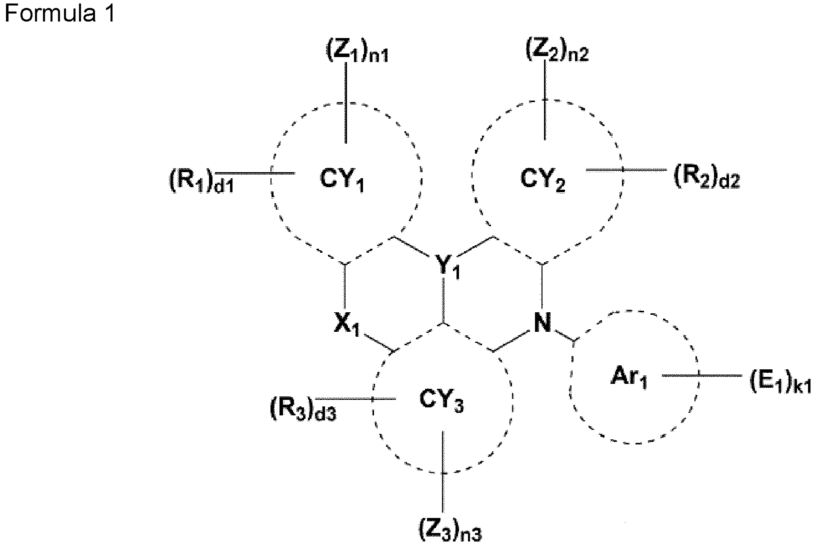

In Formula 1,
CY₁ to CY₃ may each independently be a C₆-C₃₀ carbocyclic group or a C₂-C₃₀ heterocyclic group,
X₁ may be O, S, Se, C(R₄)(R₅), Si(R₄)(R₅), or N(R₄),
Y₁ may be B, P(=O), or P(=S),
Z₁ to Z₃ may satisfy Condition 1 or Condition 2,
Condition 1
Z₁ and Z₂ are each independently an electron withdrawing group, and Z₃ is an electron donating group
Condition 2
Z₁ and Z₂ are each independently an electron donating group, and Z₃ is an electron withdrawing group
wherein the electron withdrawing group may be -F or a cyano group, a C₁-C₆₀ alkyl group, a C₂-C₆₀ alkenyl group, a C₂-C₆₀ alkynyl group, a C₃-C₆₀ carbocyclic group, or a C₁-C₆₀ heterocyclic group, each substituted with -F, a cyano group, or any combination thereof, or a π electron-deficient nitrogen-containing C₁-C₆₀ cyclic group, and
the electron donating group may be -N(R₆)(R₇) or a π electron-rich C₃-C₆₀ cyclic group that is unsubstituted or substituted with at least one R₁₀ₐ, wherein a benzene group and a cyclohexene group, each unsubstituted or substituted with at least one R₁₀ₐ, may be excluded,
n1 and n2 may each independently be an integer from 0 to 10, wherein a sum of n1 and n2 may be an integer of 1 or more,
n3 may be an integer from 1 to 10,
R₁ to R₇ may each independently be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
d1 to d3 may each independently be an integer from 0 to 10,
two or more neighboring groups of R₁ to R₇ may optionally be bonded to each other to form a C₅-C₃₀ carbocyclic group that is unsubstituted or substituted with at least one R₁₀ₐ or a C₂-C₃₀ heterocyclic group that is unsubstituted or substituted with at least one R₁₀ₐ,
Ar₁ may be a C₆-C₃₀ carbocyclic group or a C₂-C₃₀ heterocyclic group,
E₁ may be hydrogen, deuterium, -F, -Cl, -Br, -I, a hydroxyl group, a cyano group, a nitro group, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
k1 may be an integer from 0 to 10,
R₁₀ₐ may be
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ may each independently be hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof, a C₇-C₆₀ aryl alkyl group, or a C₂-C₆₀ heteroaryl alkyl group.

According to the present invention, provided is a light-emitting device including a first electrode,
a second electrode facing the first electrode,
an interlayer between the first electrode and the second electrode and including an emission layer, and
at least one condensed cyclic compound according to the present invention.

According to the present invention, provided is an electronic apparatus including the light-emitting device.

### BRIEF DESCRIPTION OF THE DRAWINGS

The above and other aspects and features of certain embodiments of the disclosure will be more apparent from the following description taken in conjunction with the accompanying drawings, in which:
FIG. 1 is a schematic cross-sectional view of a structure of a light-emitting device according to an embodiment; and
FIGS. 2 and 3 are each a schematic cross-sectional view of an electronic apparatus according to an embodiment.

### DETAILED DESCRIPTION

Reference will now be made in more detail to embodiments, examples of which are illustrated in the accompanying drawings, wherein like reference numerals refer to like elements throughout the present specification. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

A condensed cyclic compound according to the present invention is represented by Formula 1: 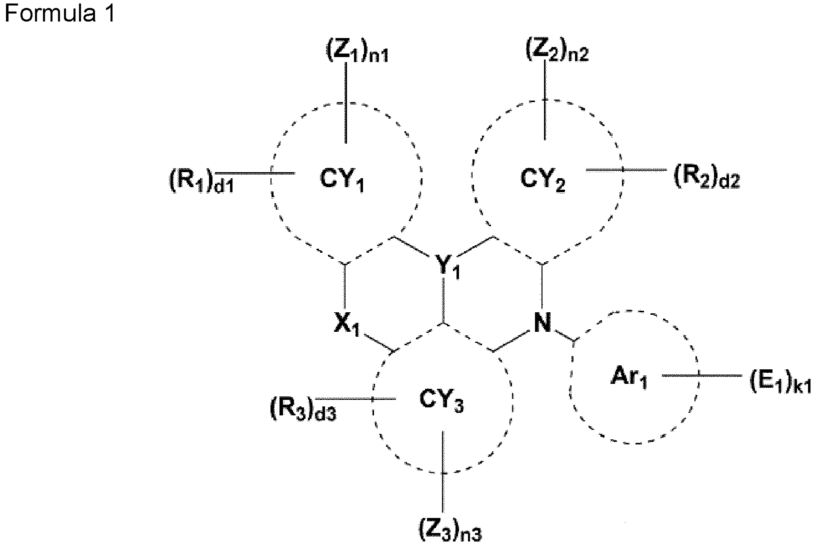
wherein, in Formula 1,
CY₁ to CY₃ may each independently be a C₆-C₃₀ carbocyclic group or a C₂-C₃₀ heterocyclic group.

In an embodiment, CY₁ to CY₃ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, an pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzotriazole, a benzoxazole group, a benzothiazole group, a benzoxadiazole group, a benzothiadiazole group, a 5,6,7,8-tetrahydroisoquinoline group, or a 5,6,7,8-tetrahydroquinoline group.

X₁ may be O, S, Se, C(R₄)(R₅), Si(R₄)(R₅), or N(R₄). For example, X₁ may be N(R₄).

Y₁ may be B, P(=O), or P(=S).

In an embodiment, R₄ may be a C₆-C₃₀ carbocyclic group or a C₂-C₃₀ heterocyclic group, each unsubstituted or substituted with at least one R₁₀ₐ, and R₁₀ₐ may be the same as described in the present specification.

Z₁ to Z₃ may satisfy Condition 1 or Condition 2:
Condition 1
   Z₁ and Z₂ are each independently an electron withdrawing group, and Z₃ is an electron donating group
Condition 2
   Z₁ and Z₂ are each independently an electron donating group, and Z₃ is an electron withdrawing group
   The electron withdrawing group may be: -F or a cyano group; a C₁-C₆₀ alkyl group, a C₂-C₆₀ alkenyl group, a C₂-C₆₀ alkynyl group, a C₃-C₆₀ carbocyclic group, or a C₁-C₆₀ heterocyclic group, each substituted with -F, a cyano group, or any combination thereof; or a π electron-deficient nitrogen-containing C₁-C₆₀ cyclic group, and
   the electron donating group may be -N(R₆)(R₇) or a π electron-rich C₃-C₆₀ cyclic group that is unsubstituted or substituted with at least one R₁₀ₐ, wherein a benzene group and a cyclohexene group, each unsubstituted or substituted with at least one R₁₀ₐ, may be excluded.
   The π electron-deficient nitrogen-containing C₁-C₆₀ cyclic group may refer to a heterocyclic group that has one to sixty carbon atoms and includes *-N=*' as a ring-forming moiety, and
   The π electron-rich C₃-C₆₀ cyclic group may refer to a cyclic group that has three to sixty carbon atoms and does not include *-N=*', wherein a benzene group and a cyclohexene group may be excluded.

For example, the π electron-deficient nitrogen-containing C₁-C₆₀ cyclic group may be a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group, and
the π electron-rich C₃-C₆₀ cyclic group may be a cyclopentadiene group, an adamantane group, a norbornane group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indeno phenanthrene group, an indenoanthracene group, a 1H-pyrrole group, a silole group, a borole group, a 2H-pyrrole group, a 3H-pyrrole group, a thiophene group, a furan group, an indole group, a benzoindole group, a naphthoindole group, an iso-indole group, a benzoiso-indole group, a naphthoiso-indole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, or a benzothienodibenzothiophene group.

In an embodiment, Z₁ and Z₂ may be identical to or different from each other.
n1 and n2 may each independently be an integer from 0 to 10, wherein the sum of n1 and n2 may be an integer of 1 or more.

In an embodiment, the sum of n1 and n2 may be an integer of 2 or more.

In an embodiment, n1 may be an integer of 1 or more, and n2 may be an integer of 1 or more.
n3 may be an integer from 1 to 10.

For example, n3 may be 1.

R₁ to R₇ may each independently be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂).

In an embodiment, R₁ to R₇ may each independently be: hydrogen, deuterium, -F, -Cl, -Br, -I, a hydroxyl group, a cyano group, a nitro group, an amidino group, a hydrazine group, a hydrazone group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, - I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, -Si(Q₃₁)(Q₃₂)(Q₃₃), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-Si(Q₁)(Q₂)(Q₃), -B(Q₁)(Q₂), -C(=O)(Q₁), -S(=O)₂(Q₁), or -P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, a triazinyl group, a carbazolyl group, a dibenzofuranyl group, or a dibenzothiophenyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, a carbazolyl group, a dibenzofuranyl group, a dibenzothiophenyl group, or any combination thereof.
d1 to d3 may each independently be an integer from 0 to 10.

Two or more neighboring groups of R₁ to R₇ may optionally be bonded to each other to form a C₅-C₃₀ carbocyclic group that is unsubstituted or substituted with at least one R₁₀ₐ or a C₂-C₃₀ heterocyclic group that is unsubstituted or substituted with at least one R₁₀ₐ.

Ar₁ may be a C₆-C₃₀ carbocyclic group or a C₂-C₃₀ heterocyclic group.

E₁ may be hydrogen, deuterium, -F, -Cl, -Br, -I, a hydroxyl group, a cyano group, a nitro group, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂).

For example, E₁ may be hydrogen, a C₃-C₆₀ carbocyclic group that is unsubstituted or substituted with at least one R₁₀ₐ or a C₁-C₆₀ heterocyclic group that is unsubstituted or substituted with at least one R₁₀ₐ.

In an embodiment, E₁ may be: hydrogen, deuterium, -F, -Cl, -Br, -I, a hydroxyl group, a cyano group, a nitro group, an amidino group, a hydrazine group, a hydrazone group, or a C₁-C₂₀ alkoxy group;
a C₁-C₂₀ alkoxy group that is substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, or an azadibenzosilolyl group, each unsubstituted or substituted with deuterium, -F, -Cl, -Br, - I, -CD₃, -CD₂H, -CDH₂, -CF₃, -CF₂H, -CFH₂, a hydroxyl group, a cyano group, a nitro group, an amidino group, a hydrazine group, a hydrazone group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a C₁-C₁₀ alkylphenyl group, a naphthyl group, a tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a cinnolinyl group, a carbazolyl group, a phenanthridinyl group, an acridinyl group, a phenanthrolinyl group, a phenazinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a thiadiazolyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, -Si(Q₃₁)(Q₃₂)(Q₃₃), -B(Q₃₁)(Q₃₂), -P(Q₃₁)(Q₃₂), -C(=O)(Q₃₁), - S(=O)₂(Q₃₁), -P(=O)(Q₃₁)(Q₃₂), or any combination thereof; or
-Si(Q₁)(Q₂)(Q₃), -B(Q₁)(Q₂), -C(=O)(Q₁), -S(=O)₂(Q₁), or -P(=O)(Q₁)(Q₂), and
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, a triazinyl group, a carbazolyl group, a dibenzofuranyl group, or a dibenzothiophenyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, a carbazolyl group, a dibenzofuranyl group, a dibenzothiophenyl group, or any combination thereof.
k1 may be an integer from 0 to 10.

In an embodiment, E₁ may not be hydrogen, and k1 may be an integer of 1 or more.

In an embodiment, a moiety represented by 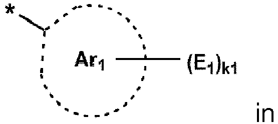 Formula 1 may be represented by one of Formulae 4-1 to 4-3: 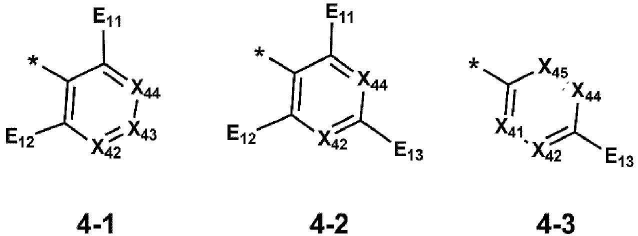 wherein, in Formulae 4-1 to 4-3,
E₁₁ to E₁₃ may each independently be the same as described in connection with E₁,
X₄₁ may be C(R₄₁) or N,
X₄₂ may be C(R₄₂) or N,
X₄₃ may be C(R₄₃) or N,
X₄₄ may be C(R₄₄) or N,
X₄₅ may be C(R₄₅) or N,
R₄₁ to R₄₅ may each independently be hydrogen, deuterium, -F, -Cl, -Br, -I, a hydroxyl group, a cyano group, or a nitro group, and
* indicates a binding site to a neighboring atom.
R₁₀ₐ may be:
   deuterium, -F, -Cl, -Br, -I, a hydroxyl group, a cyano group, or a nitro group;
   a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Qn), -S(=O)₂(Q₁₁), -P(=O)(Q₁₁)(Q₁₂), or any combination thereof;
   a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁(Q₂₂), - C(=O)(Q₂₁), -S(=O)₂(Q₂₁), -P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
   Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ aryl alkyl group; or a C₂-C₆₀ heteroaryl alkyl group.

In an embodiment, a moiety represented by 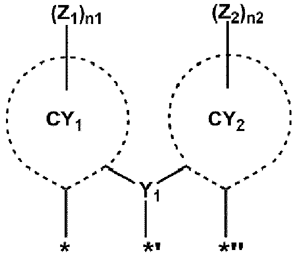 in Formula 1 may be one of Formulae 2-1 to 2-16: 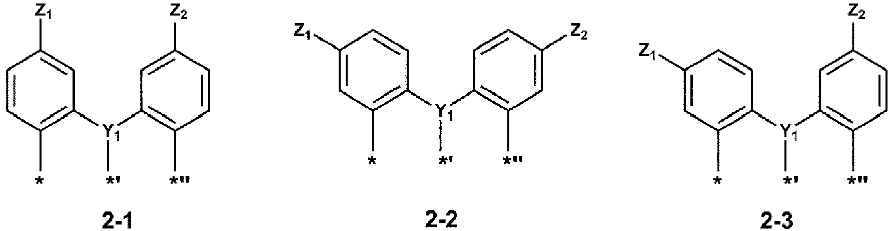 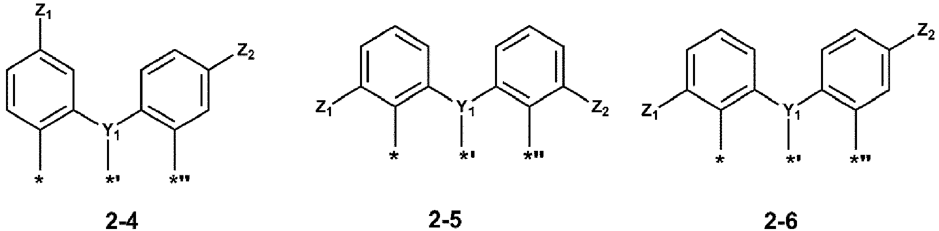 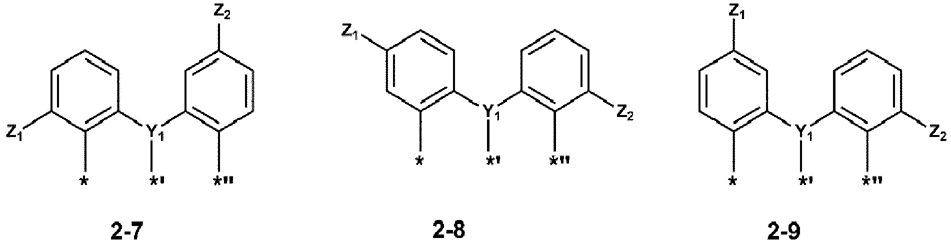 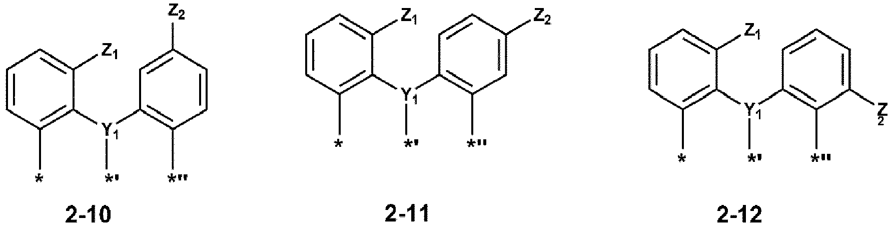 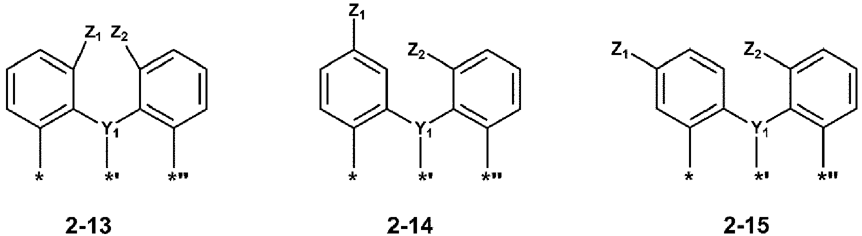 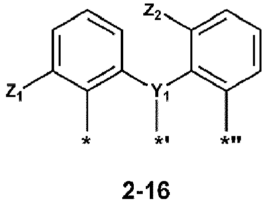 wherein, in Formulae 2-1 to 2-16,
Z₁, Z₂, and Y₁ may each independently be the same as described in the present specification, and
*, *', and *" may each indicate a binding site to a neighboring atom.

In an embodiment, a moiety represented by 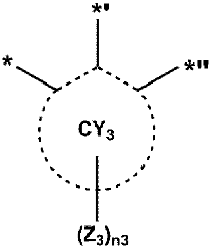 in Formula 1 may be one of Formulae 3-1 to 3-3: 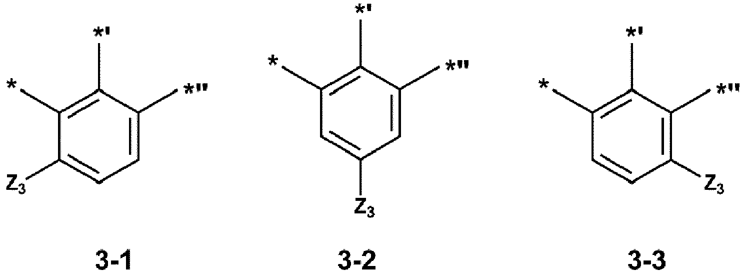 wherein, in Formulae 3-1 to 3-3,
Z₃ is the same as described in the present specification, and
*, *', and *" may each indicate a binding site to a neighboring atom.

In an embodiment, the condensed cyclic compound represented by Formula 1 may satisfy at least one of Condition 3 and Condition 4:
Condition 3
   the highest occupied molecular orbital (HOMO) energy of the condensed cyclic compound is about -4.80 eV or less; and
Condition 4
   the lowest unoccupied molecular orbital (LUMO) energy of the condensed cyclic compound is about -1.30 eV or less.

In an embodiment, the HOMO energy of the condensed cyclic compound represented by Formula 1 may be about -4.80 eV or less. For example, the HOMO energy of the condensed cyclic compound represented by Formula 1 may be about - 4.80 eV or less, about -4.90 eV or less, about -5.00 eV or less, about -5.10 eV or less, about -5.20 eV or less, or about -5.30 eV or less. For example, the HOMO energy of the condensed cyclic compound represented by Formula 1 may be about -5.60 eV or more and about -5.30 eV or less, but embodiments are not limited thereto.

In an embodiment, the lowest unoccupied molecular orbital (LUMO) energy of the condensed cyclic compound represented by Formula 1 may be about -1.30 eV or less. For example, a LUMO energy of the condensed cyclic compound represented by Formula 1 may be about -1.30 eV or less, about -1.40 eV or less, about -1.50 eV or less, about -1.60 eV or less, or about -1.70 eV or less. For example, the LUMO energy of the condensed cyclic compound represented by Formula 1 may be about -2.30 eV or more and about -1.70 eV or less, but embodiments are not limited thereto.

The HOMO and LUMO energies may be values calculated by a density functional theory (DFT) method utilizing the Gaussian program with the structure optimization at the level of B3LYP/6-311G (e.g., utilizing a B3LYP hybrid functional and a 6-311G basis set).

When the HOMO energy and/or the LUMO energy are within the above ranges, a balance between an electron injection effect and a multiple resonance effect may be achieved, and the condensed cyclic compound may have both excellent emission efficiency and excellent lifespan.

In an embodiment, the condensed cyclic compound represented by Formula 1 may be a delayed fluorescence material.

In an embodiment, the condensed cyclic compound represented by Formula 1 may be one of Compounds 1 to 72, but embodiments are not limited thereto:

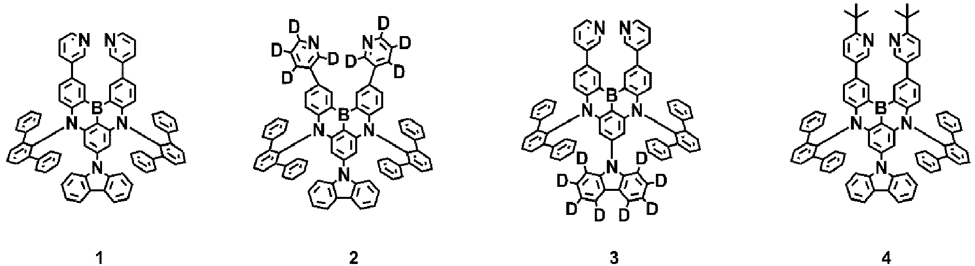

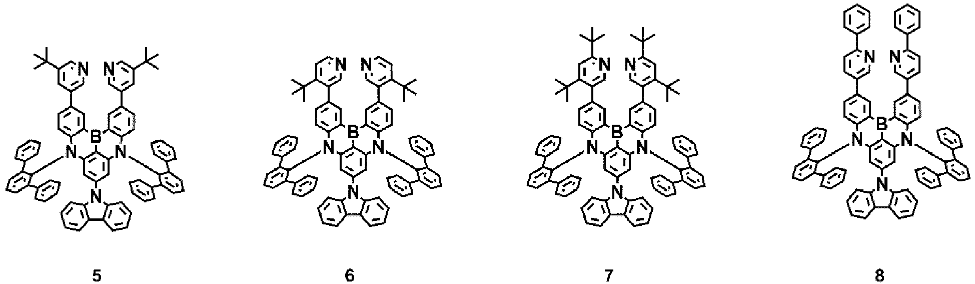

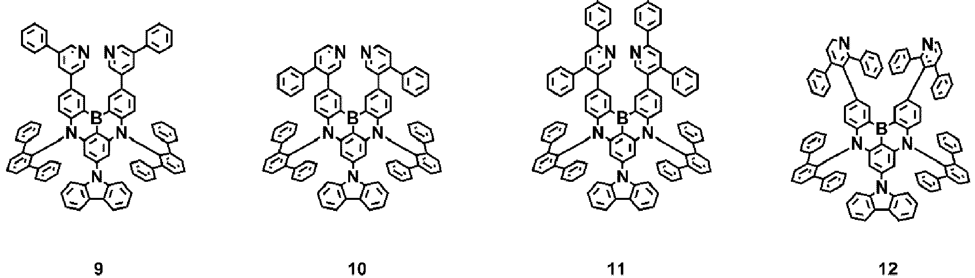

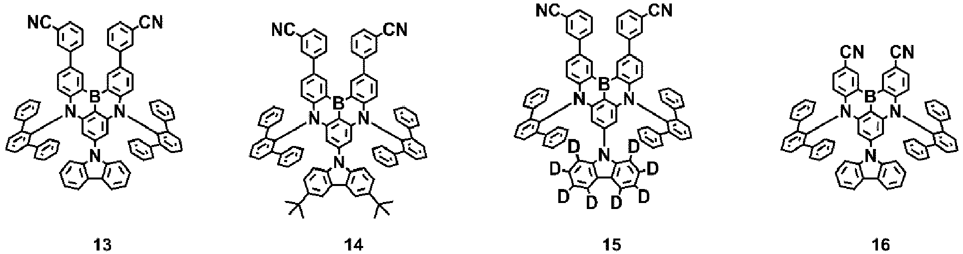

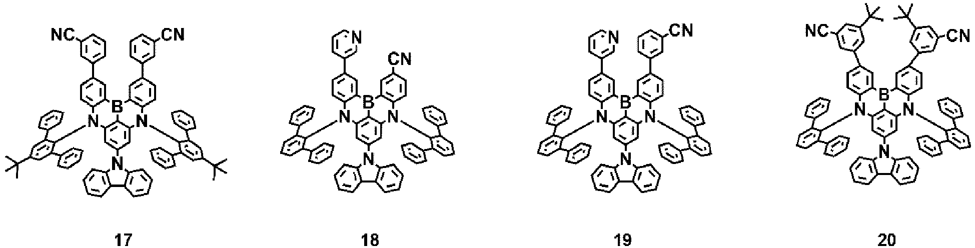

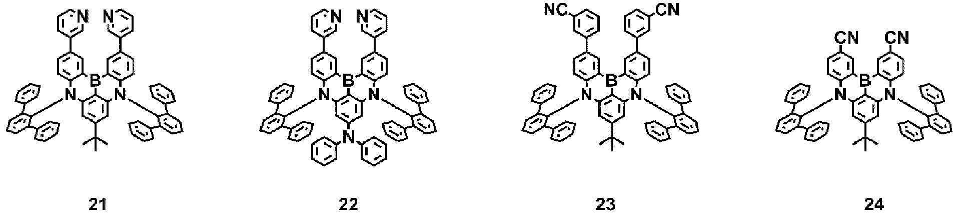

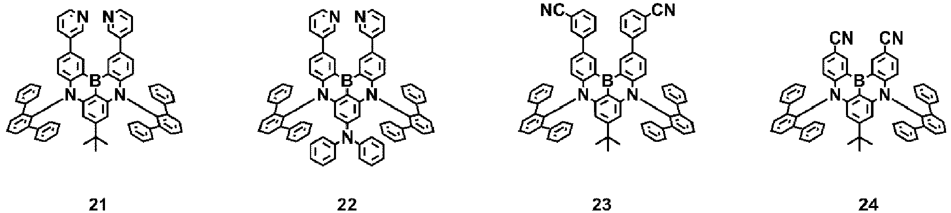

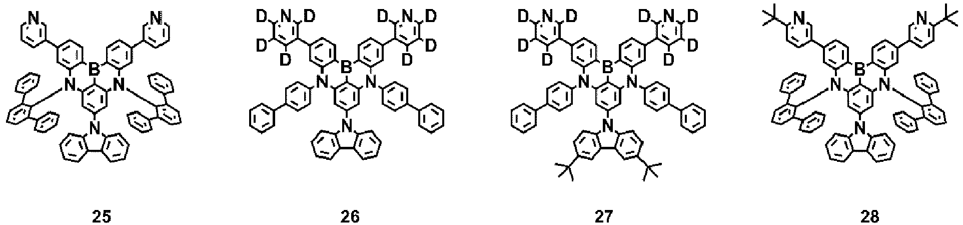

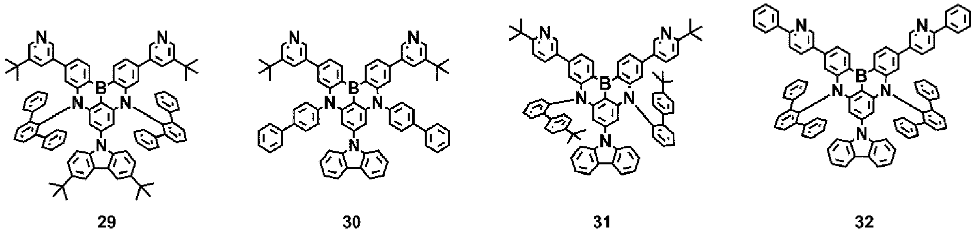

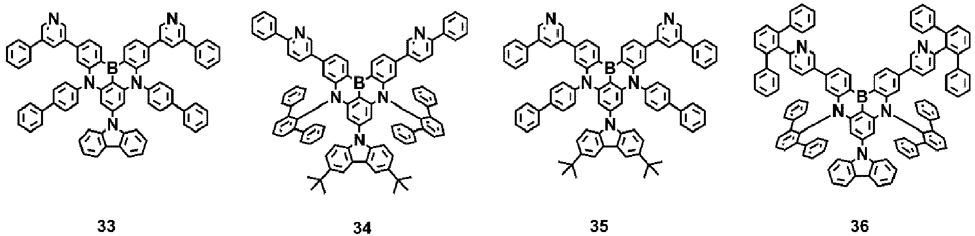

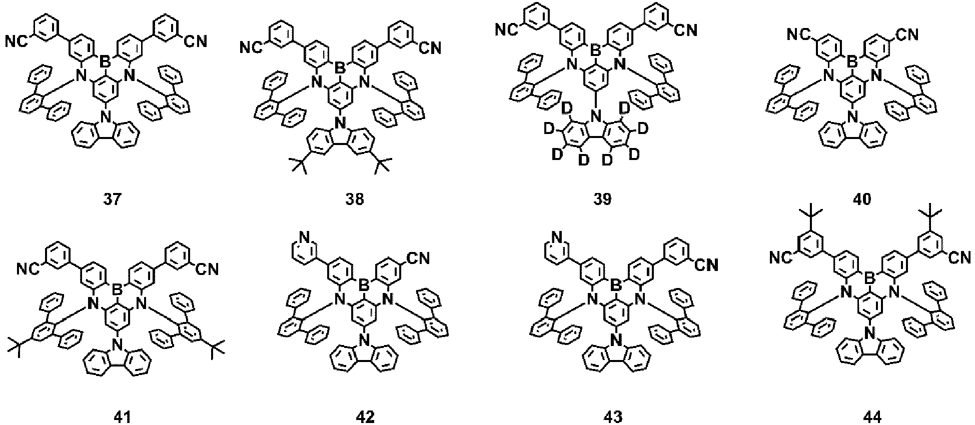

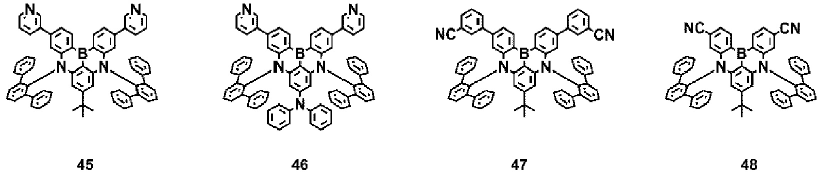

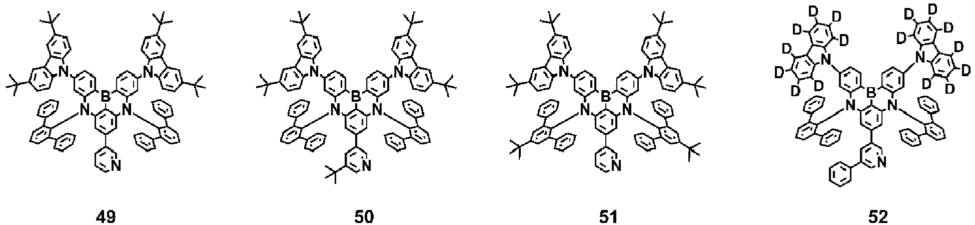

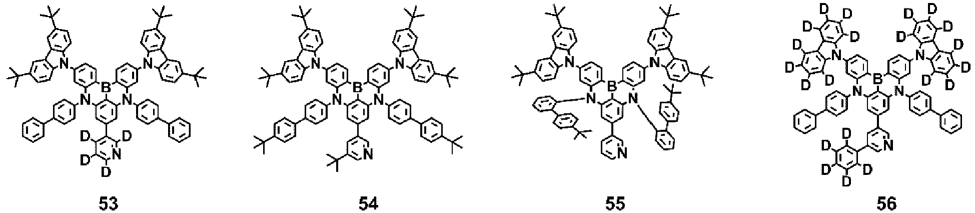

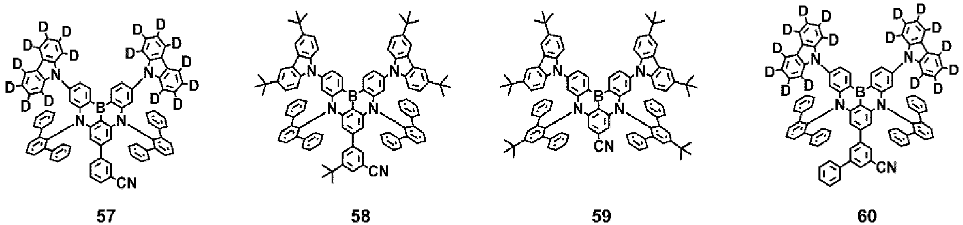

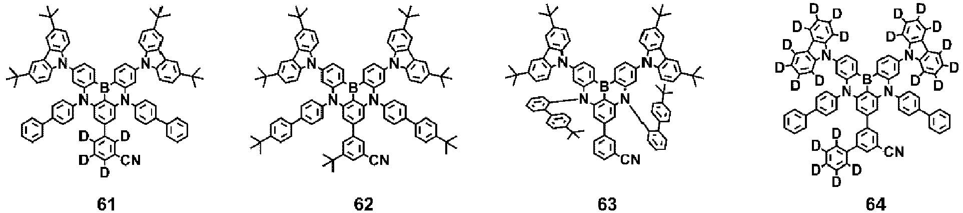

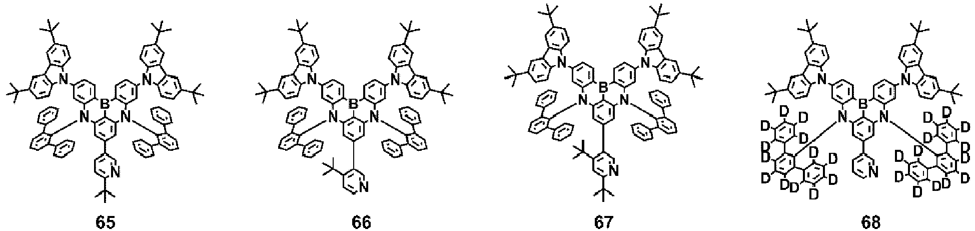

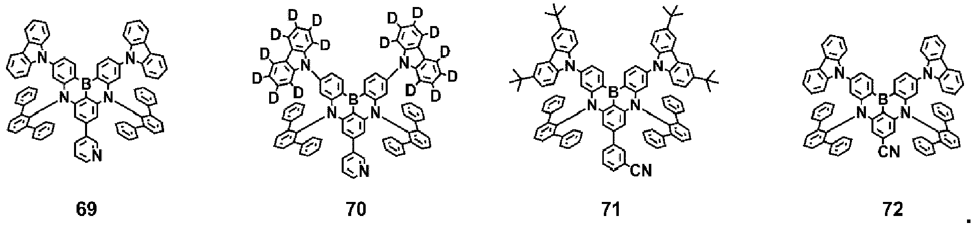

The condensed cyclic compound represented by Formula 1 has a boron-based condensed cyclic core having a multiple resonance effect, wherein the boron-based condensed cyclic core may include an electron donating group capable of improving emission efficiency and color characteristics and an electron withdrawing group capable of improving stability.

The core of the condensed cyclic compound represented by Formula 1 may have a structure including at least one N, and by having such a structure, multiple resonance in the core may be further activated (e.g., increased), delocalization of electrons in the molecule may expand (e.g., may be increased), and polarizability may increase to further increase an f value.

In addition, N of the core of the condensed cyclic compound may be substituted with Ar₁, which is a C₆-C₃₀ carbocyclic group or a C₂-C₃₀ heterocyclic group, each unsubstituted or substituted with E₁. The condensed cyclic compound includes a substituent having a large steric hindrance, thereby protecting an otherwise chemically unstable boron atom and maintaining a physical distance from a sensitizer in the emission layer. Therefore, stability of the condensed cyclic compound may increase, and device lifespan may be improved.

As the condensed cyclic compound represented by Formula 1 has the core including a substituent of the electron donating group, electron density in the multi-resonant core may increase, thereby further promoting (e.g., increasing) multiple resonance in the core, and as the condensed cyclic compound represented by Formula 1 has the core including a substituent of the electron withdrawing group, material stability may be improved, thereby improving efficiency and lifespan of the light-emitting device according to electrical/thermal stability.

Therefore, an electronic device, for example, a light-emitting device, including the condensed cyclic compound represented by Formula 1 may have low driving voltage, high luminance, high efficiency, and long lifespan.

Synthesis methods of the condensed cyclic compound represented by Formula 1 may be recognized by one of ordinary skill in the art by referring to the following Examples.

At least one condensed cyclic compound represented by Formula 1 may be used in a light-emitting device (for example, an organic light-emitting device).

According to one or more embodiments, provided is a light-emitting device including: a first electrode; a second electrode facing the first electrode; an interlayer arranged between the first electrode and the second electrode and including an emission layer; and at least one condensed cyclic compound.

In an embodiment, the first electrode may be an anode,
the second electrode may be a cathode,
the interlayer may include the condensed cyclic compound,
the interlayer may further include a hole transport region between the emission layer and the first electrode and an electron transport region between the emission layer and the second electrode,
the hole transport region may include a hole injection layer, a hole transport layer, an emission auxiliary layer, an electron blocking layer, or any combination thereof, and
the electron transport region may include a buffer layer, a hole blocking layer, an electron control layer, an electron transport layer, an electron injection layer, or any combination thereof.

In an embodiment, the emission layer may include the condensed cyclic compound represented by Formula 1.

In an embodiment, an amount of the condensed cyclic compound may be about 0.01 parts by weight to about 49.99 parts by weight, based on the total 100 parts by weight of the emission layer.

In an embodiment, the emission layer may further include a first compound and/or a second compound,
the first compound may be a hole-transporting compound, and
the second compound may be an electron-transporting compound.

The hole-transporting compound may refer to i) a compound including at least one electron donating group and/or ii) a compound that does not include an electron withdrawing group.

The electron-transporting compound may refer to a compound including at least one electron withdrawing group.

In an embodiment, the first compound and the condensed cyclic compound represented by Formula 1 may be different from each other.

In an embodiment, the second compound and the condensed cyclic compound represented by Formula 1 may be different from each other.

In an embodiment, the first compound and the second compound may act as an exciplex host.

In an embodiment, the first compound may include a compound represented by Formula 20-1, a compound represented by Formula 20-2, a compound represented by Formula 20-3, a compound represented by Formula 20-4, a compound represented by Formula 20-5, or any combination thereof: 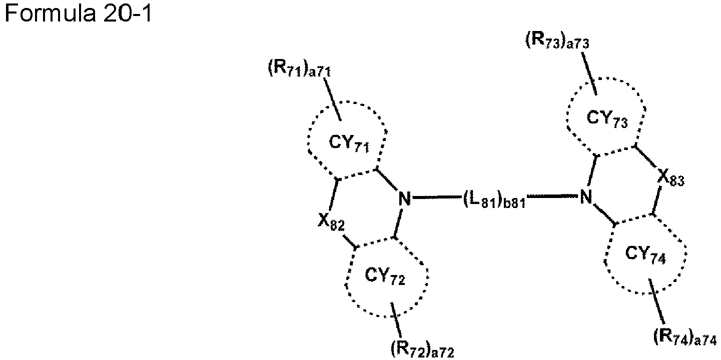 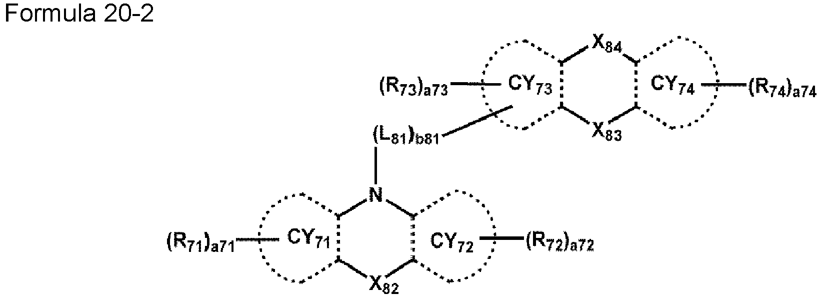 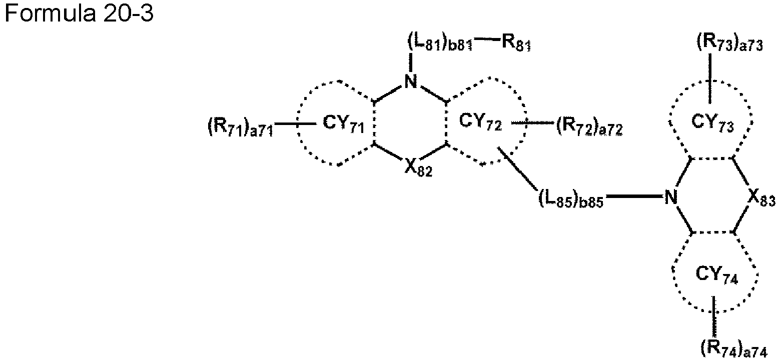 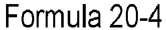 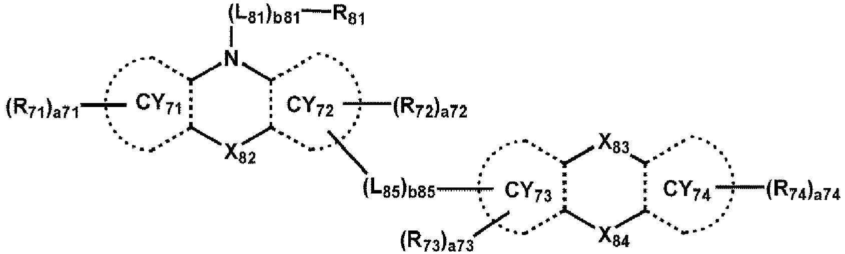 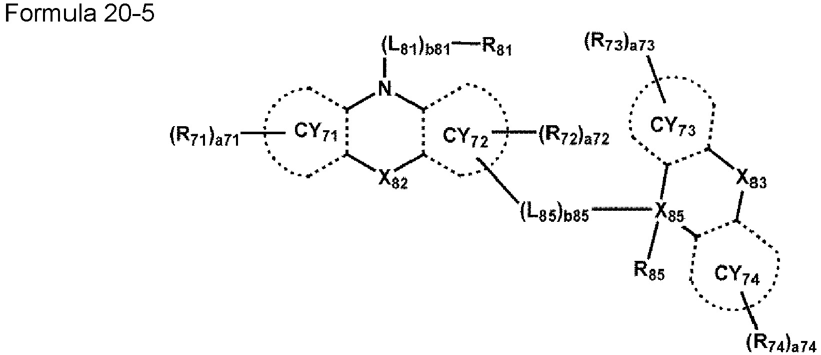 wherein, in Formulae 20-1 to 20-5,
ring CY₇₁ to ring CY₇₄ may each independently be an π electron-rich C₃-C₆₀ cyclic group or a pyridine group,
X₈₂ may be a single bond, O, S, N-[(L₈₂)_{b82}-R₈₂], C(R₈₂ₐ)(R_{82b}), or Si(R₈₂ₐ)(R_{82b}),
X₈₃ may be a single bond, O, S, N-[(L₈₃)_{b83}-R₈₃], C(R₈₃ₐ)(R_{83b}), or Si(R₈₃ₐ)(R_{83b}),
X₈₄ may be O, S, N-[(L₈₄)_{b84}-R₈₄], C(R₈₄ₐ)(R_{84b}), or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group that is unsubstituted or substituted with at least one R₁₀ₐ, or a pyridine group that is unsubstituted or substituted with at least one R₁₀ₐ, wherein Q₄ and Q₅ may each independently be the same as described in connection with Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each independently be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
a71 to a74 may each independently be an integer from 0 to 20, and
Q₁ to Q₃ and R₁₀ₐ may each independently be the same as described in the present specification.

In an embodiment, the second compound may include a pyridine group, a pyrimidine group, a pyrazine group, a pyridazine group, a triazine group, or any combination thereof.

In an embodiment, the second compound may include a compound represented by Formula 30: 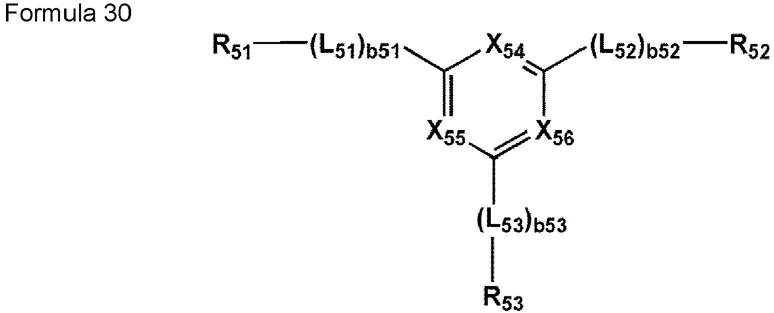 wherein, in Formula 30,
L₅₁ to L₅₃ may each independently be a single bond, a C₃-C₆₀ carbocyclic group that is unsubstituted or substituted with at least one R₁₀ₐ, or a C₁-C₆₀ heterocyclic group that is unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), and at least one of X₅₄ to X₅₆ may be N,
R₅₁ to R₅₆ may each independently be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -C(Q₁)(Q₂)(Q₃), -Si(Q₁)(Q₂)(Q₃), -N(Q₁)(Q₂), - B(Q₁)(Q₂), -C(=O)(Q₁), -S(=O)₂(Q₁), or -P(=O)(Q₁)(Q₂), and
R₁₀ₐ and Q₁ to Q₃ may each independently be the same as described in the present specification.

In an embodiment, the emission layer may further include a third compound, and
the third compound may be a metal-containing compound.

In an embodiment, the third compound may act as a sensitizer, for example, a phosphorescent sensitizer.

In an embodiment, the third compound may not emit light.

A light emission path of the light-emitting device according to an embodiment may follow a path in which the first compound and the second compound form an exciton (first step), for example, by facilitating the formation of an exciton, energy of the exciton is transferred to the third compound (second step), and the energy is transferred from the third compound to the condensed cyclic compound represented by Formula 1 of the present application (third step).

In an embodiment, the third compound may be represented by Formula 40: Formula 40

M₃₁(L₃₁)ₙ₃₁(L₃₂)ₙ₃₂

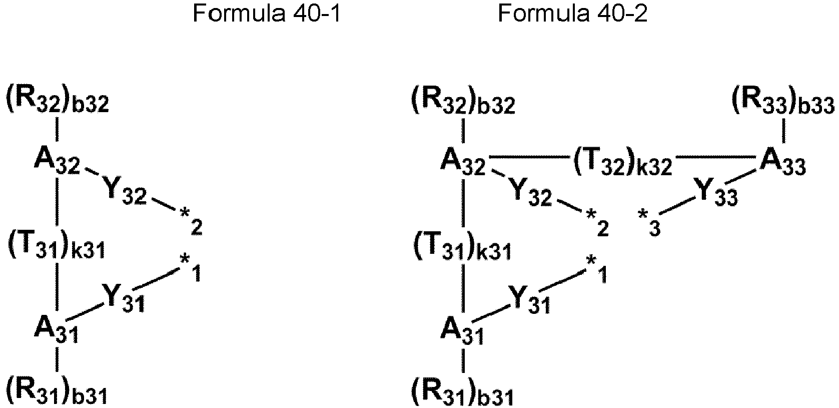

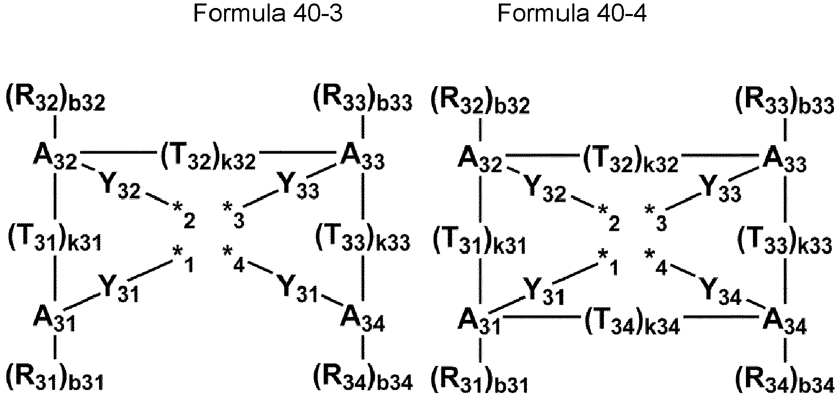

wherein, in Formulae 40 and 40-1 to 40-4,
M₃₁ may be a first-row transition metal of the Periodic Table of Elements, a second-row transition metal of the Periodic Table of Elements, or a third-row transition metal of the Periodic Table of Elements,
L₃₁ may be a ligand represented by one of Formulae c-1 to c-4,
L₃₂ may be a monodentate ligand, a bidentate ligand, or a tridentate ligand,
n31 may be 1 or 2,
n32 may be 0, 1, 2, 3, or 4,
A₃₁ to A₃₄ may each independently be a C₆-C₃₀ carbocyclic group or a C₁-C₃₀ heterocyclic group,
T₃₁ to T₃₄ may each independently be a single bond, a double bond, *-O-*', *-S-*', *-C(=O)-*', *-S(=O)-*', *-C(R₃₅)(R₃₆)-*', *-C(R₃₅)=C(R₃₆)-*', *-C(R₃₅)=*', *-Si(R₃₅)(R₃₆)-", *-B(R₃₅)-*', *-N(R₃₅)-*', or *-P(R₃₅)-*',
k31 to k34 may each independently be 1, 2, or 3,
Y₃₁ to Y₃₄ may each independently be a single bond, *-O-*', *-S-*', *-C(R₃₇)(R₃₈)-*', *-Si(R₃₇)(R₃₈)-*', *-B(R₃₇)-*', *-N(R₃₇)-*', or *-P(R₃₇)-*',
*₁, *₂, *₃, and *₄ may be a binding site to M₃₁,
R₃₁ to R₃₈ may each independently be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
R₃₁ to R₃₈ may optionally be bonded to each other to form a C₅-C₆₀ carbocyclic group that is unsubstituted or substituted with at least one R₁₀ₐ or a C₁-C₆₀ heterocyclic group that is unsubstituted or substituted with at least one R₁₀ₐ,
b31 to b34 may each independently be an integer from 0 to 10,
* and *' may each indicate a binding site to a neighboring atom, and
Q₁ to Q₃ and R₁₀ₐ may each independently be the same as described in the present specification.

In an embodiment, the first compound may include at least one of Compounds HTH1 to HTH56:

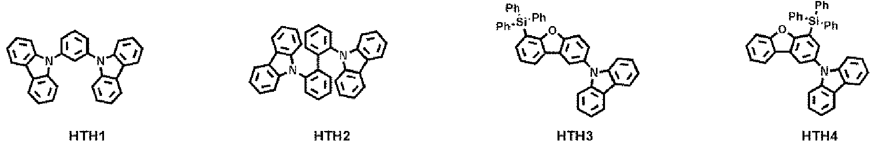

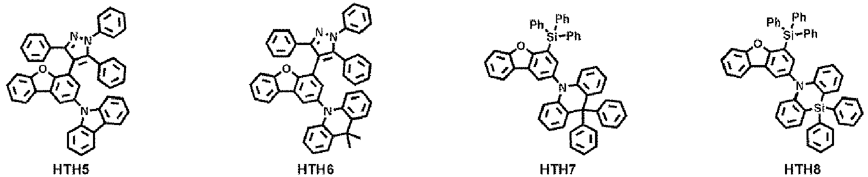

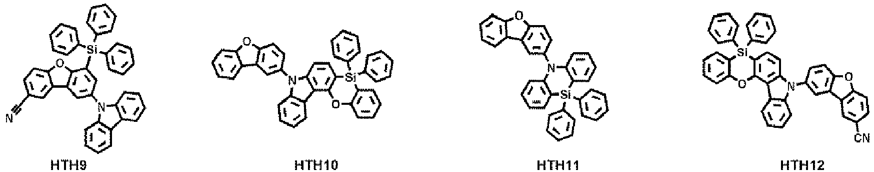

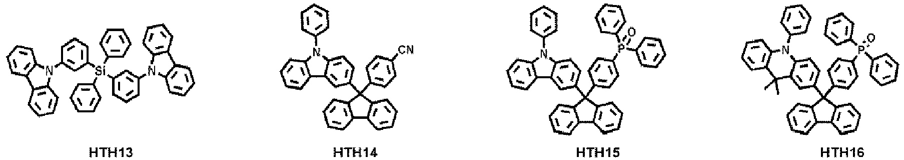

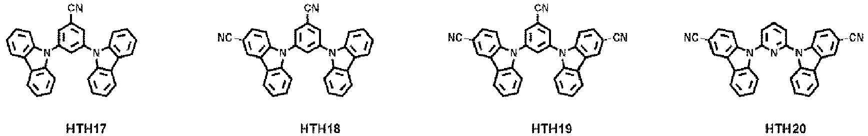

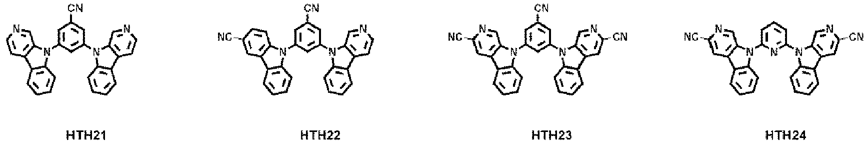

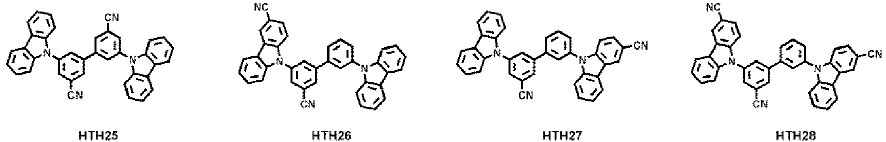

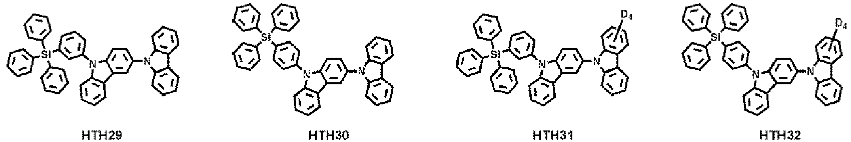

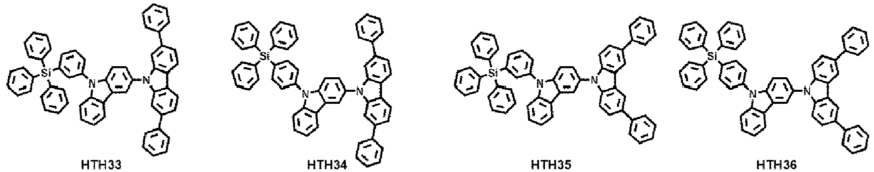

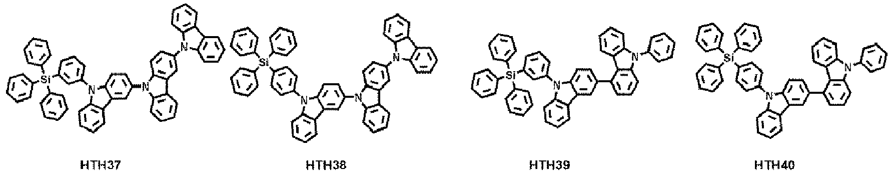

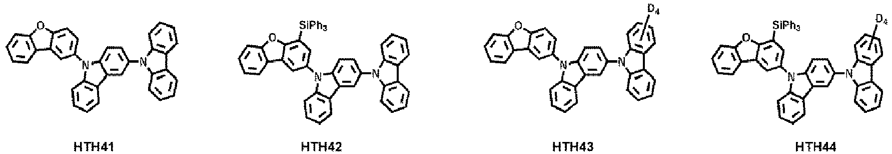

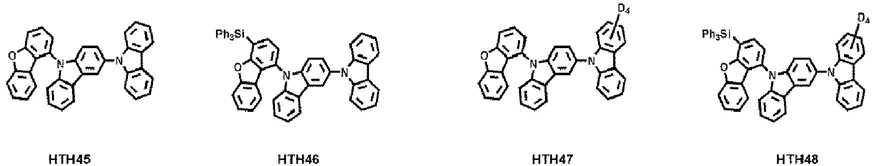

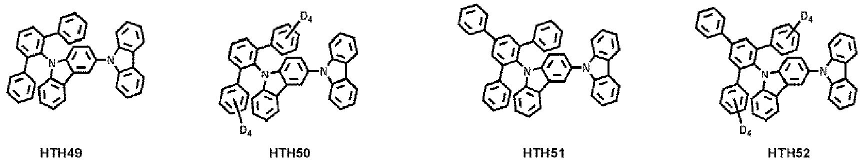

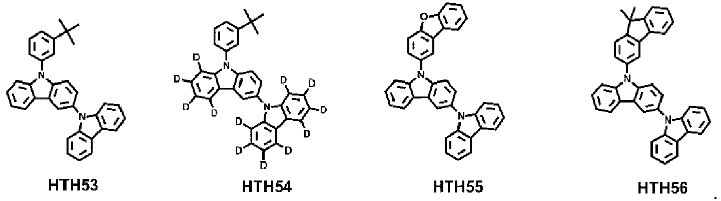

In an embodiment, the second compound may include at least one of Compounds ETH1 to ETH87:

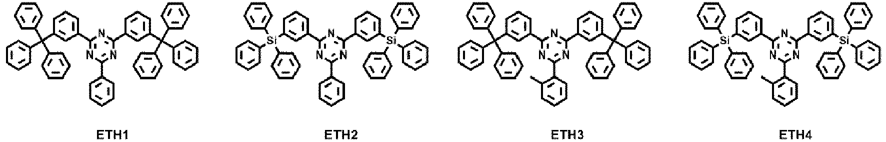

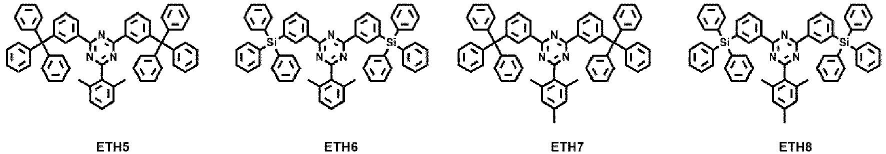

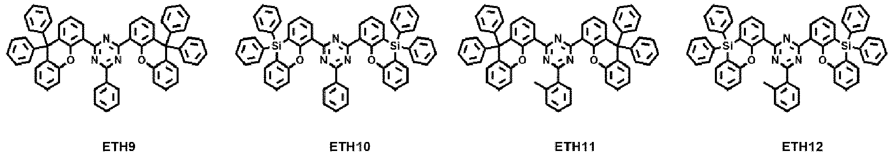

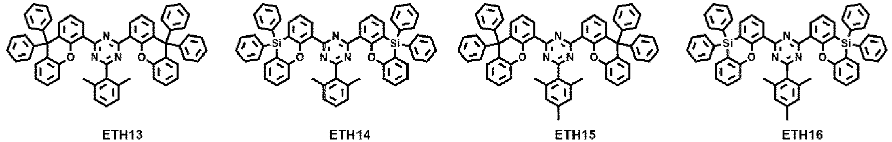

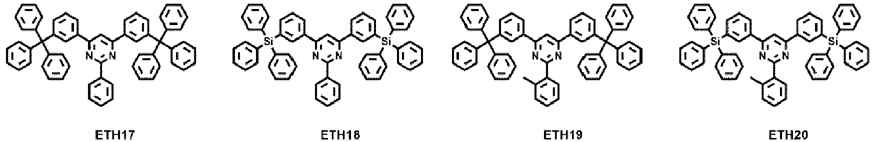

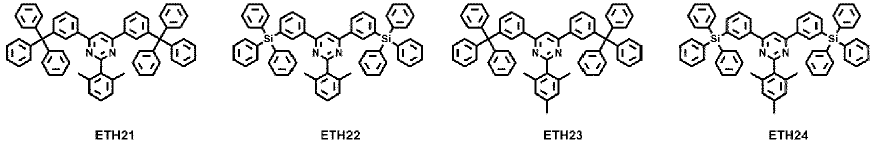

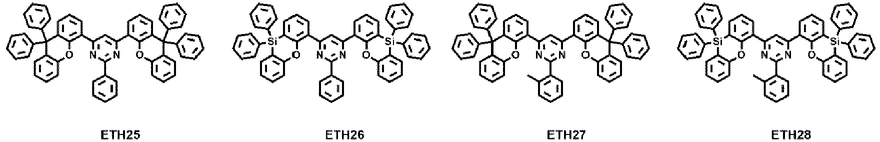

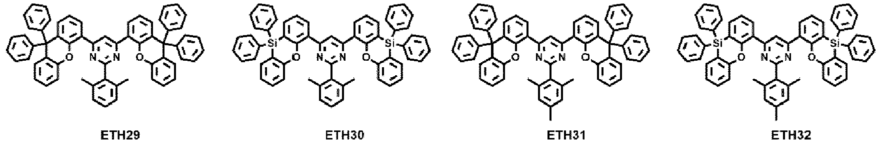

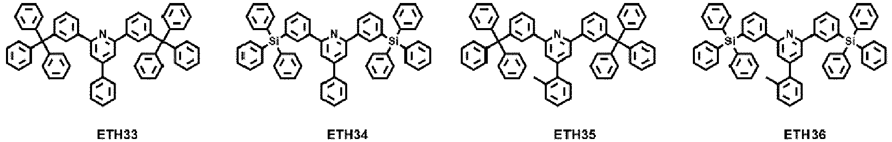

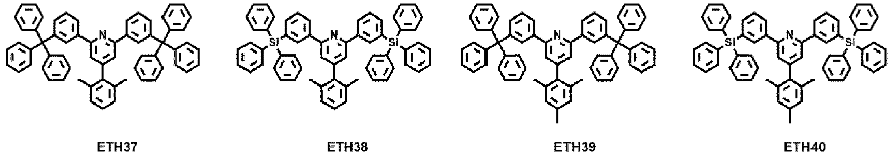

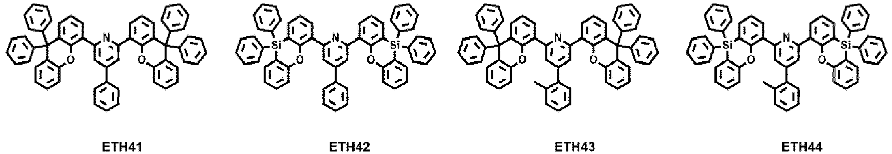

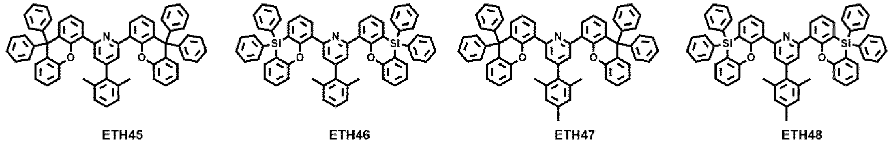

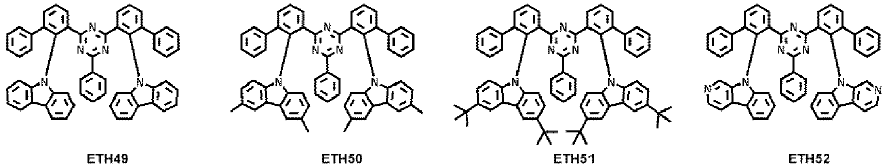

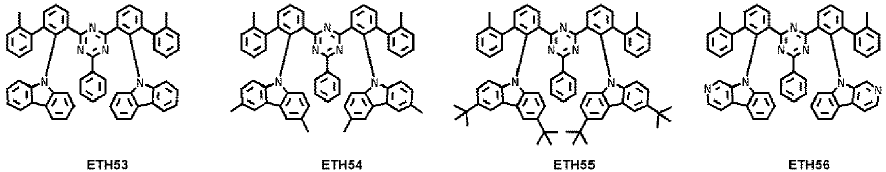

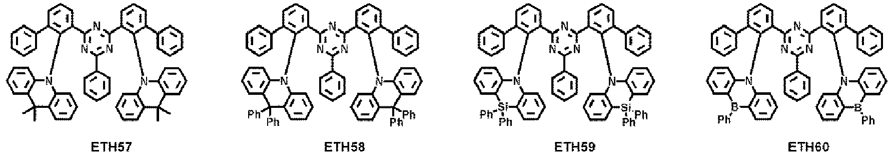

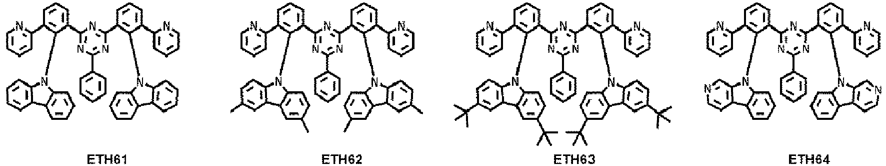

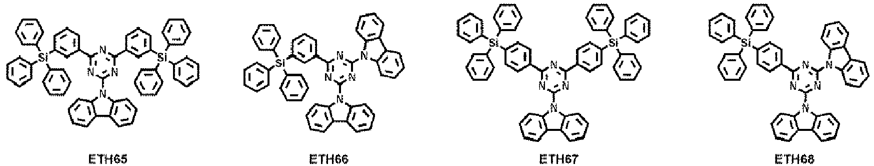

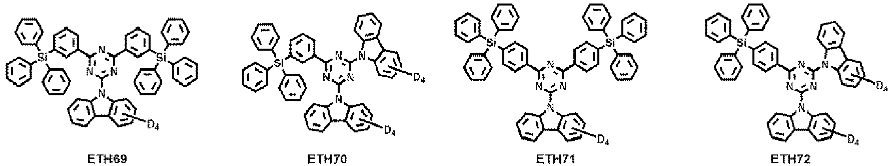

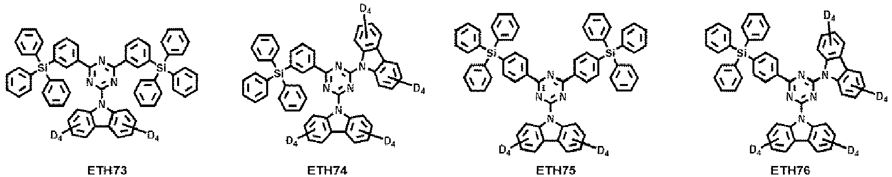

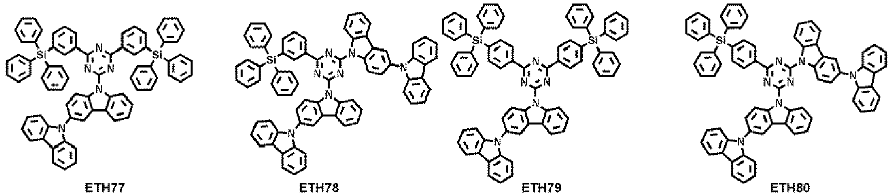

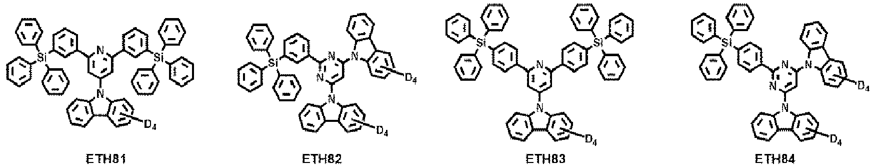

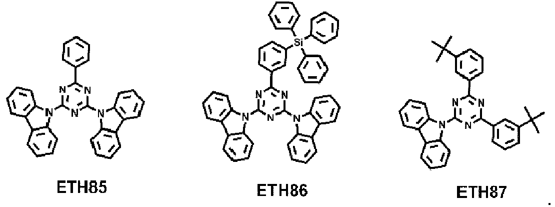

In an embodiment, the third compound may include at least one of Compounds PD1 to PD41:

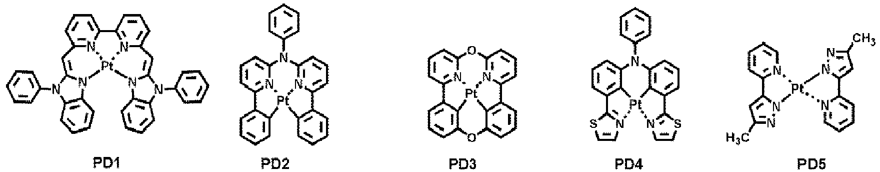

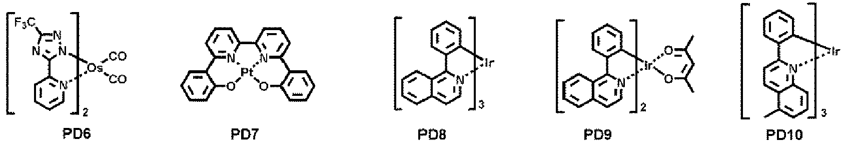

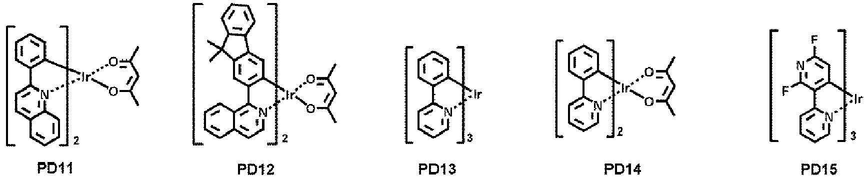

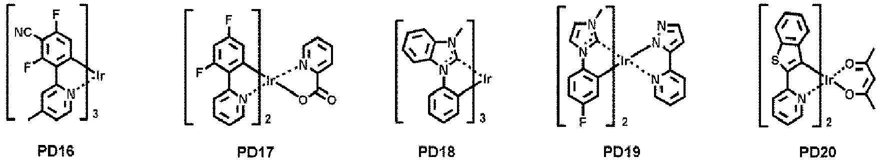

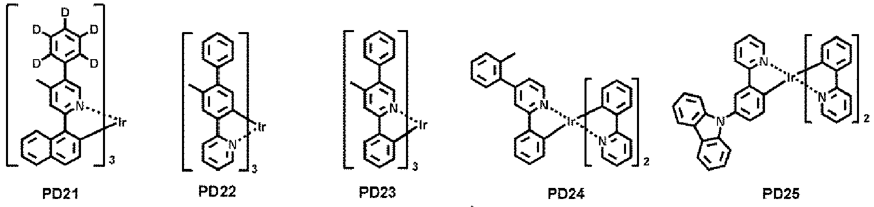

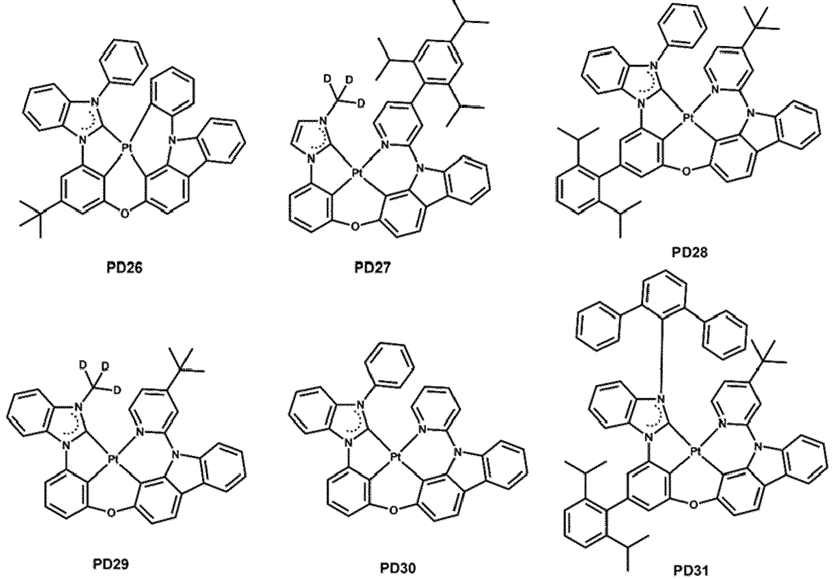

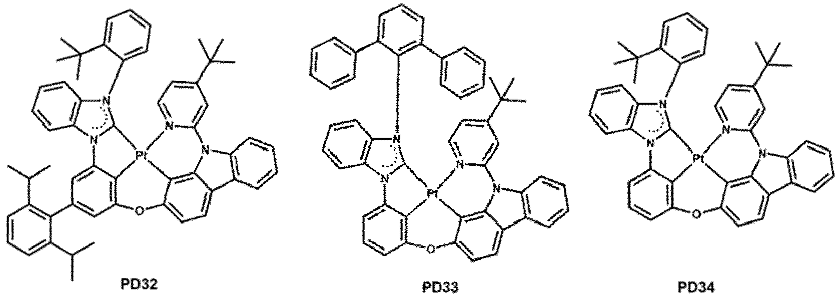

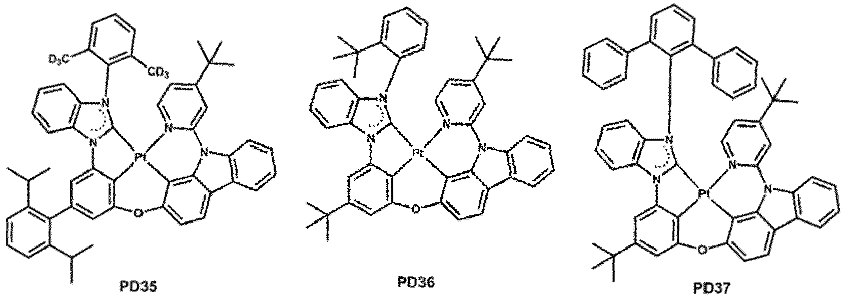

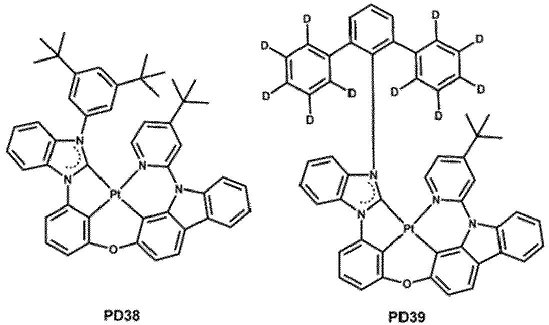

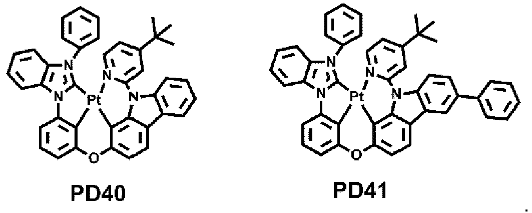

In an embodiment, the condensed cyclic compound included in the emission layer may be a thermally activated delayed fluorescence (TADF) emitter, and the emission layer may emit delayed fluorescence. The emission layer may emit red light, green light, blue light, and/or white light. For example, the emission layer may emit blue light. The blue light may have a maximum emission wavelength of, for example, about 400 nm to about 500 nm, about 400 nm to about 490 nm, about 420 nm to about 480 nm, or about 430 nm to about 480 nm. The emission layer may further include a host, and an amount of the host may be greater than an amount of the condensed cyclic compound represented by Formula 1.

In an embodiment, the light-emitting device may include a capping layer arranged outside the first electrode and/or arranged outside the second electrode.

For example, the light-emitting device may further include at least one of a first capping layer located outside the first electrode and a second capping layer located outside the second electrode, and at least one of the first capping layer and the second capping layer may include the condensed cyclic compound represented by Formula 1. The first capping layer and/or the second capping layer may each independently be the same as described in the present specification.

The expression "(interlayer) includes a condensed cyclic compound," as utilized herein, may be to mean that the (interlayer) may include one kind of condensed cyclic compound represented by Formula 1 or two or more different kinds of condensed cyclic compounds, each represented by Formula 1.

For example, the interlayer may include Compound 1 only as the condensed cyclic compound. In this regard, Compound 1 may be present in the interlayer of the light-emitting device. In an embodiment, the interlayer may include, as the condensed cyclic compound, Compound 1 and Compound 2. In this regard, Compound 1 and Compound 2 may be present in the same layer (for example, all of Compound 1 and Compound 2 may be present in the electron transport layer), or may be present in different layers (for example, Compound 1 may be present in the electron transport layer, and Compound 2 may be present in the buffer layer).

The term "interlayer," as utilized herein, refers to a single layer and/or all of a plurality of layers arranged between the first electrode and the second electrode of the light-emitting device.

According to one or more embodiments, provided is an electronic apparatus including the light-emitting device.

In an embodiment, the electronic apparatus may further include a thin-film transistor. For example, the electronic apparatus may further include a thin-film transistor including a source electrode and a drain electrode, and the first electrode of the light-emitting device may be electrically connected to the source electrode or the drain electrode.

In an embodiment, the electronic apparatus may further include a color filter, a color conversion layer, a touch screen layer, a polarizing layer, or any combination thereof. For example, the electronic apparatus may be a flat panel display apparatus, but embodiments are not limited thereto.

The electronic apparatus may be the same as described in the present specification.

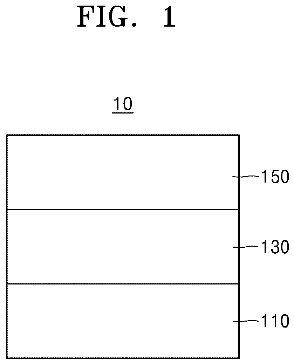

### Description of FIG. 1

FIG. 1 is a schematic cross-sectional view of a light-emitting device 10 according to an embodiment of the disclosure. The light-emitting device 10 includes a first electrode 110, an interlayer 130, and a second electrode 150.

Hereinafter, a structure of the light-emitting device 10 according to an embodiment and a method of manufacturing the light-emitting device 10 will be described in connection with FIG. 1.

### First electrode 110

In FIG. 1, a substrate may be additionally located under the first electrode 110 or above the second electrode 150. In an embodiment, as the substrate, a glass substrate and/or a plastic substrate may be utilized. In an embodiment, the substrate may be a flexible substrate, and may include plastics having excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing and/or sputtering a material for forming the first electrode 110 on the substrate. When the first electrode 110 is an anode, a material for forming the first electrode 110 may be a high work function material to facilitate injection of holes.

The first electrode 110 may be a reflective electrode, a semi-transmissive electrode, or a transmissive electrode. When the first electrode 110 is a transmissive electrode, the material for forming the first electrode 110 may include indium tin oxide (ITO), indium zinc oxide (IZO), tin oxide (SnO₂), zinc oxide (ZnO), or any combination thereof. In an embodiment, when the first electrode 110 is a semi-transmissive electrode or a reflective electrode, the material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layered structure consisting of a single layer, or a multilayer structure including a plurality of layers. In an embodiment, the first electrode 110 may have a three-layered structure of ITO/Ag/ITO.

### Interlayer 130

The interlayer 130 is located on the first electrode 110. The interlayer 130 includes an emission layer.

The interlayer 130 may further include a hole transport region located between the first electrode 110 and the emission layer and an electron transport region located between the emission layer and the second electrode 150.

The interlayer 130 may further include a metal-containing compound such as an organometallic compound, an inorganic material such as a quantum dot, and/or the like, in addition to various suitable organic materials.

In an embodiment, the interlayer 130 may include, i) two or more emitting units sequentially stacked between the first electrode 110 and the second electrode 150, and ii) a charge generation layer located between the two emitting units. When the interlayer 130 includes emitting units and a charge generation layer as described above, the light-emitting device 10 may be a tandem light-emitting device.

### Hole transport region in interlayer 130

The hole transport region may have: i) a single-layered structure consisting of a single layer consisting of a single material; ii) a single-layered structure consisting of a single layer consisting of a plurality of different materials; or iii) a multilayer structure including a plurality of layers including different materials.

The hole transport region may include a hole injection layer, a hole transport layer, an emission auxiliary layer, an electron blocking layer, or any combination thereof.

In an embodiment, the hole transport region may have a multilayer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the layers of each structure being stacked sequentially from the first electrode 110.

The hole transport region may include a compound represented by Formula 201, a compound represented by Formula 202, or any combination thereof: 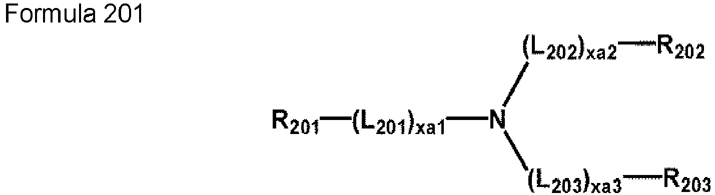 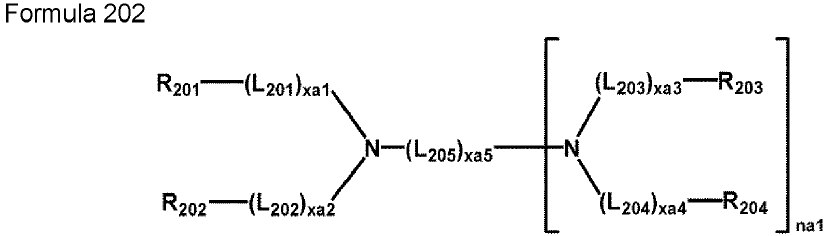
wherein, in Formulae 201 and 202,
L₂₀₁ to L₂₀₄ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
L₂₀₅ may be *-O-*', *-S-*', *-N(Q₂₀₁)-*', a C₁-C₂₀ alkylene group that is unsubstituted or substituted with at least one R₁₀ₐ, a C₂-C₂₀ alkenylene group that is unsubstituted or substituted with at least one R₁₀ₐ, a C₃-C₆₀ carbocyclic group that is unsubstituted or substituted with at least one R₁₀ₐ, or a C₁-C₆₀ heterocyclic group that is unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
R₂₀₁ and R₂₀₂ may optionally be linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group (for example, a carbazole group) that is unsubstituted or substituted with at least one R₁₀ₐ (for example, see Compound HT16),
R₂₀₃ and R₂₀₄ may optionally be linked to each other via a single bond, a C₁-C₅ alkylene group that is unsubstituted or substituted with at least one R₁₀ₐ, or a C₂-C₅ alkenylene group that is unsubstituted or substituted with at least one R₁₀ₐ to form a C₈-C₆₀ polycyclic group that is unsubstituted or substituted with at least one R₁₀ₐ, and
na1 may be an integer from 1 to 4.

In an embodiment, Formulae 201 and 202 may each include at least one of groups represented by Formulae CY201 to CY217: 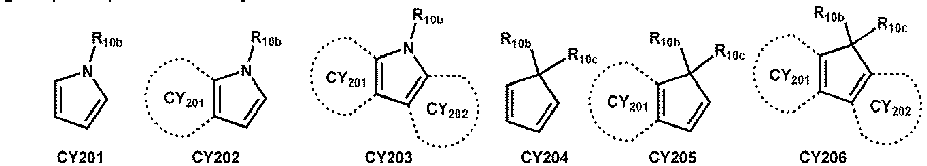 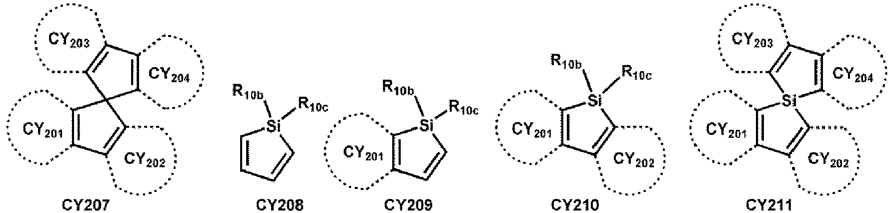 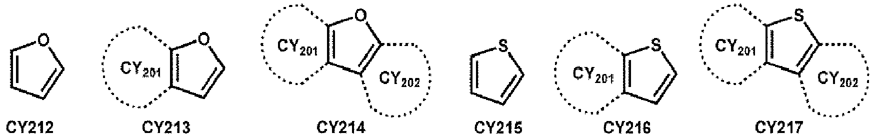 wherein, in Formulae CY201 to CY217, R_{10b} and R_{10c} may each independently be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In an embodiment, ring CY₂₀₁ to ring CY₂₀₄ in Formulae CY201 to CY217 may each independently be a benzene group, a naphthalene group, a phenanthrene group, or an anthracene group.

In an embodiment, Formulae 201 and 202 may each include at least one of groups represented by Formulae CY201 to CY203.

In an embodiment, Formula 201 may include at least one of groups represented by Formulae CY201 to CY203 and at least one of groups represented by Formulae CY204 to CY217.

In an embodiment, xa1 in Formula 201 may be 1, R₂₀₁ may be a group represented by one of Formulae CY201 to CY203, xa2 may be 0, and R₂₀₂ may be a group represented by one of Formulae CY204 to CY207.

In an embodiment, each of Formulae 201 and 202 may not include groups represented by Formulae CY201 to CY203.

In an embodiment, each of Formulae 201 and 202 may not include groups represented by Formulae CY201 to CY203, and may include at least one of groups represented by Formulae CY204 to CY217.

In an embodiment, each of Formulae 201 and 202 may not include groups represented by Formulae CY201 to CY217.

In an embodiment, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzene sulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), CzSi, or any combination thereof:

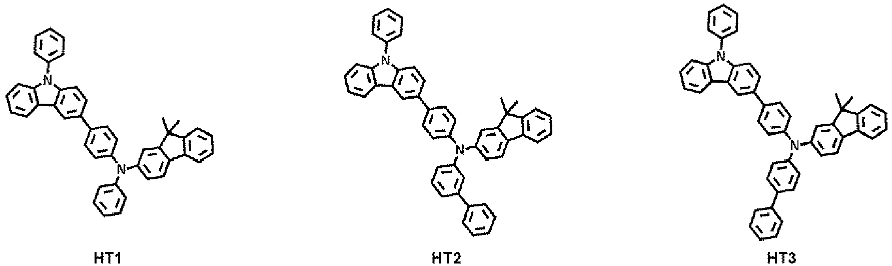

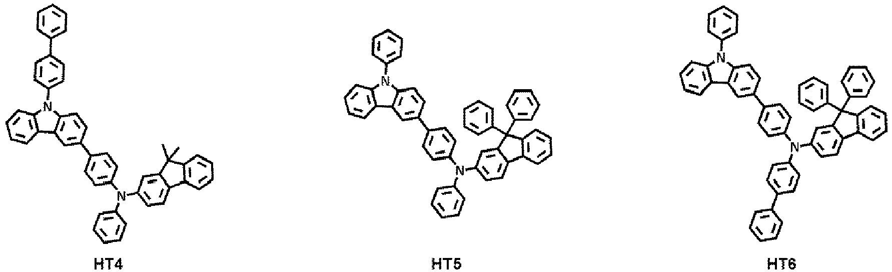

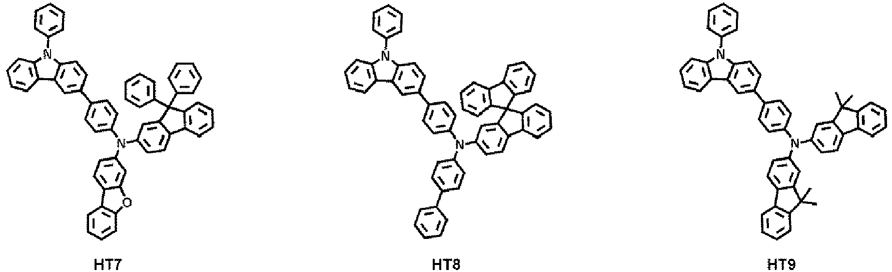

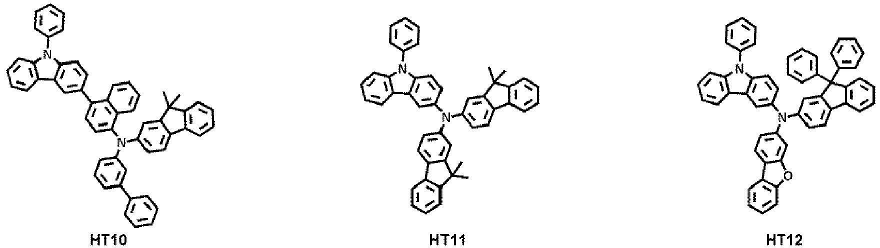

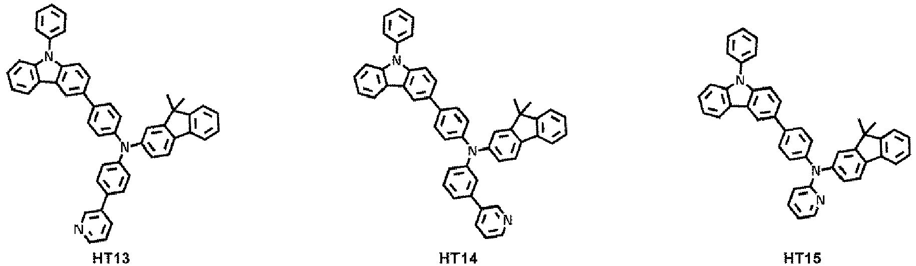

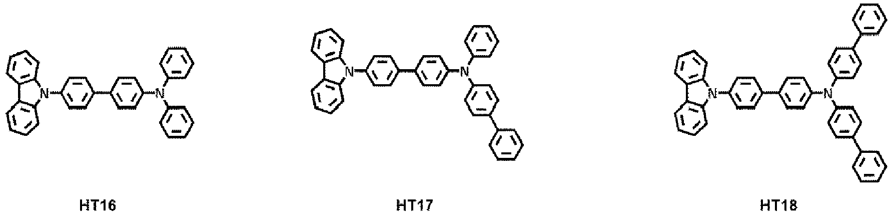

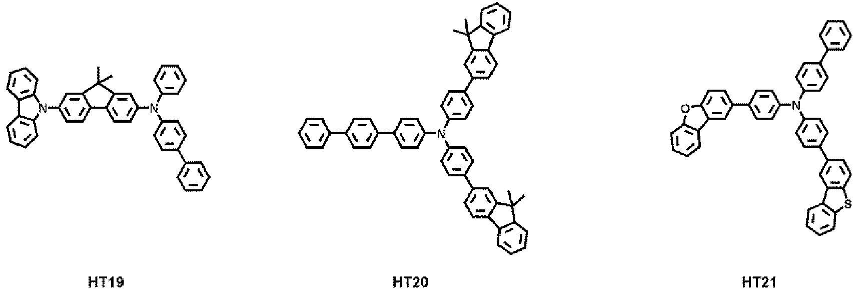

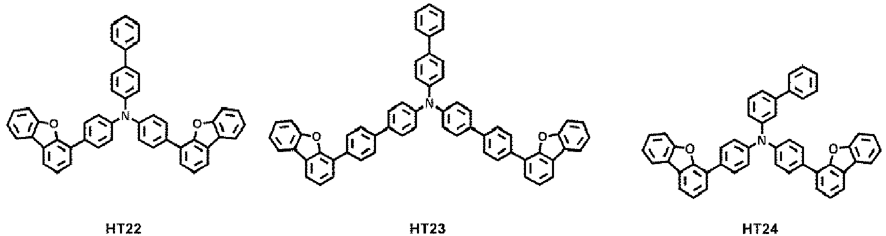

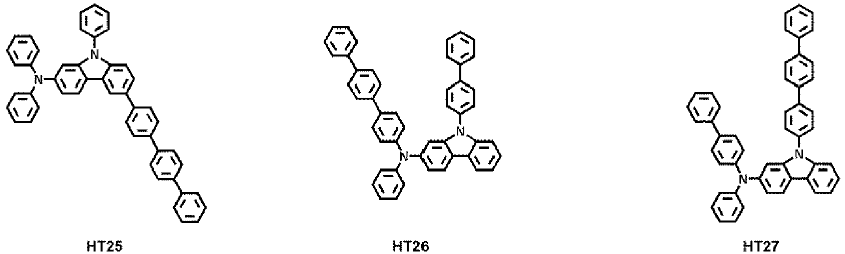

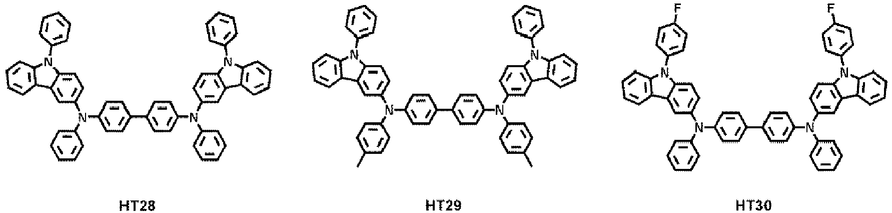

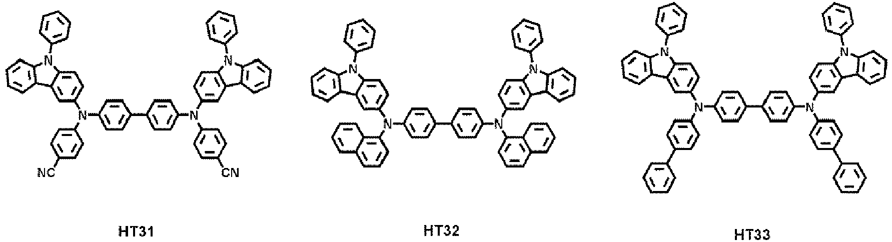

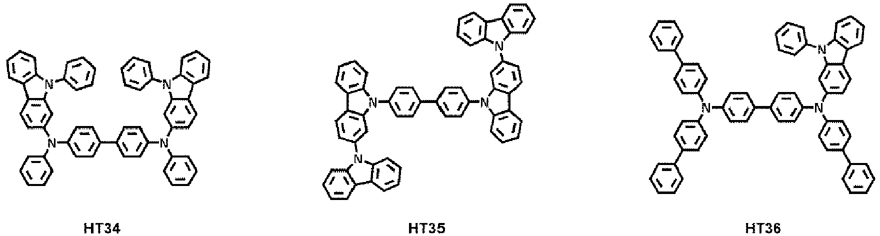

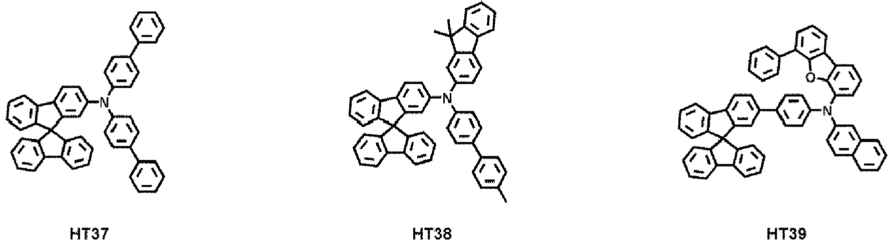

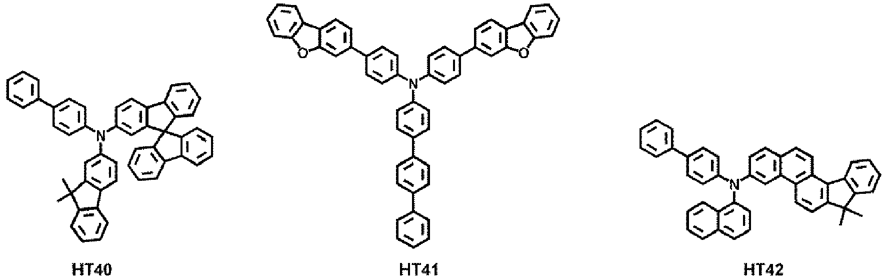

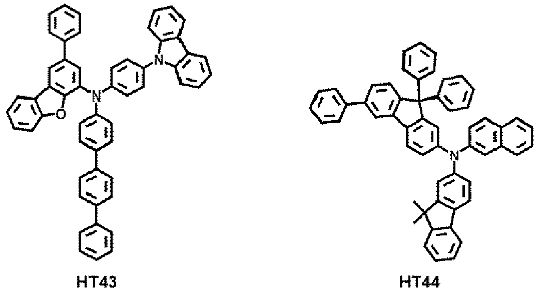

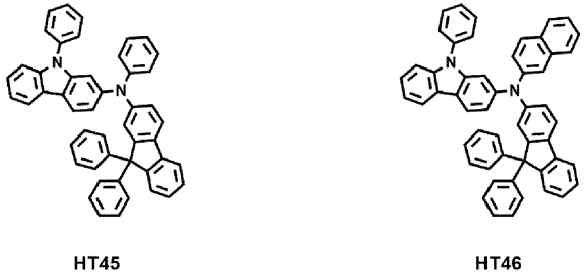

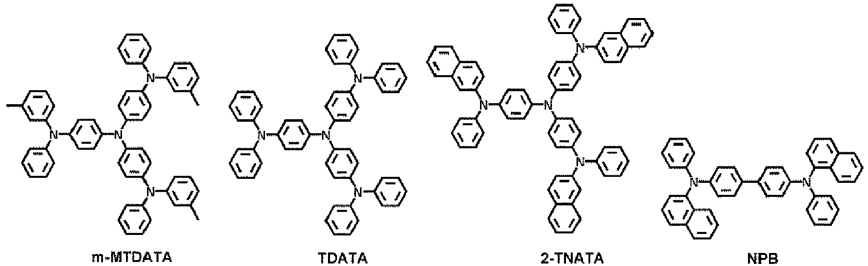

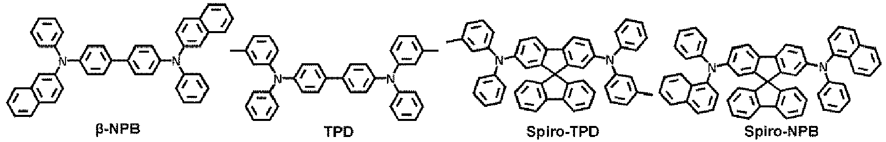

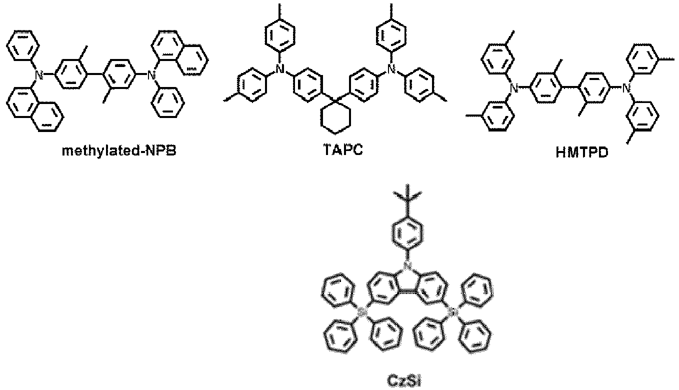

A thickness of the hole transport region may be in a range of about 5 nm to about 1,000 nm (about 50 Å to about 10,000 Å), for example, about 10 nm to about 400 nm (about 100 Å to about 4,000 Å). When the hole transport region includes a hole injection layer, a hole transport layer, or any combination thereof, a thickness of the hole injection layer may be in a range of about 10 nm to about 900 nm (about 100 Å to about 9,000 Å), for example, about 10 nm to about 100 nm (about 100 Å to about 1,000 Å), and a thickness of the hole transport layer may be in a range of about 5 nm to about 200 nm (about 50 Å to about 2,000 Å), for example, about 10 nm to about 150 nm (about 100 Å to about 1,500 Å). When the thicknesses of the hole transport region, the hole injection layer and the hole transport layer are within these ranges, suitable or satisfactory hole-transporting characteristics may be obtained without a substantial increase in driving voltage.

The emission auxiliary layer may increase light-emission efficiency by compensating for an optical resonance distance of the wavelength of light emitted by an emission layer, and the electron blocking layer may block or reduce the leakage of electrons from an emission layer to a hole transport region. Materials that may be included in the hole transport region may be included in the emission auxiliary layer and the electron blocking layer.

### p-dopant

The hole transport region may further include, in addition to these materials, a charge-generation material for the improvement of conductive properties (e.g., electrically conductive properties). The charge-generation material may be uniformly or non-uniformly dispersed in the hole transport region (for example, in the form of a single layer consisting of a charge-generation material).

The charge-generation material may be, for example, a p-dopant.

In an embodiment, the LUMO energy level of the p-dopant may be about - 3.5 eV or less.

In an embodiment, the p-dopant may include a quinone derivative, a cyano group-containing compound, a compound including an element EL1 and an element EL2, or any combination thereof.

Examples of the quinone derivative may include TCNQ, F4-TCNQ, and the like.

Examples of the cyano group-containing compound may include HAT-CN, a compound represented by Formula 221, and the like.

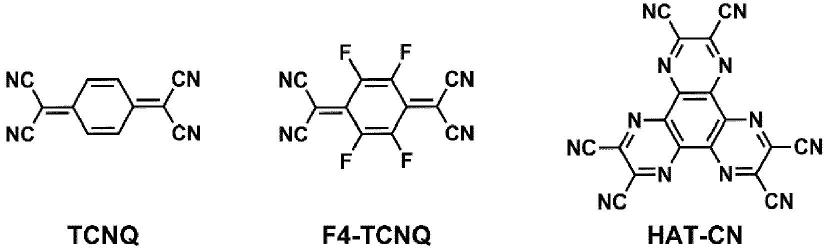

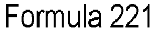

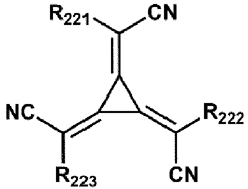

In Formula 221,
R₂₂₁ to R₂₂₃ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ, and
at least one of R₂₂₁ to R₂₂₃ may each independently be: a C₃-C₆₀ carbocyclic group or a C₁-C₆₀ heterocyclic group, each substituted with: a cyano group; -F; -Cl; -Br; -I; a C₁-C₂₀ alkyl group that is substituted with a cyano group, -F, -Cl, -Br, -I, or any combination thereof; or any combination thereof.

In the compound including the element EL1 and the element EL2, the element EL1 may be a metal, a metalloid, or a combination thereof, and the element EL2 may be a non-metal, a metalloid, or a combination thereof.

Examples of the metal may include an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Examples of the metalloid may include silicon (Si), antimony (Sb), and tellurium (Te).

Examples of the non-metal may include oxygen (O) and halogen (for example, F, Cl, Br, I, etc.).

In an embodiment, examples of the compound containing the element EL1 and the element EL2 may include a metal oxide, a metal halide (for example, a metal fluoride, a metal chloride, a metal bromide, and/or a metal iodide), a metalloid halide (for example, a metalloid fluoride, a metalloid chloride, a metalloid bromide, and/or a metalloid iodide), a metal telluride, or any combination thereof.

Examples of the metal oxide may include a tungsten oxide (for example, WO, W₂O₃, WO₂, WO₃, W₂O₅, etc.), a vanadium oxide (for example, VO, V₂O₃, VO₂, V₂O₅, etc.), a molybdenum oxide (MoO, Mo₂O₃, MoO₂, MoO₃, Mo₂O₅, etc.), and a rhenium oxide (for example, ReO₃, etc.).

Examples of the metal halide may include an alkali metal halide, an alkaline earth metal halide, a transition metal halide, a post-transition metal halide, and a lanthanide metal halide.

Examples of the alkali metal halide may include LiF, NaF, KF, RbF, CsF, LiCl, NaCl, KCl, RbCl, CsCl, LiBr, NaBr, KBr, RbBr, CsBr, Lil, Nal, KI, Rbl, and Csl.

Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, Bel₂, Mgl₂, Cal₂, Srl₂, and Bal₂.

Examples of the transition metal halide may include a titanium halide (for example, TiF₄, TiCl₄, TiBr₄, Til₄, etc.), a zirconium halide (for example, ZrF₄, ZrCl₄, ZrBr₄, Zrl₄, etc.), a hafnium halide (for example, HfF₄, HfCl₄, HfBr₄, Hfl₄, etc.), a vanadium halide (for example, VF₃, VCl₃, VBr₃, Vl₃, etc.), a niobium halide (for example, NbF₃, NbCl₃, NbBr₃, Nbl₃, etc.), a tantalum halide (for example, TaF₃, TaCl₃, TaBr₃, Tal₃, etc.), a chromium halide (for example, CrF₃, CrCl₃, CrBr₃, Crl₃, etc.), a molybdenum halide (for example, MoF₃, MoCl₃, MoBr₃, Mol₃, etc.), a tungsten halide (for example, WF₃, WCl₃, WBr₃, Wl₃, etc.), a manganese halide (for example, MnF₂, MnCl₂, MnBr₂, Mnl₂, etc.), a technetium halide (for example, TcF₂, TcCl₂, TcBr₂, Tcl₂, etc.), a rhenium halide (for example, ReF₂, ReCl₂, ReBr₂, Rel₂, etc.), an iron halide (for example, FeF₂, FeCl₂, FeBr₂, Fel₂, etc.), a ruthenium halide (for example, RuF₂, RuCl₂, RuBr₂, Rul₂, etc.), an osmium halide (for example, OsF₂, OsCl₂, OsBr₂, Osl₂, etc.), a cobalt halide (for example, CoF₂, CoCl₂, CoBr₂, Col₂, etc.), a rhodium halide (for example, RhF₂, RhCl₂, RhBr₂, Rhl₂, etc.), an iridium halide (for example, IrF₂, IrCl₂, IrBr₂, Irl₂, etc.), a nickel halide (for example, NiF₂, NiCl₂, NiBr₂, Nil₂, etc.), a palladium halide (for example, PdF₂, PdCl₂, PdBr₂, Pdl₂, etc.), a platinum halide (for example, PtF₂, PtCl₂, PtBr₂, Ptl₂, etc.), a copper halide (for example, CuF, CuCl, CuBr, Cul, etc.), a silver halide (for example, AgF, AgCl, AgBr, Agl, etc.), and a gold halide (for example, AuF, AuCl, AuBr, Aul, etc.).

Examples of the post-transition metal halide may include a zinc halide (for example, ZnF₂, ZnCl₂, ZnBr₂, Znl₂, etc.), an indium halide (for example, Inl₃, etc.), and a tin halide (for example, Snl₂, etc.).

Examples of the lanthanide metal halide may include YbF, YbF₂, YbF₃, SmF₃, YbCl, YbCl₂, YbCl₃, SmCl₃, YbBr, YbBr₂, YbBr₃, SmBr₃, Ybl, Ybl₂, Ybl₃, and Sml₃.

Examples of the metalloid halide may include an antimony halide (for example, SbCl₅, etc.).

Examples of the metal telluride may include an alkali metal telluride (for example, Li₂Te, Na₂Te, K₂Te, Rb₂Te, Cs₂Te, etc.), an alkaline earth metal telluride (for example, BeTe, MgTe, CaTe, SrTe, BaTe, etc.), a transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), a post-transition metal telluride (for example, ZnTe, etc.), and a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers may contact (e.g., physical contact) each other or may be separated (e.g., spaced apart) from each other. In an embodiment, the emission layer may include two or more materials of a red light-emitting material, a green light-emitting material, and a blue light-emitting material, in which the two or more materials may be mixed together with each other in a single layer to emit white light.

The emission layer may include a host and a dopant. The dopant may include a phosphorescent dopant, a fluorescent dopant, or any combination thereof.

An amount of the dopant in the emission layer may be about 0.01 parts by weight to about 15 parts by weight, based on 100 parts by weight of the host.

In an embodiment, the emission layer may include a quantum dot.

The emission layer may include a transition metal-containing material. The transition metal-containing material may act as a sensitizer or a dopant.

The transition metal-containing material may include the third compound.

In an embodiment, the emission layer may include a delayed fluorescence material. The delayed fluorescence material may act as a dopant of the emission layer.

The delayed fluorescence material may be the condensed cyclic compound represented by Formula 1.

A thickness of the emission layer may be in a range of about 10 nm to about 100 nm (about 100 Å to about 1,000 Å), for example, about 20 nm to about 60 nm (about 200 Å to about 600 Å). When the thickness of the emission layer is within the above range, excellent light-emission characteristics may be obtained without a substantial increase in driving voltage.

### Host

The host may include the first compound and/or the second compound.

The host may further include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), or - P(=O)(Q₃₀₁)(Q₃₀₂),
xb21 may be an integer from 1 to 5, and
Q₃₀₁ to Q₃₀₃ may each independently be the same as described in connection with Q₁.

In an embodiment, when xb11 in Formula 301 is 2 or more, two or more Ar₃₀₁(s) may be linked to each other via a single bond.

In an embodiment, the host may include a compound represented by Formula 301-1, a compound represented by Formula 301-2, or any combination thereof: 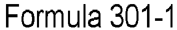 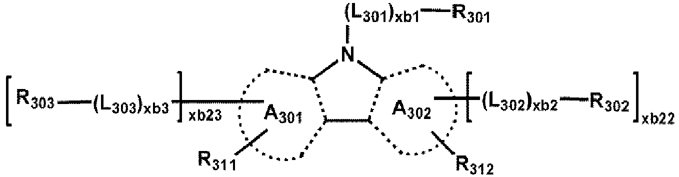 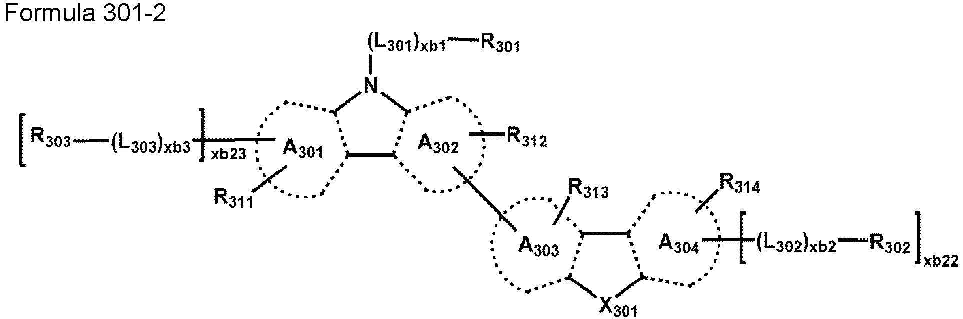 wherein, in Formulae 301-1 to 301-2,
ring A₃₀₁ to ring A₃₀₄ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each independently be the same as described in the present specification,
L₃₀₂ to L₃₀₄ may each independently be the same as described in connection with L₃₀₁,
xb2 to xb4 may each independently be the same as described in connection with xb1, and
R₃₀₂ to R₃₀₅ and R₃₁₁ to R₃₁₄ may each independently be the same as described in connection with R₃₀₁.

In an embodiment, the host may include an alkali earth metal complex, a post-transition metal complex, or a combination thereof. In an embodiment, the host may include a Be complex (for example, Compound H55), an Mg complex, a Zn complex, or a combination thereof.

In an embodiment, the host may include one of Compounds H1 to H131, one of Compounds HT-1 to HT-17, one of Compounds ET01 to ET015, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), or any combination thereof:

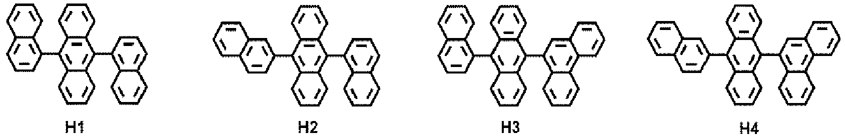

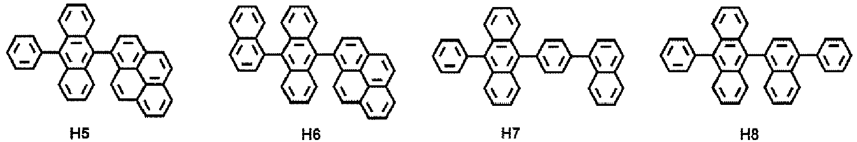

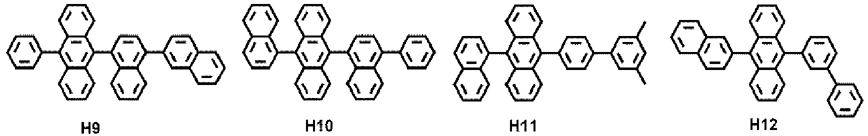

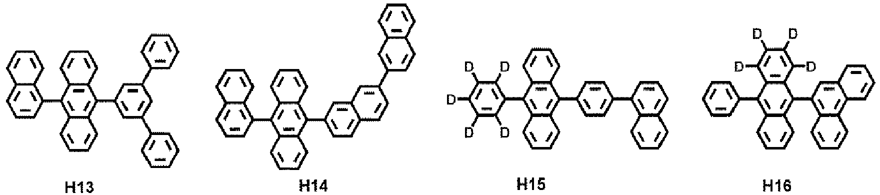

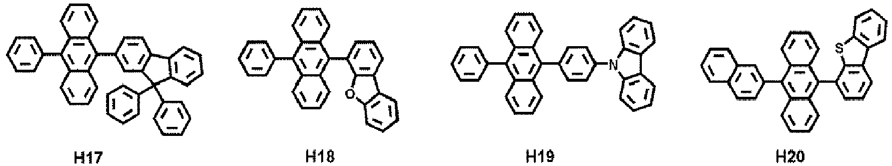

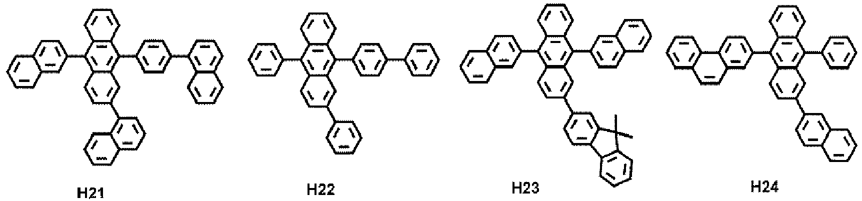

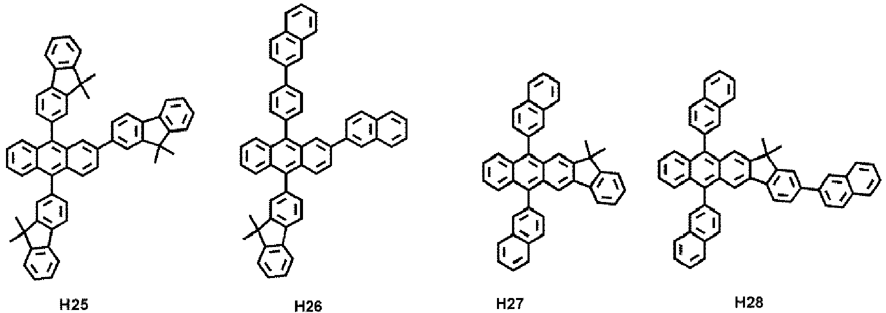

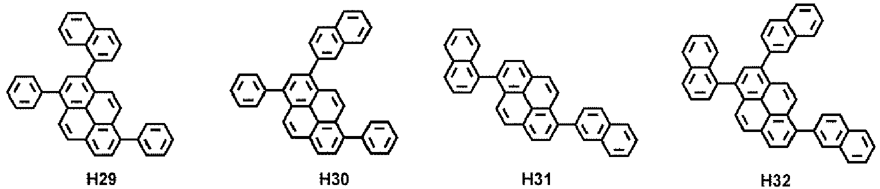

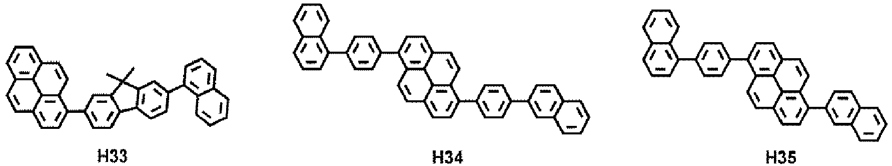

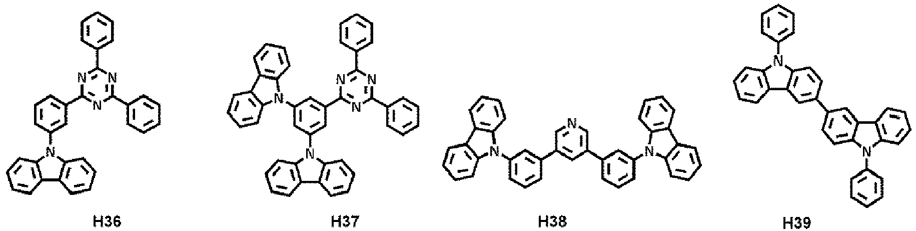

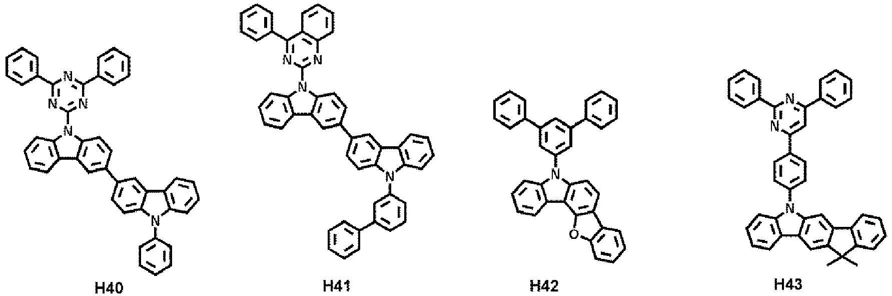

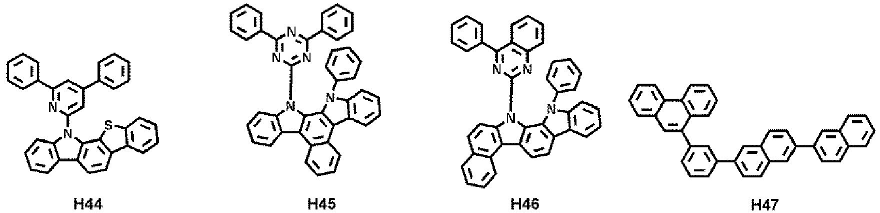

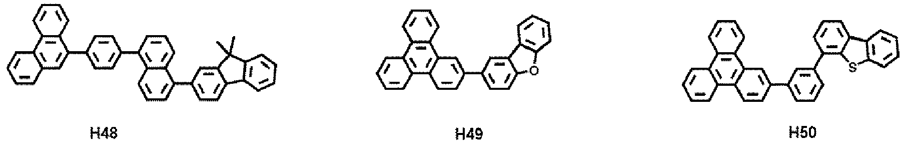

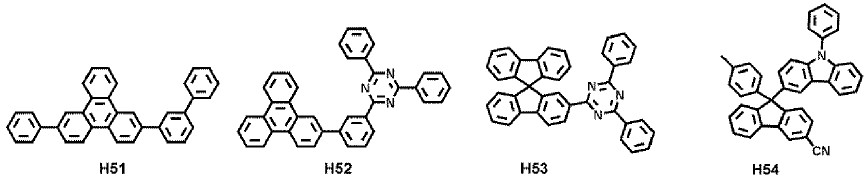

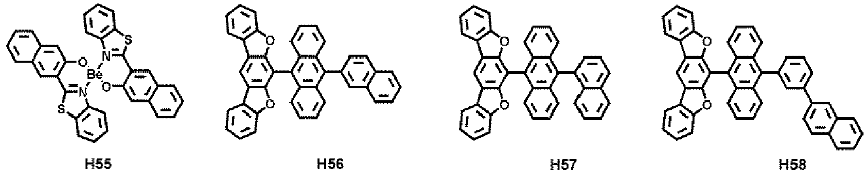

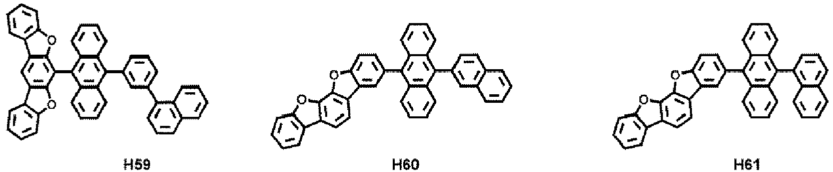

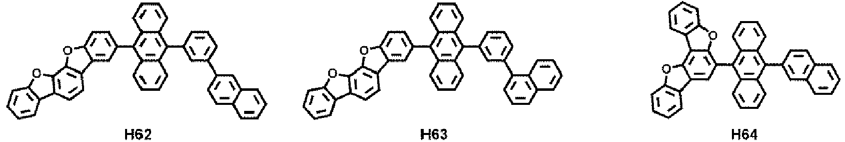

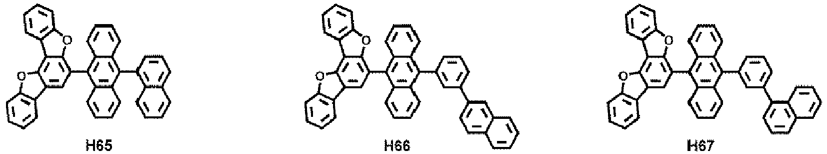

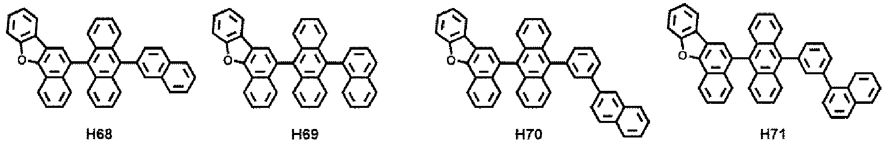

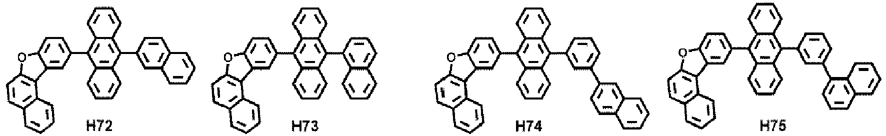

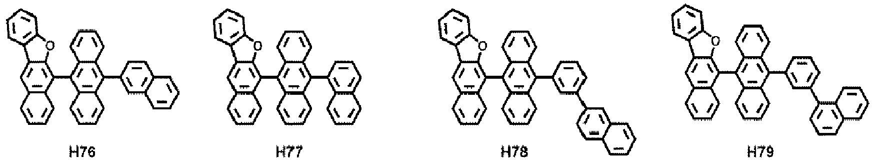

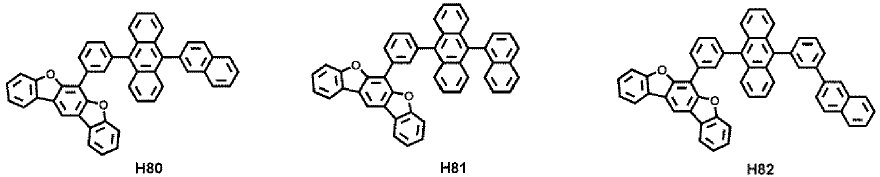

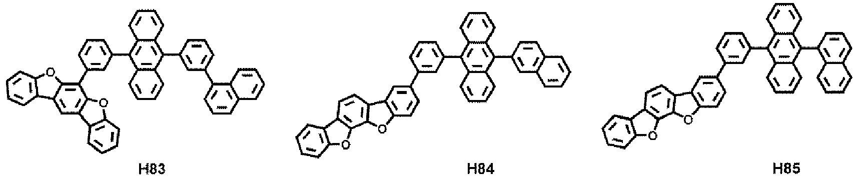

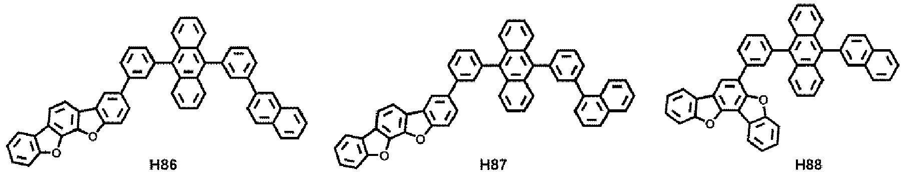

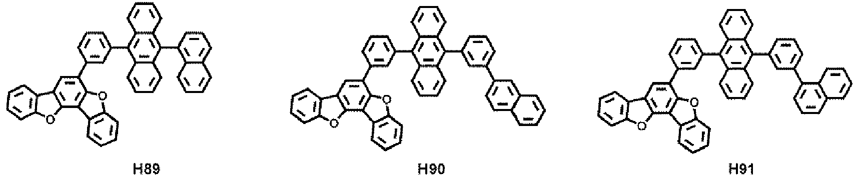

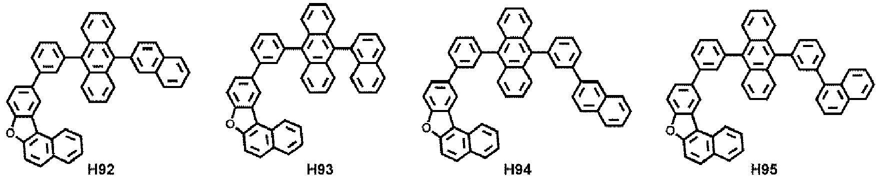

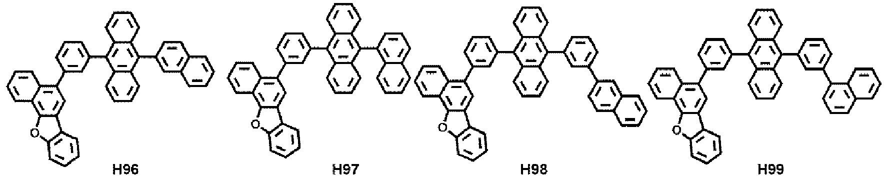

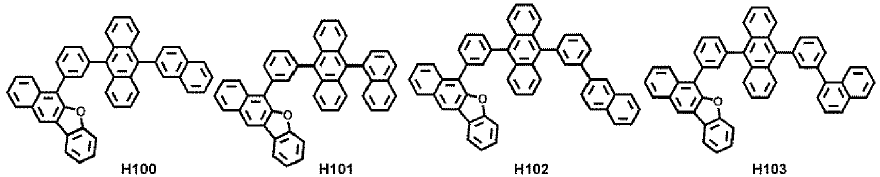

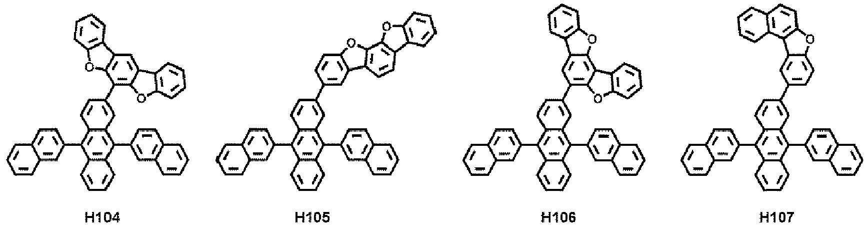

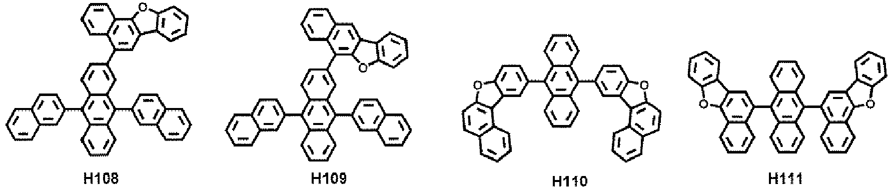

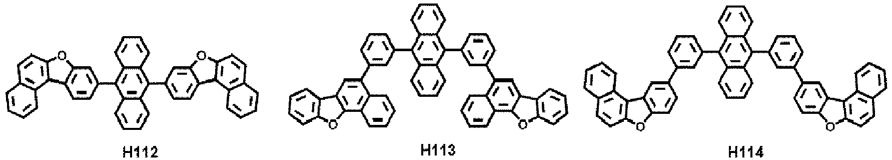

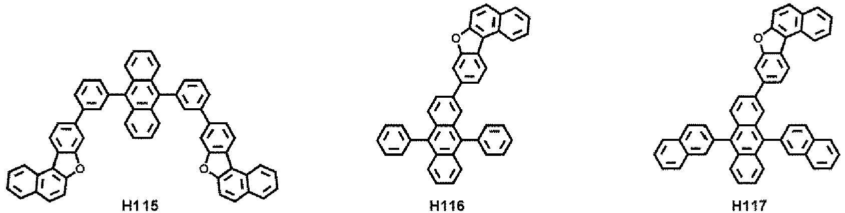

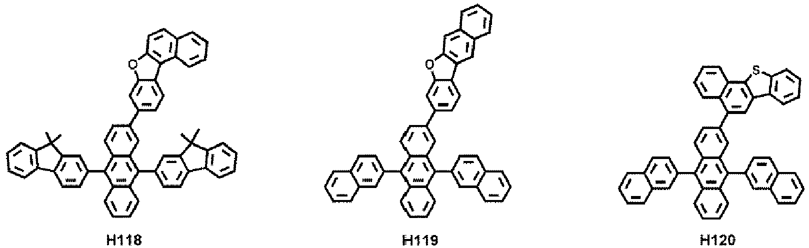

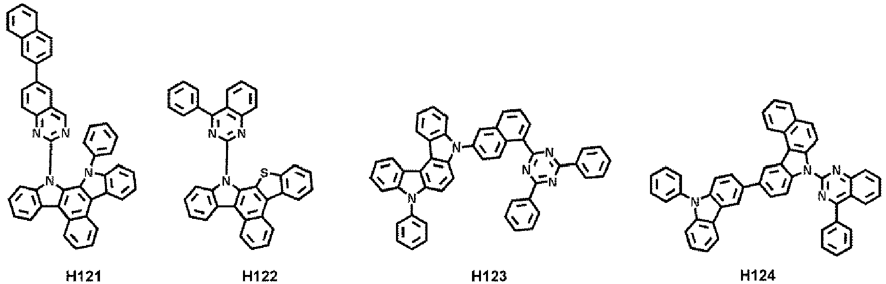

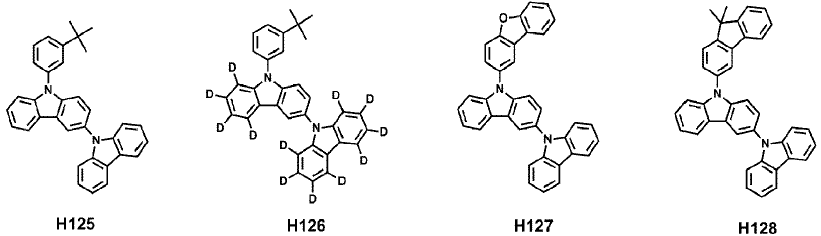

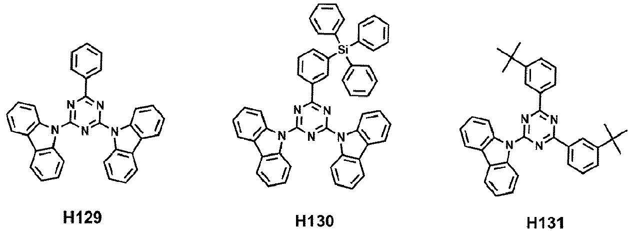

### Phosphorescent dopant

The phosphorescent dopant may include at least one transition metal as a central metal.

The phosphorescent dopant may act as a sensitizer without emitting light directly according to the type or composition of another material included in the emission layer.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

In an embodiment, the phosphorescent dopant may include an organometallic compound represented by Formula 401:

Formula 401 M(L₄₀₁)_{xc1}(L₄₀₂)_{xc2}

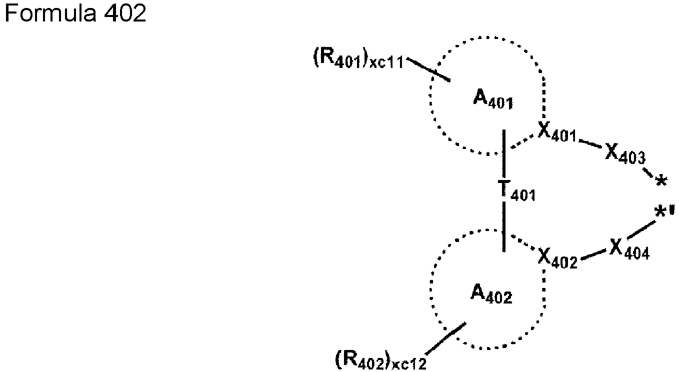

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is two or more, two or more L₄₀₁(s) may be identical to or different from each other,
L₄₀₂ may be an organic ligand, and xc2 may be 0, 1, 2, 3, or 4, wherein, when xc2 is 2 or more, two or more L₄₀₂(s) may be identical to or different from each other,
X₄₀₁ and X₄₀₂ may each independently be nitrogen or carbon,
ring A₄₀₁ and ring A₄₀₂ may each independently be a C₃-C₆₀ carbocyclic group or a C₁-C₆₀ heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C(Q₄₁₁)=*',
X₄₀₃ and X₄₀₄ may each independently be a chemical bond (for example, a covalent bond or a coordinate bond, which may also be referred to as a coordinate covalent bond or a dative bond), O, S, N(Q₄₁₃), B(Q₄₁₃), P(Q₄₁₃), C(Q₄₁₃)(Q₄₁₄), or Si(Q413)(Q414),
Q₄₁₁ to Q₄₁₄ may each independently be the same as described in connection with Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group that is unsubstituted or substituted with at least one R₁₀ₐ, a C₁-C₂₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each independently be the same as described in connection with Q₁,
xc11 and xc12 may each independently be an integer from 0 to 10, and
* and *' in Formula 402 may each indicate a binding site to M in Formula 401.

In an embodiment, in Formula 402, i) X₄₀₁ may be nitrogen, and X₄₀₂ may be carbon, or ii) each of X₄₀₁ and X₄₀₂ may be nitrogen.

In an embodiment, when xc1 in Formula 402 is 2 or more, two rings A₄₀₁ in two or more L₄₀₁(s) may be optionally linked to each other via T₄₀₂, which is a linking group, and two rings A₄₀₂ may optionally be linked to each other via T₄₀₃, which is a linking group (see Compounds PD1 to PD4 and PD7). T₄₀₂ and T₄₀₃ may each independently be the same as described in connection with T₄₀₁.

L₄₀₂ in Formula 401 may be an organic ligand. In an embodiment, L₄₀₂ may include a halogen group, a diketone group (for example, an acetylacetonate group), a carboxylic acid group (for example, a picolinate group), -C(=O), an isonitrile group, a - CN group, a phosphorus group (for example, a phosphine group, a phosphite group, etc.), or any combination thereof.

The phosphorescent dopant may include for example, one of Compounds PD1 to PD41, one of Compounds PD-1 to PD-36, or any combination thereof:

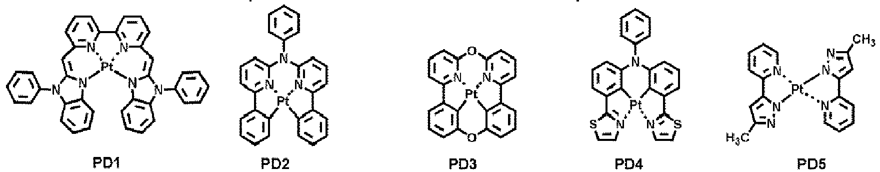

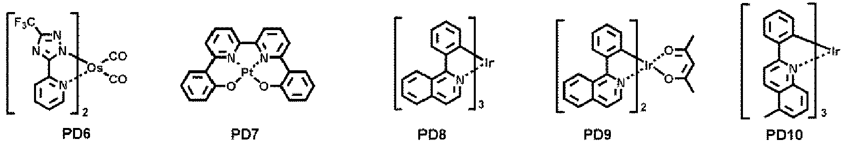

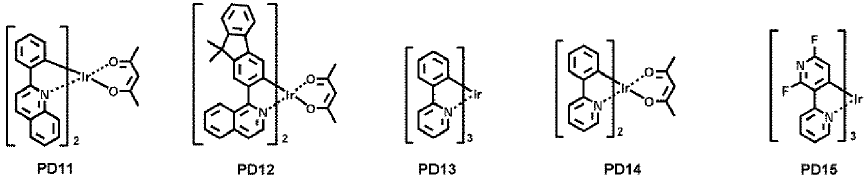

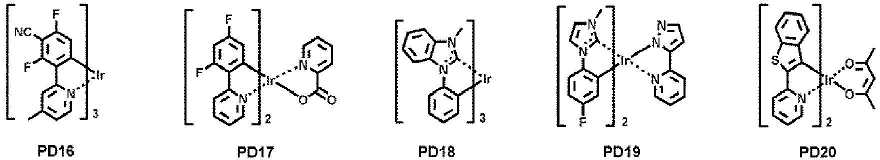

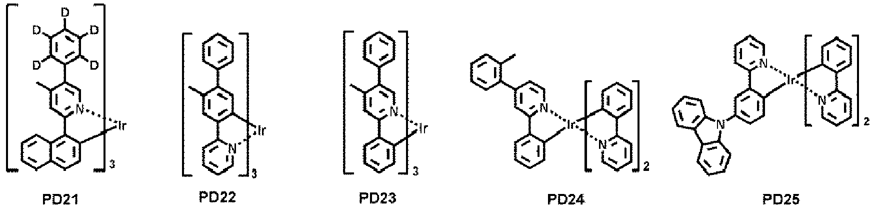

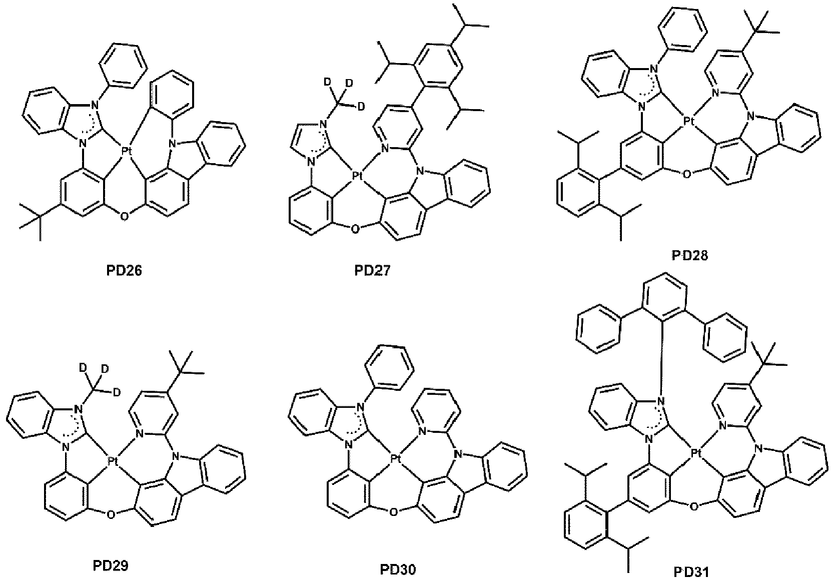

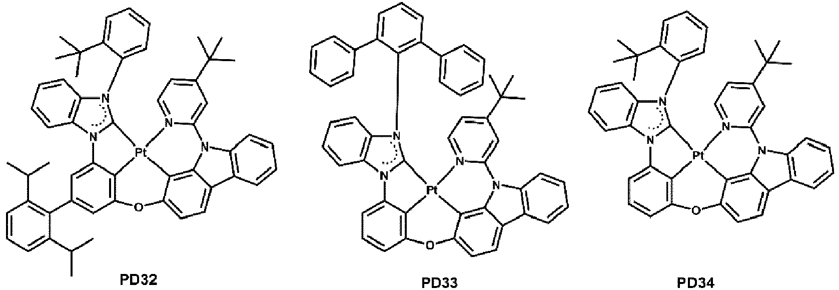

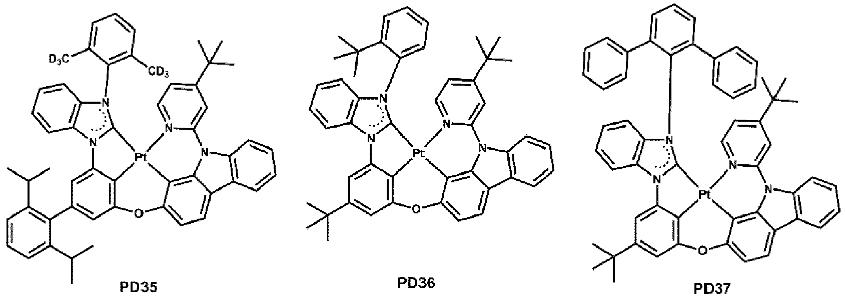

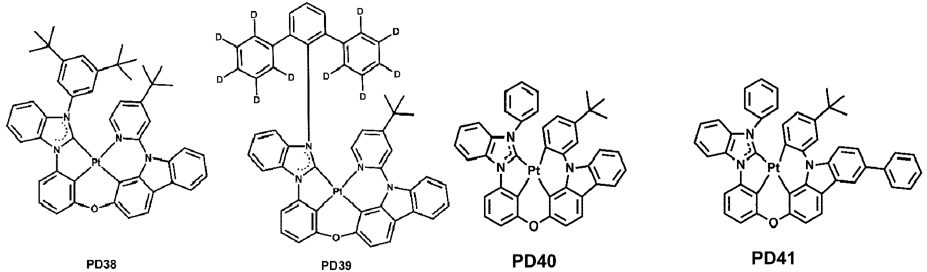

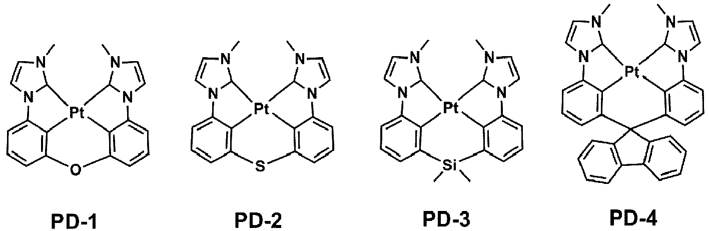

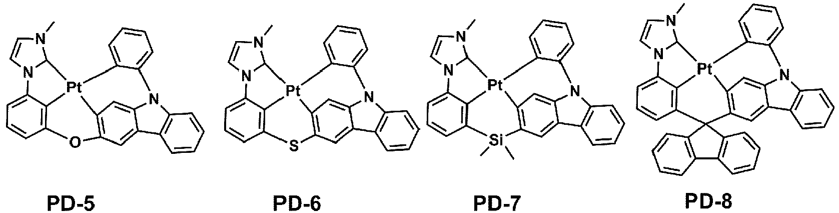

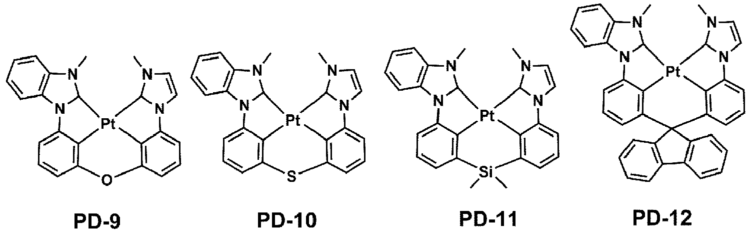

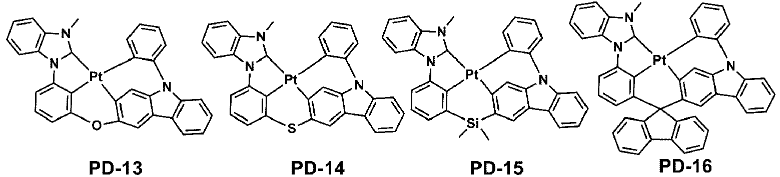

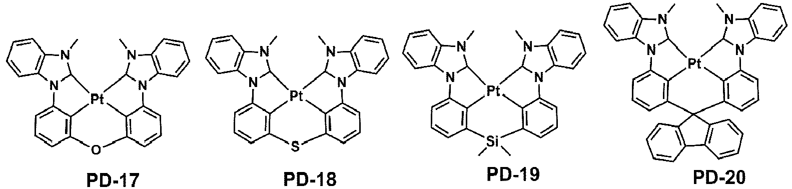

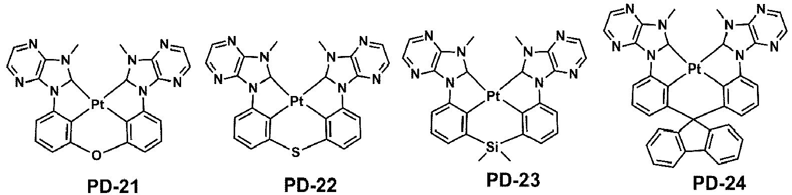

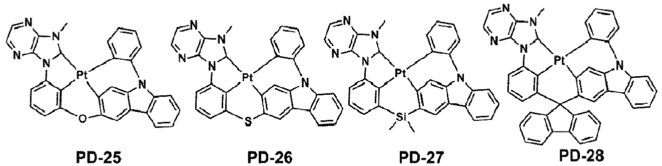

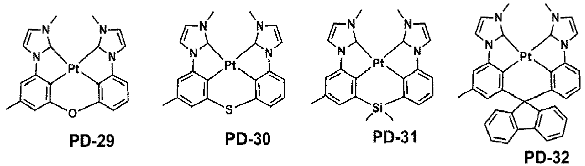

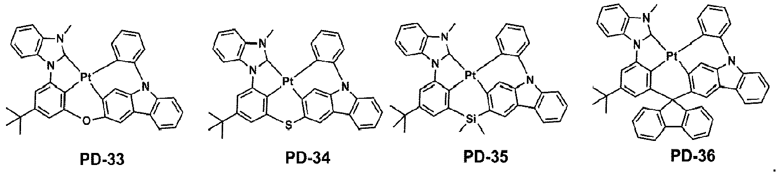

### Fluorescent dopant

The fluorescent dopant may include an amine group-containing compound, a styryl group-containing compound, or any combination thereof.

In an embodiment, the fluorescent dopant may include a compound represented by Formula 501: 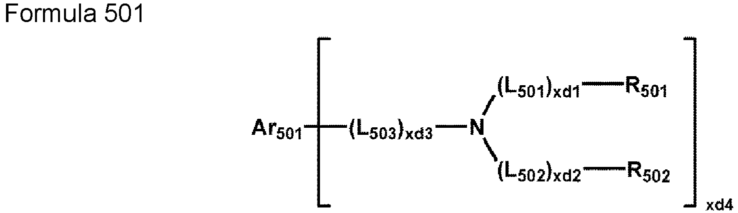 wherein, in Formula 501,
Ar₅₀₁, L₅₀₁ to L₅₀₃, R₅₀₁, and R₅₀₂ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xd1 to xd3 may each independently be 0, 1, 2, or 3, and
xd4 may be 1, 2, 3, 4, 5, or 6.

In an embodiment, Ar₅₀₁ in Formula 501 may be a condensed cyclic group (for example, an anthracene group, a chrysene group, or a pyrene group) in which three or more monocyclic groups are condensed together.

In an embodiment, xd4 in Formula 501 may be 2.

In an embodiment, the fluorescent dopant may include: one of Compounds FD1 to FD36; DPVBi; DPAVBi; or any combination thereof:

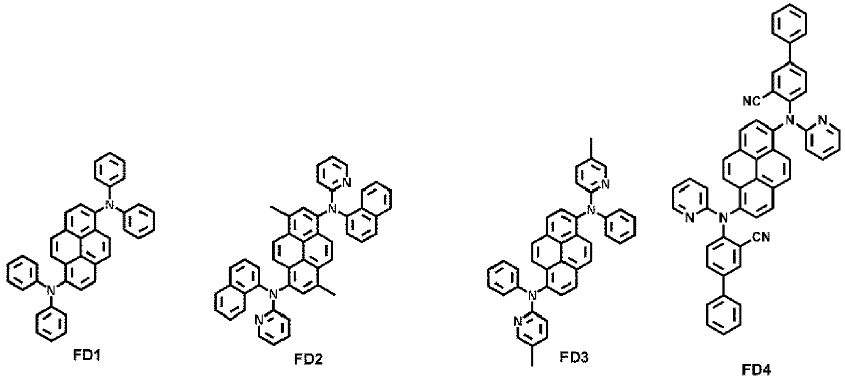

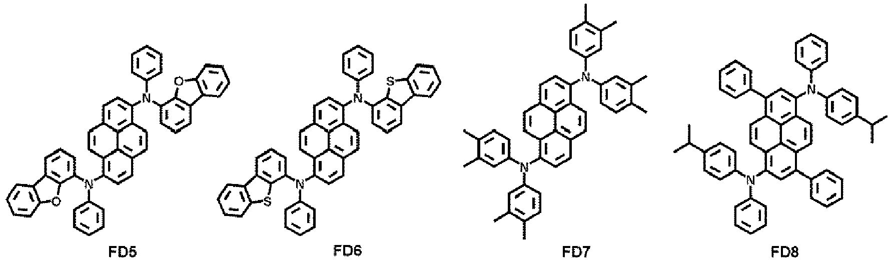

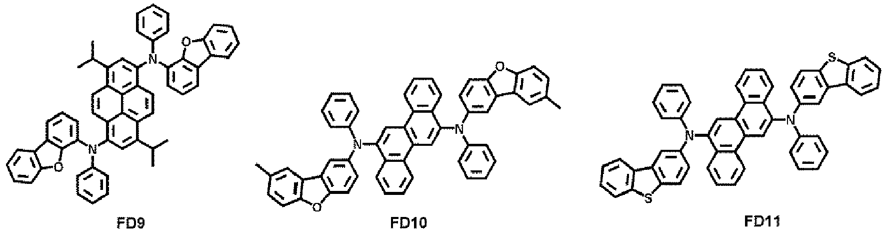

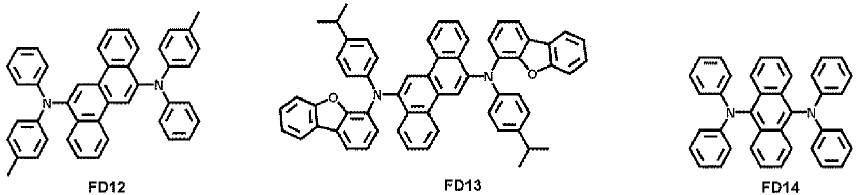

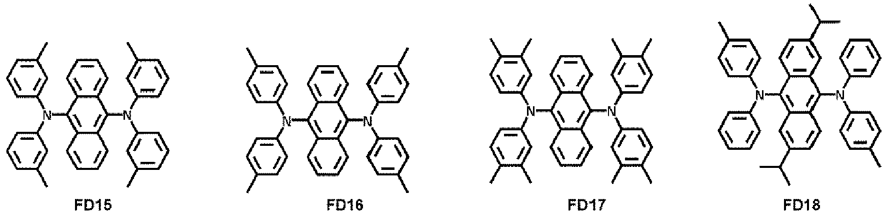

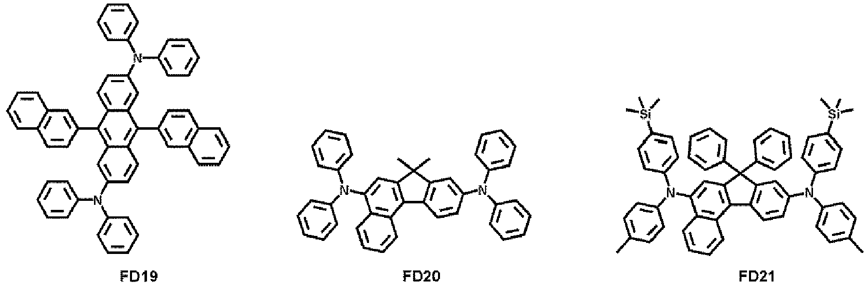

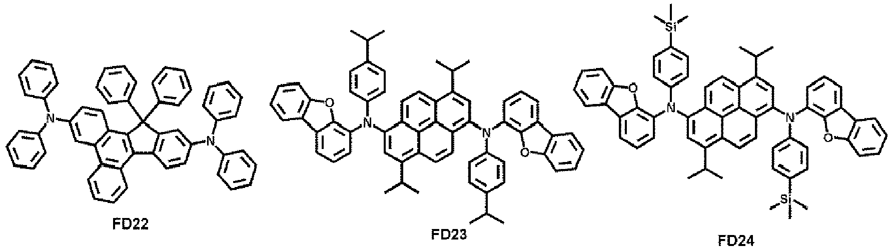

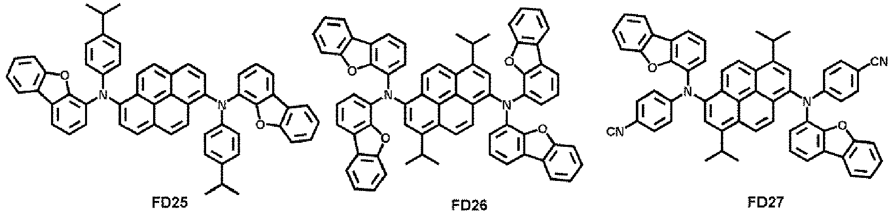

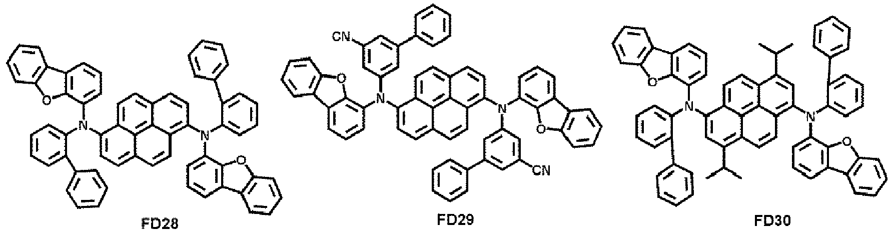

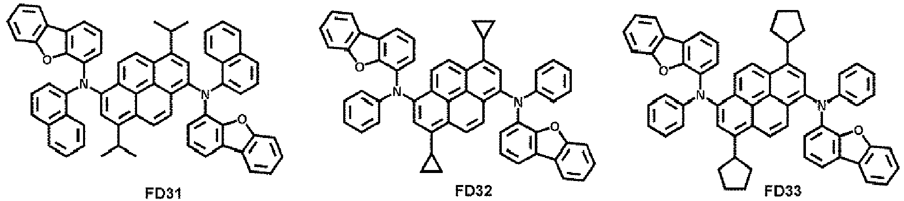

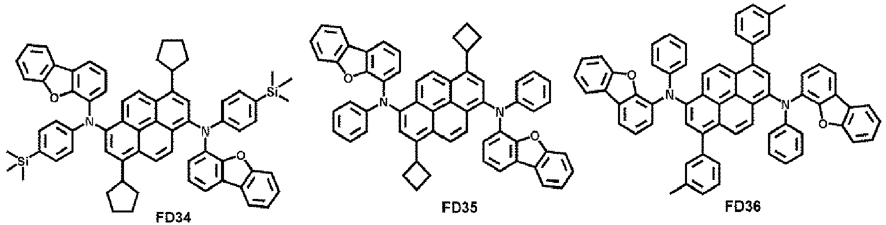

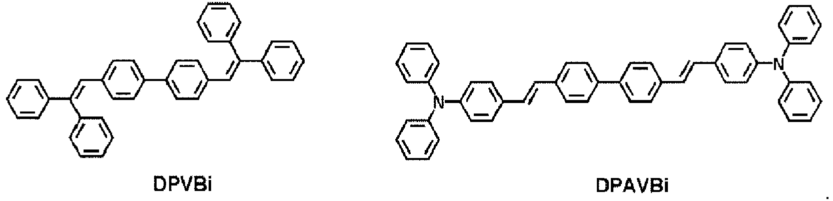

### Delayed fluorescence material

The emission layer may include a delayed fluorescence material.

In an embodiment, the delayed fluorescence material may include the condensed cyclic compound represented by Formula 1.

In the present specification, the delayed fluorescence material may be selected from compounds capable of emitting delayed fluorescence based on a delayed fluorescence emission mechanism.

The delayed fluorescence material included in the emission layer may act as a host or a dopant depending on the type or composition of other materials included in the emission layer.

In an embodiment, the difference between the triplet energy level (eV) of the delayed fluorescence material and the singlet energy level (eV) of the delayed fluorescence material may be greater than or equal to about 0 eV and less than or equal to about 0.5 eV. When the difference between the triplet energy level (eV) of the delayed fluorescence material and the singlet energy level (eV) of the delayed fluorescence material satisfies the above-described range, up-conversion from the triplet state to the singlet state of the delayed fluorescence materials may effectively occur, and thus, the emission efficiency of the light-emitting device 10 may be improved.

In an embodiment, the delayed fluorescence material may include i) a material including at least one electron donor (for example, a π electron-rich C₃-C₆₀ cyclic group, such as a carbazole group) and at least one electron acceptor (for example, a sulfoxide group, a cyano group, or a π electron-deficient nitrogen-containing C₁-C₆₀ cyclic group), and ii) a material including a C₈-C₆₀ polycyclic group in which two or more cyclic groups are condensed together while sharing boron (B).

Examples of the delayed fluorescence material may include at least one of Compounds DF1 to DF9:

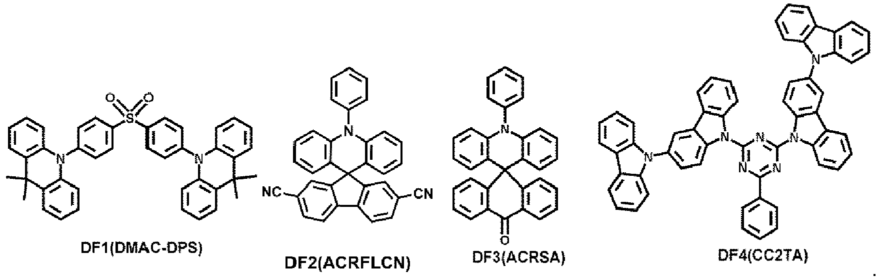

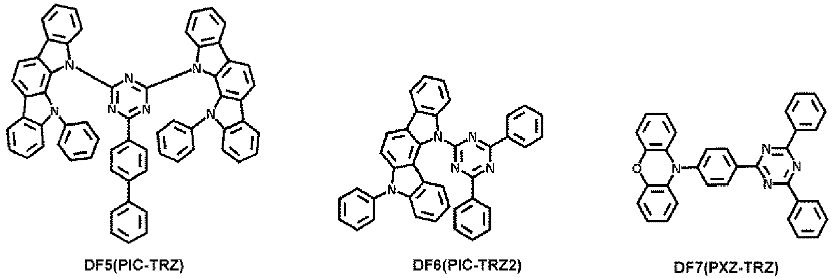

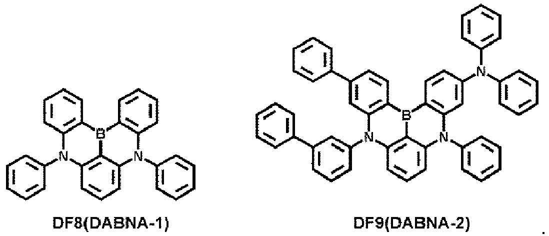

### Quantum dot

The emission layer may include a quantum dot.

In the present specification, a quantum dot refers to a crystal of a semiconductor compound, and may include any suitable material capable of emitting light of various suitable emission wavelengths according to the size of the crystal.

A diameter of the quantum dot may be, for example, in a range of about 1 nm to about 10 nm.

The quantum dot may be synthesized by a wet chemical process, a metal organic chemical vapor deposition process, a molecular beam epitaxy process, and/or any suitable process similar thereto.

According to the wet chemical process, a precursor material is mixed together with an organic solvent to grow a quantum dot particle crystal. As the crystal grows, the organic solvent naturally acts as a dispersant coordinated on the surface of the quantum dot crystal and controls the growth of the crystal so that the growth of quantum dot particles may be controlled through a process which is more easily performed than vapor deposition methods, such as metal organic chemical vapor deposition (MOCVD) or molecular beam epitaxy (MBE), and which has a lower cost.

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound may include: a binary compound, such as CdS, CdSe, CdTe, ZnS, ZnSe, ZnTe, ZnO, HgS, HgSe, HgTe, MgSe, and/or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS; a quaternary compound, such as CdZnSeS, CdZnSeTe, CdZnSTe, CdHgSeS, CdHgSeTe, CdHgSTe, HgZnSeS, HgZnSeTe, and/or HgZnSTe; or any combination thereof.

Examples of the Group III-V semiconductor compound may include: a binary compound, such as GaN, GaP, GaAs, GaSb, AIN, AIP, AlAs, AlSb, InN, InP, InAs, and/or InSb; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, and/or InPSb; a quaternary compound, such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, and/or InAlPSb; or any combination thereof. In an embodiment, the Group III-V semiconductor compound may further include Group II elements. Examples of the Group III-V semiconductor compound further including Group II elements may include InZnP, InGaZnP, InAlZnP, and the like.

Examples of the Group III-VI semiconductor compound may include: a binary compound, such GaS, GaSe, Ga₂Se₃, GaTe, InS, InSe, In₂S₃, In₂Se₃, and/or InTe; a ternary compound, such as InGaS₃, and/or InGaSe₃; or any combination thereof.

Examples of the Group I-III-VI semiconductor compound may include: a ternary compound, such as AgInS, AgInS₂, CuInS, CuInS₂, CuGaO₂, AgGaO₂, and/or AgAlO₂; or any combination thereof.

Examples of the Group IV-VI semiconductor compound may include: a binary compound, such as SnS, SnSe, SnTe, PbS, PbSe, PbTe, and/or the like; a ternary compound, such as SnSeS, SnSeTe, SnSTe, PbSeS, PbSeTe, PbSTe, SnPbS, SnPbSe, SnPbTe, and/or the like; a quaternary compound, such as SnPbSSe, SnPbSeTe, SnPbSTe, and/or the like; or any combination thereof.

The Group IV element or compound may include: a single element compound, such as Si or Ge; a binary compound, such as SiC and/or SiGe; or any combination thereof.

Each element included in a multi-element compound such as the binary compound, ternary compound and quaternary compound, may exist in a particle with a uniform concentration or non-uniform concentration.

In an embodiment, the quantum dot may have a single structure or a dual core-shell structure. In the case of the quantum dot having a single structure, the concentration of each element included in the corresponding quantum dot may be uniform (e.g., substantially uniform). In an embodiment, the material contained in the core and the material contained in the shell may be different from each other.

The shell of the quantum dot may act as a protective layer to prevent or reduce chemical degeneration of the core to maintain semiconductor characteristics and/or as a charging layer to impart electrophoretic characteristics to the quantum dot. The shell may be a single layer or a multi-layer. The element presented in the interface between the core and the shell of the quantum dot may have a concentration gradient that decreases along a direction toward the center of the quantum dot.

Examples of the material forming the shell of the quantum dot may include an oxide of metal, metalloid, and/or non-metal, a semiconductor compound, or any combination thereof. Examples of the oxide of metal, metalloid, or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO; a ternary compound, such as MgAl₂O₄, CoFe₂O₄, NiFe₂O₄, and/or CoMn₂O₄; or any combination thereof. Examples of the semiconductor compound may include, as described herein, a Group II-VI semiconductor compound, a Group III-V semiconductor compound, a Group III-VI semiconductor compound, a Group I-III-VI semiconductor compound, a Group IV-VI semiconductor compound, or any combination thereof. In addition, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AIP, AlSb, or any combination thereof.

A full width at half maximum (FWHM) of an emission wavelength spectrum of the quantum dot may be about 45 nm or less, for example, about 40 nm or less, for example, about 30 nm or less, and within these ranges, color purity and/or color reproducibility may be increased. In addition, because the light emitted through the quantum dot is emitted in all (e.g., substantially all) directions, the wide viewing angle may be improved.

In addition, the quantum dot may be a spherical particle, a pyramidal particle, a multi-arm particle, a cubic nanoparticle, a nanotube particle, a nanowire particle, a nanofiber particle, and/or a nanoplate particle.

Because the energy band gap may be adjusted by controlling the size of the quantum dot, light having various suitable wavelength bands may be obtained from the quantum dot emission layer. Therefore, by utilizing quantum dots of different sizes, a light-emitting device that emits light of various suitable wavelengths may be implemented. In an embodiment, the size of the quantum dot may be selected to emit red, green and/or blue light. In addition, the size of the quantum dot may be configured to emit white light by combining light of various suitable colors.

### Electron transport region in interlayer 130

The electron transport region may have: i) a single-layered structure consisting of a single layer consisting of a single material, ii) a single-layered structure consisting of a single layer consisting of a plurality of different materials, or iii) a multilayered structure including a plurality of layers including different materials.

The electron transport region may include a buffer layer, a hole blocking layer, an electron control layer, an electron transport layer, an electron injection layer, or any combination thereof.

In an embodiment, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer.

In an embodiment, the electron transport region (for example, the buffer layer, the hole blocking layer, the electron control layer, or the electron transport layer in the electron transport region) may include a metal-free compound including at least one π electron-deficient nitrogen-containing C₁-C₆₀ cyclic group.

In an embodiment, the electron transport region may include a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or - P(=O)(Q₆₀₁)(Q₆₀₂),
Q₆₀₁ to Q₆₀₃ may each independently be the same as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group that is unsubstituted or substituted with at least one R₁₀ₐ.

In an embodiment, when xe11 in Formula 601 is 2 or more, two or more Ar₆₀₁(s) may be linked to each other via a single bond.

In an embodiment, Ar₆₀₁ in Formula 601 may be a substituted or unsubstituted anthracene group.

In an embodiment, the electron transport region may include a compound represented by Formula 601-1: 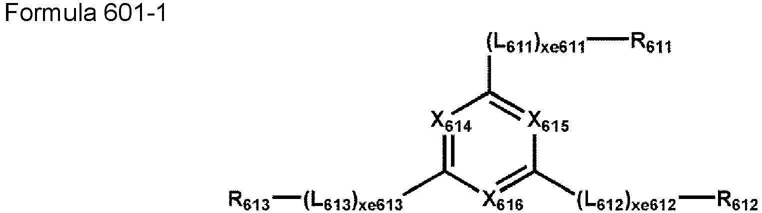 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.

In an embodiment, xe1 and xe611 to xe613 in Formulae 601 and 601-1 may each independently be 0, 1, or 2.

The electron transport region may include one of Compounds ET1 to ET45, 2,9-dimethyl-4,7-diphenyl-1,10-phenanthroline (BCP), 4,7-diphenyl-1,10-phenanthroline (Bphen), Alq₃, BAlq, TAZ, NTAZ, TSPO1, TPBi, or any combination thereof:

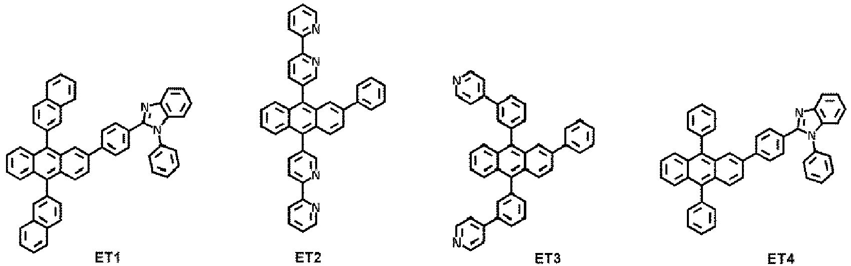

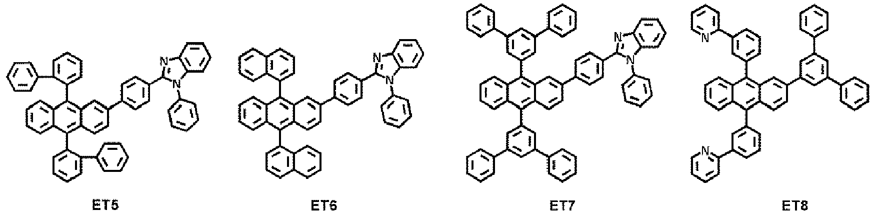

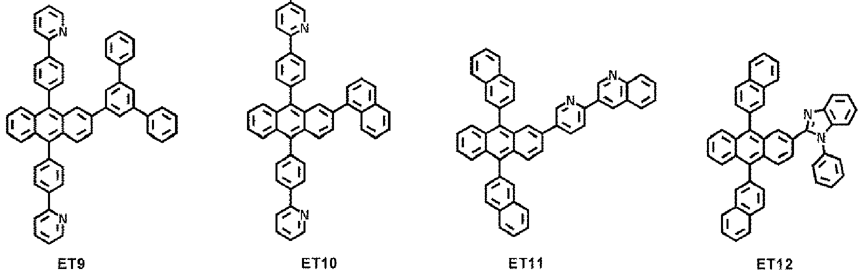

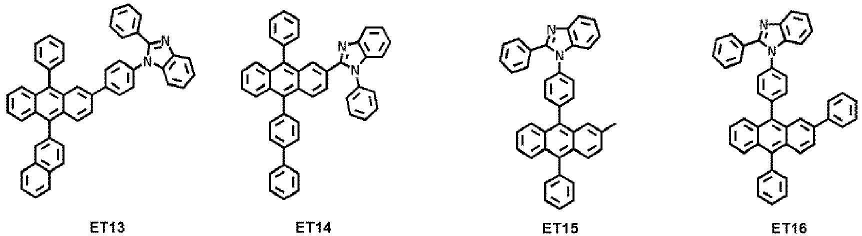

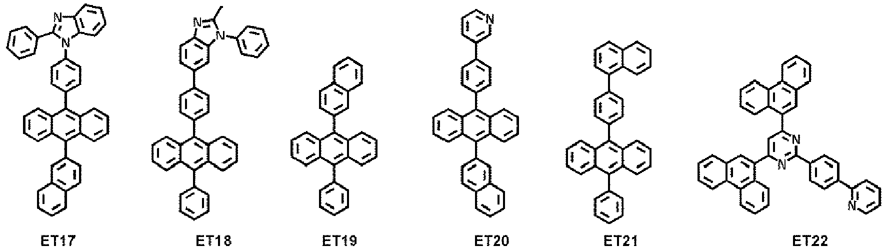

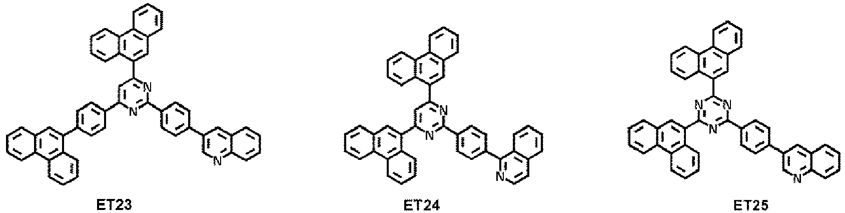

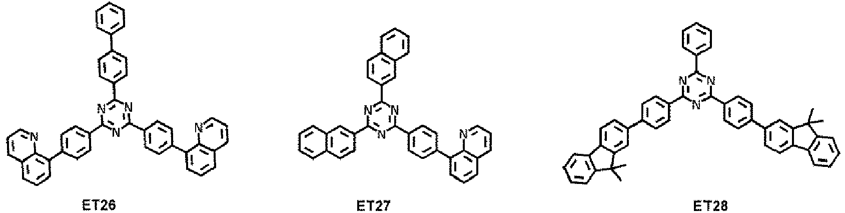

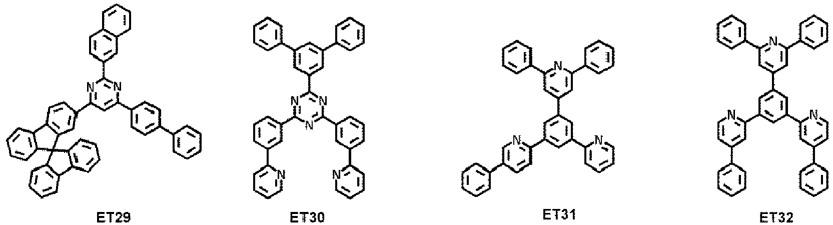

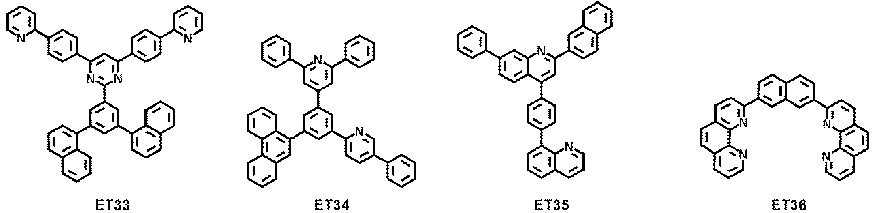

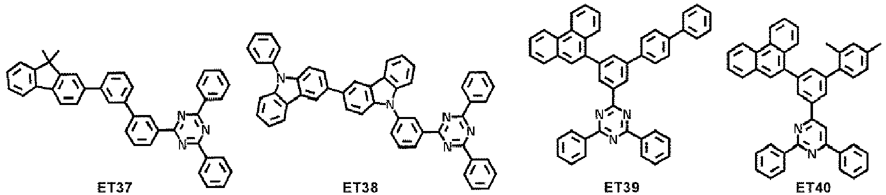

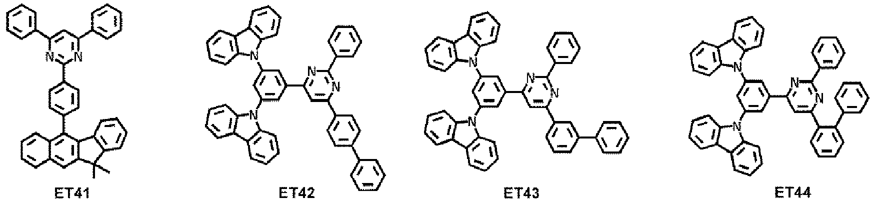

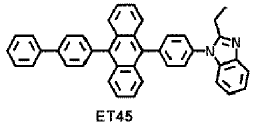

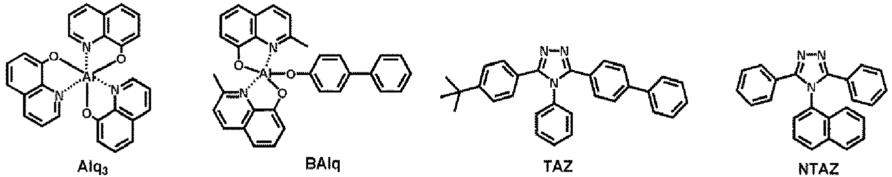

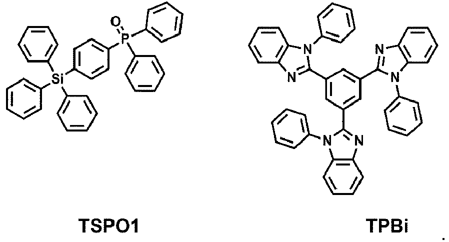

A thickness of the electron transport region may be about 10 nm to about 500 nm (about 100 Å to about 5,000 Å), for example, about 16 nm to about 400 nm (about 160 Å to about 4,000 A). When the electron transport region includes a buffer layer, a hole blocking layer, an electron control layer, an electron transport layer, or any combination thereof, the thickness of the buffer layer, the hole blocking layer, or the electron control layer may each independently be from about 2 nm to about 100 nm (about 20 Å to about 1,000 Å), for example, about 3 nm to about 30 nm (about 30 Å to about 300 Å), and the thickness of the electron transport layer may be from about 10 nm to about 100 nm (about 100 Å to about 1,000 Å), for example, about 15 nm to about 50 nm (about 150 Å to about 500 Å). When the thicknesses of the buffer layer, the hole blocking layer, the electron control layer, the electron transport layer, and/or the electron transport layer are within these ranges, suitable or satisfactory electron-transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In an embodiment, the metal-containing material may include a Li complex. The Li complex may include, for example, Compound ET-D1 (LiQ) or ET-D2:

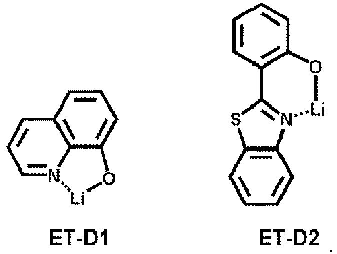

The electron transport region may include an electron injection layer to facilitate the injection of electrons from the second electrode 150. The electron injection layer may be in direct contact (e.g., physical contact) with the second electrode 150.

The electron injection layer may have: i) a single-layered structure consisting of a single layer consisting of a single material, ii) a single-layered structure consisting of a single layer consisting of a plurality of different materials, or iii) a multilayer structure including a plurality of layers including different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides (for example, fluorides, chlorides, bromides, and/or iodides), and/or tellurides of the alkali metal, the alkaline earth metal, and the rare earth metal, or any combination thereof.

The alkali metal-containing compound may include alkali metal oxides, such as Li₂O, Cs₂O, and/or K₂O, alkali metal halides, such as LiF, NaF, CsF, KF, Lil, Nal, Csl, and/or KI, or any combination thereof. The alkaline earth metal-containing compound may include an alkaline earth metal compound, such as BaO, SrO, CaO, BaₓSr₁₋ₓO (x is a real number satisfying the condition of 0<x<1), BaₓCa₁₋ₓO (x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, Ybl₃, Scl₃, Tbl₃, or any combination thereof. In an embodiment, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and Lu₂Te₃.

The alkali metal complex, the alkaline earth-metal complex, and the rare earth metal complex may include i) one of an ion of the alkali metal, the alkaline earth metal, and the rare earth metal and ii), as a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In an embodiment, the electron injection layer may further include an organic material (for example, a compound represented by Formula 601).

In an embodiment, the electron injection layer may include (e.g., consist of) i) an alkali metal-containing compound (for example, an alkali metal halide), ii) a) an alkali metal-containing compound (for example, an alkali metal halide); and b) an alkali metal, an alkaline earth metal, a rare earth metal, or any combination thereof. For example, the electron injection layer may be a KI:Yb co-deposited layer, a RbI:Yb co-deposited layer, a LiF:Yb co-deposited layer, and/or the like.

When the electron injection layer further includes an organic material, the alkali metal, alkaline earth metal, rare earth metal, alkali metal-containing compound, alkaline earth metal-containing compound, rare earth metal-containing compound, alkali metal complex, alkaline earth-metal complex, rare earth metal complex, or any combination thereof may be homogeneously or non-homogeneously dispersed in a matrix including the organic material.

A thickness of the electron injection layer may be in a range of about 0.1 nm to about 10 nm (about 1 Å to about 100 Å), and, for example, about 0.3 nm to about 9 nm (about 3 Å to about 90 Å). When the thickness of the electron injection layer is within the range described above, suitable or satisfactory electron injection characteristics may be obtained without a substantial increase in driving voltage.

### Second electrode 150

The second electrode 150 may be located on the interlayer 130 having such a structure. The second electrode 150 may be a cathode, which is an electron injection electrode, and as the material for the second electrode 150, a metal, an alloy, an electrically conductive compound, or any combination thereof, each having a low work function, may be utilized.

In an embodiment, the second electrode 150 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure or a multilayer structure including two or more layers.

### Capping layer

A first capping layer may be located outside the first electrode 110, and/or a second capping layer may be located outside the second electrode 150. In more detail, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

Light generated in an emission layer of the interlayer 130 of the light-emitting device 10 may be extracted toward the outside through the first electrode 110, which is a semi-transmissive electrode or a transmissive electrode, and the first capping layer or light generated in an emission layer of the interlayer 130 of the light-emitting device 10 may be extracted toward the outside through the second electrode 150, which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the emission efficiency of the light-emitting device 10 may be improved.

Each of the first capping layer and second capping layer may include a material having a refractive index (at a wavelength of 589 nm) of 1.6 or more.

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include carbocyclic compounds, heterocyclic compounds, amine group-containing compounds, porphyrin derivatives, phthalocyanine derivatives, naphthalocyanine derivatives, alkali metal complexes, alkaline earth metal complexes, or any combination thereof. The carbocyclic compound, the heterocyclic compound, and the amine group-containing compound may be optionally substituted with a substituent containing O, N, S, Se, Si, F, Cl, Br, I, or any combination thereof. In an embodiment, at least one of the first capping layer and the second capping layer may each independently include an amine group-containing compound.

In an embodiment, at least one of the first capping layer and the second capping layer may each independently include a compound represented by Formula 201, a compound represented by Formula 202, or any combination thereof.

In an embodiment, at least one of the first capping layer and the second capping layer may each independently include one of Compounds HT28 to HT33, one of Compounds CP1 to CP6, β-NPB, or any combination thereof:

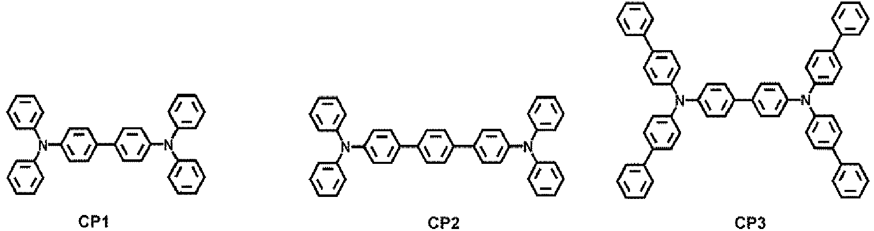

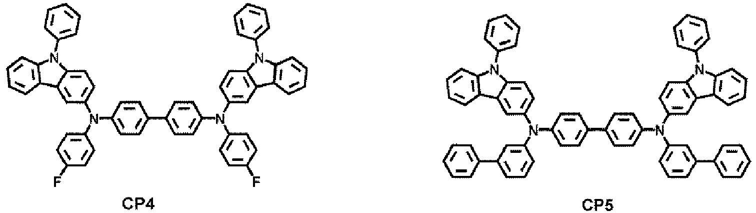

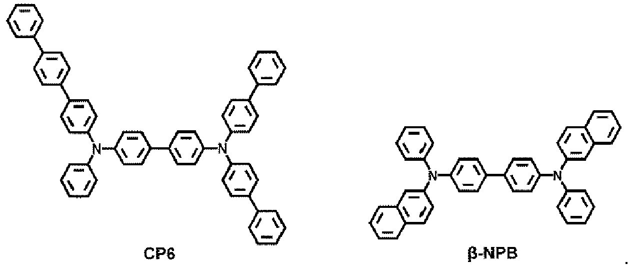

### Film

The condensed cyclic compound represented by Formula 1 may be included in various suitable films. According to one or more embodiments, provided is a film including the condensed cyclic compound represented by Formula 1. The film may be, for example, an optical member (e.g., a light control member) (for example, a color filter, a color conversion member, a capping layer, a light extraction efficiency enhancement layer, a selective light absorbing layer, a polarizing layer, a quantum dot-containing layer, and/or like), a light-blocking member (for example, a light reflective layer, a light absorbing layer, and/or the like), a protective member (for example, an insulating layer, a dielectric layer, and/or the like).

### Electronic apparatus

The light-emitting device may be included in various suitable electronic apparatuses. In an embodiment, the electronic apparatus including the light-emitting device may be a light-emitting apparatus, an authentication apparatus, and/or the like.

The electronic apparatus (for example, light-emitting apparatus) may further include, in addition to the light-emitting device, i) a color filter, ii) a color conversion layer, or iii) a color filter and a color conversion layer. The color filter and/or the color conversion layer may be located in at least one traveling direction of light emitted from the light-emitting device. In an embodiment, the light emitted from the light-emitting device may be blue light or white light. The light-emitting device may be the same as described above. In an embodiment, the color conversion layer may include quantum dots. The quantum dot may be, for example, a quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining layer may be located among the subpixel areas to define each of the subpixel areas.

The color filter may further include a plurality of color filter areas and light-shielding patterns located among the color filter areas, and the color conversion layer may include a plurality of color conversion areas and light-shielding patterns located among the color conversion areas.

The color filter areas (or the color conversion areas) may include a first area that emits a first color light, a second area that emits a second color light, and/or a third area that emits a third color light, and the first color light, the second color light, and/or the third color light may have different maximum emission wavelengths from one another. For example, the first color light may be red light, the second color light may be green light, and the third color light may be blue light. For example, the color filter areas (or the color conversion areas) may include quantum dots. In more detail, the first area may include a red quantum dot, the second area may include a green quantum dot, and the third area may not include a quantum dot. The quantum dot may be the same as described in the present specification. The first area, the second area, and/or the third area may each further include a scatterer.

In an embodiment, the light-emitting device may emit a first light, the first area may absorb the first light to emit a first first-color light, the second area may absorb the first light to emit a second first-color light, and the third area may absorb the first light to emit a third first-color light. In this regard, the first first-color light, the second first-color light, and the third first-color light may each have different maximum emission wavelengths. In more detail, the first light may be blue light, the first first-color light may be red light, the second first-color light may be green light, and the third first-color light may be blue light.

The electronic apparatus may further include a thin-film transistor in addition to the light-emitting device as described above. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, etc.

The activation layer may include crystalline silicon, amorphous silicon, organic semiconductor, oxide semiconductor, and/or the like.

The electronic apparatus may further include a sealing portion for sealing the light-emitting device. The sealing portion may be located between the color filter and/or the color-conversion layer and the light-emitting device. The sealing portion allows light from the light-emitting device to be extracted to the outside, while concurrently (e.g., simultaneously) preventing or reducing penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally located on the sealing portion, in addition to the color filter and/or the color conversion layer, according to the intended use of the electronic apparatus. The functional layers may include a touch screen layer, a polarizing layer, and/or the like. The touch screen layer may be a pressure-sensitive touch screen layer, a capacitive touch screen layer, and/or an infrared touch screen layer. The authentication apparatus may be, for example, a biometric authentication apparatus that authenticates an individual by utilizing biometric information of a living body (for example, fingertips, pupils, etc.).

The authentication apparatus may further include, in addition to the light-emitting device, a biometric information collector.

The electronic apparatus may be applied to various suitable displays, light sources, lighting, personal computers (for example, a mobile personal computer), mobile phones, digital cameras, electronic diaries, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, various suitable measuring instruments, meters (for example, meters for a vehicle, an aircraft, and a vessel), projectors, and the like.

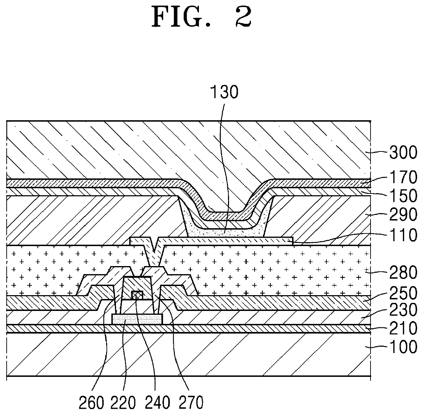

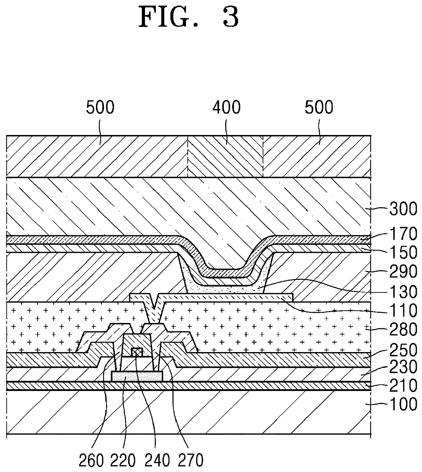

### Description of FIGS. 2 and 3

FIG. 2 is a cross-sectional view of a light-emitting apparatus according to an embodiment.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, and/or a metal substrate. A buffer layer 210 may be formed on the substrate 100. The buffer layer 210 may prevent or reduce penetration of impurities through the substrate 100 and may provide a flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region and a channel region.

A gate insulating film 230 for insulating the activation layer 220 from the gate electrode 240 may be located on the activation layer 220, and the gate electrode 240 may be located on the gate insulating film 230.

An interlayer insulating film 250 is located on the gate electrode 240. The interlayer insulating film 250 may be placed between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be in contact (e.g., physical contact) with the exposed portions of the source region and the drain region of the activation layer 220.

The TFT is electrically connected to a light-emitting device to drive the light-emitting device, and is covered by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be located on the passivation layer 280. The passivation layer 280 does not completely cover the drain electrode 270 and exposes a portion of the drain electrode 270, and the first electrode 110 is connected to the exposed portion of the drain electrode 270.

A pixel-defining layer 290 containing an insulating material may be located on the first electrode 110. The pixel-defining layer 290 exposes a region of the first electrode 110, and an interlayer 130 may be formed in the exposed region of the first electrode 110. The pixel-defining layer 290 may be a polyimide and/or polyacrylic organic film. In some embodiments, at least some layers of the interlayer 130 may extend beyond the upper portion of the pixel-defining layer 290 to be located in the form of a common layer.

The second electrode 150 may be located on the interlayer 130, and a capping layer 170 may be additionally formed on the second electrode 150. The capping layer 170 may cover the second electrode 150.

The encapsulation portion 300 may be located on the capping layer 170. The encapsulation portion 300 may be located on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or a combination thereof; or a combination of the inorganic film and the organic film.

FIG. 3 is a cross-sectional view of a light-emitting apparatus according to another embodiment.

The light-emitting apparatus of FIG. 3 is substantially the same as the light-emitting apparatus of FIG. 2, except that a light-shielding pattern 500 and a functional region 400 are additionally arranged on the encapsulation portion 300. The functional region 400 may be a combination of i) a color filter area, ii) a color conversion area, or iii) a combination of the color filter area and the color conversion area. In an embodiment, the light-emitting device included in the light-emitting apparatus of FIG. 3 may be a tandem light-emitting device.

### Manufacture method

Respective layers included in the hole transport region, the emission layer, and respective layers included in the electron transport region may be formed in a certain region by using one or more suitable methods selected from vacuum deposition, spin coating, casting, Langmuir-Blodgett (LB) deposition, ink-jet printing, laser-printing, and laser-induced thermal imaging.

When layers constituting the hole transport region, an emission layer, and layers constituting the electron transport region are formed by vacuum deposition, the deposition may be performed at a deposition temperature of about 100 °C to about 500 °C, a vacuum degree of about 133.3×10⁻⁸ Pa (10⁻⁸ torr) to about 133.3×10⁻³ Pa (10⁻³ torr), and a deposition speed of about 0.001 nm/sec to about 10 nm/sec (about 0.01 Å/sec to about 100 Å/sec), depending on a material to be included in a layer to be formed and the structure of a layer to be formed.

### Definition of terms

The term "C₃-C₆₀ carbocyclic group," as used herein, refers to a cyclic group consisting of carbon only as a ring-forming atom and having three to sixty carbon atoms, and the term "C₁-C₆₀ heterocyclic group," as used herein, refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed together with each other. In an embodiment, the C₁-C₆₀ heterocyclic group has 3 to 61 ring-forming atoms.

The term "cyclic group," as utilized herein, may include the C₃-C₆₀ carbocyclic group and the C₁-C₆₀ heterocyclic group.

The term "π electron-rich C₃-C₆₀ cyclic group," as used herein, refers to a cyclic group that has three to sixty carbon atoms and does not include *-N=*' as a ring-forming moiety, but a benzene group and a cyclohexene group are excluded, and the term "π electron-deficient nitrogen-containing C₁-C₆₀ cyclic group," as used herein, refers to a heterocyclic group that has one to sixty carbon atoms and includes *-N=*' as a ring-forming moiety.

In an embodiment,
the C₃-C₆₀ carbocyclic group may be i) a group T1 or ii) a condensed cyclic group in which two or more groups T1 are condensed together with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a group T2, ii) a condensed cyclic group in which two or more groups T2 are condensed together with each other, or iii) a condensed cyclic group in which at least one group T2 and at least one group T1 are condensed together with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) a group T1, ii) a condensed cyclic group in which two or more groups T1 are condensed together with each other, iii) a group T3, iv) a condensed cyclic group in which two or more groups T3 are condensed together with each other, or v) a condensed cyclic group in which at least one group T3 and at least one group T1 are condensed together with each other (for example, a group excluding a benzene group and a cyclohexene group among the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.), and
the π electron-deficient nitrogen-containing C₁-C₆₀ cyclic group may be i) a group T4, ii) a condensed cyclic group in which two or more group T4 are condensed together with each other, iii) a condensed cyclic group in which at least one group T4 and at least one group T1 are condensed together with each other, iv) a condensed cyclic group in which at least one group T4 and at least one group T3 are condensed together with each other, or v) a condensed cyclic group in which at least one group T4, at least one group T1, and at least one group T3 are condensed together with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
wherein the group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,
the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the group T3 may be a furan group, a thiophene group, a 1H-pyrrole group, a silole group, or a borole group, and
the group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group", "C₃-C₆₀ carbocyclic group", "C₁-C₆₀ heterocyclic group", "π electron-rich C₃-C₆₀ cyclic group", or "π electron-deficient nitrogen-containing C₁-C₆₀ cyclic group," as used herein, refers to a group condensed to any cyclic group or a polyvalent group (for example, a divalent group, a trivalent group, a tetravalent group, etc.), depending on the structure of a formula in connection with which the terms are used. In an embodiment, "a benzene group" may be a benzo group, a phenyl group, a phenylene group, or the like, which may be easily understood by one of ordinary skill in the art according to the structure of a formula including the "benzene group."

In an embodiment, examples of a monovalent C₃-C₆₀ carbocyclic group and a monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and examples of a divalent C₃-C₆₀ carbocyclic group and a divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group," as used herein, refers to a linear or branched aliphatic hydrocarbon monovalent group that has one to sixty carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group," as used herein, refers to a divalent group having substantially the same structure as the C₁-C₆₀ alkyl group.

The term "C₂-C₆₀ alkenyl group," as used herein, refers to a monovalent hydrocarbon group having at least one carbon-carbon double bond at a main chain (e.g., in the middle) or at a terminal end (e.g., the terminus) of the C₂-C₆₀ alkyl group, and examples thereof include an ethenyl group, a propenyl group, and a butenyl group. The term "C₂-C₆₀ alkenylene group," as used herein, refers to a divalent group having substantially the same structure as the C₂-C₆₀ alkenyl group.

The term "C₂-C₆₀ alkynyl group," as used herein, refers to a monovalent hydrocarbon group having at least one carbon-carbon triple bond at a main chain (e.g., in the middle) or at a terminal end (e.g., the terminus) of the C₂-C₆₀ alkyl group, and examples thereof include an ethynyl group and a propynyl group. The term "C₂-C₆₀ alkynylene group," as used herein, refers to a divalent group having substantially the same structure as the C₂-C₆₀ alkynyl group.

The term "C₁-C₆₀ alkoxy group," as used herein, refers to a monovalent group represented by -OA₁₀₁ (wherein A₁₀₁ is the C₁-C₆₀ alkyl group), and examples thereof include a methoxy group, an ethoxy group, and an isopropyloxy group.

The term "C₃-C₁₀ cycloalkyl group," as used herein, refers to a monovalent saturated hydrocarbon cyclic group having 3 to 10 carbon atoms, and examples thereof include a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group," as used herein, refers to a divalent group having substantially the same structure as the C₃-C₁₀ cycloalkyl group.

The term "C₁-C₁₀ heterocycloalkyl group," as used herein, refers to a monovalent cyclic group that further includes, in addition to a carbon atom, at least one heteroatom as a ring-forming atom and has 1 to 10 carbon atoms, and examples thereof include a 1,2,3,4-oxatriazolidinyl group, a tetrahydrofuranyl group, and a tetrahydrothiophenyl group. The term "C₁-C₁₀ heterocycloalkylene group," as used herein, refers to a divalent group having substantially the same structure as the C₁-C₁₀ heterocycloalkyl group.

The term "C₃-C₁₀ cycloalkenyl group," as used herein, refers to a monovalent cyclic group that has three to ten carbon atoms and at least one carbon-carbon double bond in a ring thereof and no aromaticity (e.g., is not aromatic), and examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group.

The term "C₁-C₁₀ heterocycloalkenyl group," as used herein, refers to a monovalent cyclic group that has, in addition to a carbon atom, at least one heteroatom as a ring-forming atom, 1 to 10 carbon atoms, and at least one carbon-carbon double bond in a cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group," as used herein, refers to a divalent group having substantially the same structure as the C₁-C₁₀ heterocycloalkenyl group.

The term "C₆-C₆₀ aryl group," as used herein, refers to a monovalent group having a carbocyclic aromatic system having six to sixty carbon atoms, and the term "C₆-C₆₀ arylene group," as used herein, refers to a divalent group having a carbocyclic aromatic system having six to sixty carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the rings may be condensed together with each other.

The term "C₁-C₆₀ heteroaryl group," as used herein, refers to a monovalent group having a heterocyclic aromatic system that has, in addition to a carbon atom, at least one heteroatom as a ring-forming atom, and 1 to 60 carbon atoms. The term "C₁-C₆₀ heteroarylene group," as used herein, refers to a divalent group having a heterocyclic aromatic system that has, in addition to a carbon atom, at least one heteroatom as a ring-forming atom, and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed together with each other.

The term "monovalent non-aromatic condensed polycyclic group," as used herein, refers to a monovalent group having two or more rings condensed to each other, only carbon atoms (for example, having 8 to 60 carbon atoms) as ring-forming atoms, and non-aromaticity in its molecular structure when considered as a whole (e.g., is not aromatic when considered as a whole). Examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group. The term "divalent non-aromatic condensed polycyclic group," as used herein, refers to a divalent group having substantially the same structure as a monovalent non-aromatic condensed polycyclic group.

The term "monovalent non-aromatic condensed heteropolycyclic group," as used herein, refers to a monovalent group having two or more rings condensed to each other, at least one heteroatom other than carbon atoms (for example, having 1 to 60 carbon atoms), as a ring-forming atom, and non-aromaticity in its molecular structure when considered as a whole (e.g., is not aromatic when considered as a whole). Examples of the monovalent non-aromatic condensed heteropolycyclic group include a pyrrolyl group, a thiophenyl group, a furanyl group, an indolyl group, a benzoindolyl group, a naphtho indolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group," as used herein, refers to a divalent group having substantially the same structure as a monovalent non-aromatic condensed heteropolycyclic group.

The term "C₆-C₆₀ aryloxy group," as used herein, indicates -OA₁₀₂ (wherein A₁₀₂ is the C₆-C₆₀ aryl group), and the term "C₆-C₆₀ arylthio group," as used herein, indicates -SA₁₀₃ (wherein A₁₀₃ is the C₆-C₆₀ aryl group).

The term "C₇₋C₆₀ aryl alkyl group," as used herein, refers to -A₁₀₄A₁₀₅ (where A₁₀₄ may be a C₁-C₅₄ alkylene group, and A₁₀₅ may be a C₆-C₅₉ aryl group), and the term "C₂-C₆₀ heteroaryl alkyl group," as used herein, refers to -A₁₀₆A₁₀₇ (where A₁₀₆ may be a C₁-C₅₉ alkylene group, and A₁₀₇ may be a C₁-C₅₉ heteroaryl group).

R₁₀ₐ may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group, a C₁-C₆₀ heterocyclic group, a C₇-C₆₀ aryl alkyl group, or a C₂-C₆₀ heteroaryl alkyl group, each unsubstituted or substituted with deuterium, -F, a cyano group, a C₁-C₆₀ alkyl group, a C₁-C₆₀ alkoxy group, a phenyl group, a biphenyl group, or any combination thereof.

The term "hetero atom," as used herein, refers to any atom other than a carbon atom. Examples of the heteroatom include O, S, N, P, Si, B, Ge, Se, or any combination thereof.

The term "the third-row transition metal," as used herein, includes hafnium (Hf), tantalum (Ta), tungsten (W), rhenium (Re), osmium (Os), iridium (Ir), platinum (Pt), gold (Au), and the like.

The term "Ph," as used herein, refers to a phenyl group, the term "Me," as used herein, refers to a methyl group, the term "Et," as used herein, refers to an ethyl group, the term "ter-Bu" or "Bu^{t}," as used herein, refers to a tert-butyl group, and the term "OMe," as used herein, refers to a methoxy group.

The term "biphenyl group," as used herein, refers to "a phenyl group substituted with a phenyl group." In other words, the "biphenyl group" is a substituted phenyl group having a C₆-C₆₀ aryl group as a substituent.

The term "terphenyl group," as used herein, refers to "a phenyl group substituted with a biphenyl group". The "terphenyl group" is a substituted phenyl group having, as a substituent, a C₆-C₆₀ aryl group substituted with a C₆-C₆₀ aryl group.
* and *', as used herein, unless defined otherwise, each refer to a binding site to a neighboring atom in a corresponding formula or moiety.

Hereinafter, a compound and light-emitting device according to an embodiment of the disclosure will be described in more detail with reference to the following Synthesis example and Examples. The wording "B was utilized instead of A," used in describing Synthesis Examples, indicates that an identical molar equivalent of B was utilized in place of A.

### Examples

### Synthesis Example 1: Synthesis of Compound 14

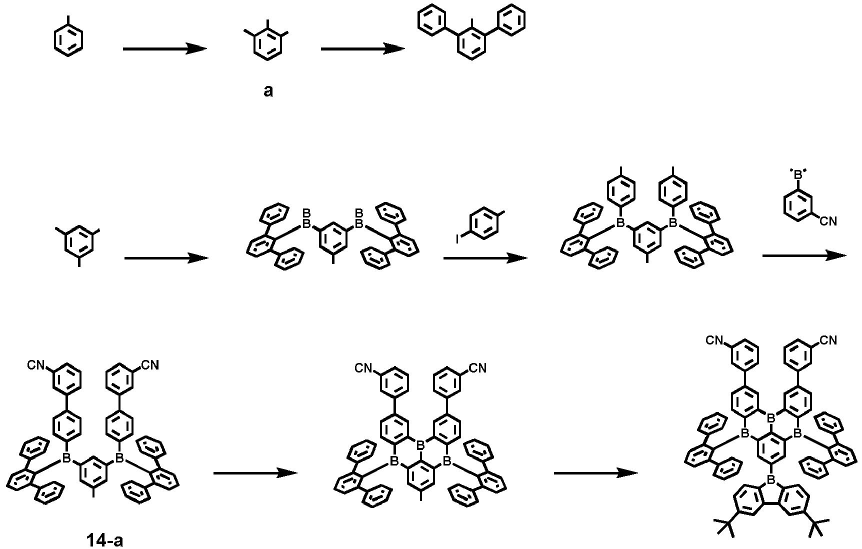

### Synthesis of Intermediate a

In an argon atmosphere, aniline (7.5 g, 80 mmol) was dissolved in 800 ml of dichloromethane and then cooled to 0 °C. With strong stirring, NBS (32.8 g, 184 mmol) was dissolved in 200 ml of dichloromethane and then added dropwise thereto, the temperature was raised to room temperature, and then, the resultant reaction solution was stirred for 24 hours. After the reaction was terminated, a solvent was removed therefrom under reduced pressure, followed by column chromatography for separation and purification by using ethyl acetate and hexane, to thereby obtain Intermediate **a** (white solid, 18.1 g, 72 mmol, 90%).

By ESI-LCMS, the obtained compound was identified as Intermediate **a.** (ESI-LCMS: [M]⁺: C₅H₄Br₂N₂. 250.88.)

### Synthesis of Intermediate b

In an argon atmosphere, Intermediate **a** (18.1 g, 72 mmol), phenyl boronic acid (21.9 g, 180 mmol), Pd(PPh₃)₄ (4.2 g, 3.6 mmol), and potassium carbonate (29.9 g, 216 mmol) were placed in a 2 L flask and dissolved in 600 ml of toluene and 200 ml of H₂O, and then, the resultant reaction solution was stirred at 100 °C for 12 hours. After cooling the resultant mixture, an extraction process was performed thereon by adding water (300 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **b** (white solid, 14 g, 57 mmol, 79 %).

By ESI-LCMS, the obtained compound was identified as Intermediate **b.** (ESI-LCMS: [M]⁺: C₁₇H₁₄N₂. 245.12.)

### Synthesis of Intermediate c

In an argon atmosphere, Intermediate **b** (14 g, 57 mmol), 1,3-dibromo-5-chlorobenzene (7.7 g, 29 mmol), Pd₂dba₃ (1.3 g, 1.5 mmol), tris-tert-butyl phosphine solution 50 % in toluene (1.4 ml, 2.9 mmol), and sodium tert-butoxide (8.4 g, 87 mmol) were placed in a 2 L flask and dissolved in 600 ml of o-xylene, and then, the resultant reaction solution was stirred at 140 °C for 12 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **c** (white solid, 12.7 g, 21 mmol, 73 %).

By ESI-LCMS, the obtained compound was identified as Intermediate **c.** (ESI-LCMS: [M]⁺: C₄₀H₂₉ClN₄. 598.22.)

### Synthesis of Intermediate d

In an argon atmosphere, Intermediate c (12.7 g, 21 mmol), 4-iodo-bromobenzene (29.7 g, 105 mmol), Pd₂dba₃ (1.0 g, 1.1 mmol), tris-tert-butyl phosphine solution 50 % in toluene (1.0 ml, 2.1 mmol), and sodium tert-butoxide (6.1 g, 63 mmol) were placed in a 1 L flask and dissolved in 300 ml of o-xylene, and then, the resultant reaction solution was stirred at 140 °C for 72 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **d** (white solid, 11.5 g, 12.6 mmol, 60 %).

By ESI-LCMS, the obtained compound was identified as Intermediate **d.** (ESI-LCMS: [M]⁺: C₅₂H₃₅Br₂ClN₄. 908.10.)

### Synthesis of Intermediate 14-a

In an argon atmosphere, Intermediate **d** (11.5 g, 13 mmol), (3-cyanophenyl) boronic acid (3.1 g, 25 mmol), Pd(PPh₃)₄ (0.73 g, 0.63 mmol), and potassium carbonate (5.2 g, 38 mmol) were placed in a 500 ml flask and dissolved in 150 ml of toluene and 50 ml of H₂O, and then, the resultant reaction solution was stirred at 100 °C for 12 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **14-a** (white solid, 7.7 g, 8.5 mmol, 65 %).

By ESI-LCMS, the obtained compound was identified as Intermediate **14-a.** (ESI-LCMS: [M]⁺: C₆₄H₄₅ClN₄. 952.33.)

### Synthesis of Intermediate 14-b

In an argon atmosphere, Intermediate **14-a** (7.7 g, 8.5 mmol) was placed in a 500 ml flask and dissolved in 160 ml of o-dichlorobenzene, followed by cooling by using water-ice, BBr₃ (5 equiv.) was slowly added dropwise thereto, and then the resultant reaction solution was stirred at 180 °C for 12 hours. After cooling the resultant mixture, triethylamine (5 equiv.) was added thereto to terminate the reaction, and an extraction process was performed thereon by using water/CH₂Cl₂ to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **14-b** (yellow solid, 3.0 g, 3.2 mmol, 38 %).

By ESI-LCMS, the obtained compound was identified as Intermediate **14-b.** (ESI-LCMS: [M]⁺: C₆₄H₄₂BClN₄. 960.32.)

### Synthesis of Compound 14

In an argon atmosphere, Intermediate **14-b** (3.0 g, 3.2 mmol), 3,6-di-tert-butyl-carbazole (0.6 g, 3.5 mmol), Pd₂dba₃ (0.15 g, 0.16 mmol), tris-tert-butyl phosphine solution 50 % in toluene (0.15 ml, 0.3 mmol), and sodium tert-butoxide (0.62 g, 6.4 mmol) were placed in a 500 ml flask and dissolved in 50 ml of o-xylene, and then, the resultant reaction solution was stirred at 140 °C for 12 hours. After cooling the resultant mixture, an extraction process was performed thereon by adding water (300 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Compound **14** (yellow solid, 2.27 g, 2.18 mmol, 68 %).

By ¹H-NMR and ESI-LCMS, the obtained compound was identified as Compound **14.** (ESI-LCMS: [M]⁺: C₇₆H₅₀BN₅. 1023.54.)

### Synthesis Example 2: Synthesis of Compound 25

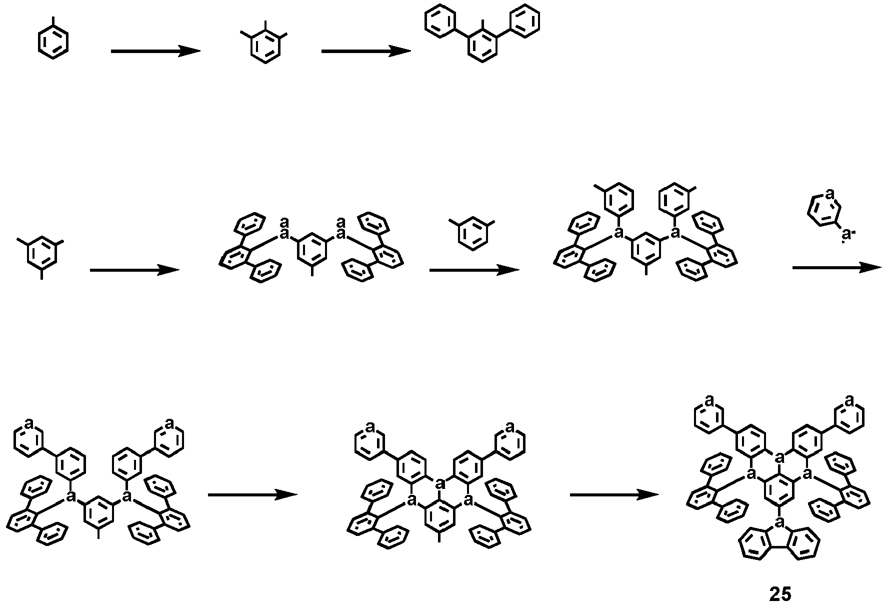

Intermediates **a, b,** and **c** were each synthesized in the same manner as described above.

### Synthesis of Intermediate e

In an argon atmosphere, Intermediate **c** (12.0 g, 20 mmol), 3-iodo-bromobenzene (28.3 g, 100 mmol), Pd₂dba₃ (0.9 g, 1.0 mmol), tris-tert-butyl phosphine solution 50 % in toluene (0.9 ml, 2.0 mmol), and sodium tert-butoxide (5.8 g, 60 mmol) were placed in a 1 L flask and dissolved in 300 ml of o-xylene, and then, the resultant reaction solution was stirred at 140 °C for 72 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **e** (white solid, 12.0 g, 13.2 mmol, 66 %).

By ESI-LCMS, the obtained compound was identified as Intermediate **e.** (ESI-LCMS: [M]⁺: C₅₂H₃₅Br₂ClN₄. 908.10.)

### Synthesis of Intermediate 25-a

In an argon atmosphere, Intermediate e (12.0 g, 13 mmol), pyridine-3-ylboronic acid (6.1 g, 26 mmol), Pd(PPh₃)₄ (0.76 g, 0.66 mmol), and potassium carbonate (5.5 g, 40 mmol) were placed in a 500 ml flask and dissolved in 150 ml of toluene and 50 ml of H₂O, and then, the resultant reaction solution was stirred at 100 °C for 12 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **25-a** (white solid, 8.5 g, 7.5 mmol, 58 %).

By ESI-LCMS, the obtained compound was identified as Intermediate **25-a.** (ESI-LCMS: [M]⁺: C₃₀H₇₇ClN₄. 904.33.)

### Synthesis of Intermediate 25-b

In an argon atmosphere, Intermediate **25-a** (8.5 g, 7.5 mmol) was placed in a 500 ml flask and dissolved in 160 ml of o-dichlorobenzene, followed by cooling by using water-ice, BBr₃ (5 equiv.) was slowly added dropwise thereto, and then the resultant reaction solution was stirred at 180 °C for 12 hours. After cooling the resultant mixture, triethylamine (5 equiv.) was added thereto to terminate the reaction, and an extraction process was performed thereon by using water/CH₂Cl₂ to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **25-b** (yellow solid, 2.5 g, 2.2 mmol, 29 %).

By ESI-LCMS, the obtained compound was identified as Intermediate **25-b.** (ESI-LCMS: [M]⁺: C₈₀H₇₄BClN₄. 912.32.)

### Synthesis of Compound 25

In an argon atmosphere, Intermediate **25-b** (2.5 g, 2.2 mmol), 9H-carbazole (0.40 g, 2.4 mmol), Pd₂dba₃ (0.10 g, 0.11 mmol), tris-tert-butyl phosphine solution 50 % in toluene (0.10 mL, 0.22 mmol), and sodium tert-butoxide (0.42 g, 4.4 mmol) were placed in a 500 ml flask and dissolved in 50 ml of o-xylene, and then, the resultant reaction solution was stirred at 140 °C for 12 hours. After cooling the resultant mixture, an extraction process was performed thereon by adding water (300 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Compound **25** (yellow solid, 1.7 g, 1.3 mmol, 60 %).

By ¹H-NMR and ESI-LCMS, the obtained compound was identified as Compound **25.** (ESI-LCMS: [M]⁺: C₉₂H₈₂BN₅. 1043.42.)

### Synthesis Example 3: Synthesis of Compound 49

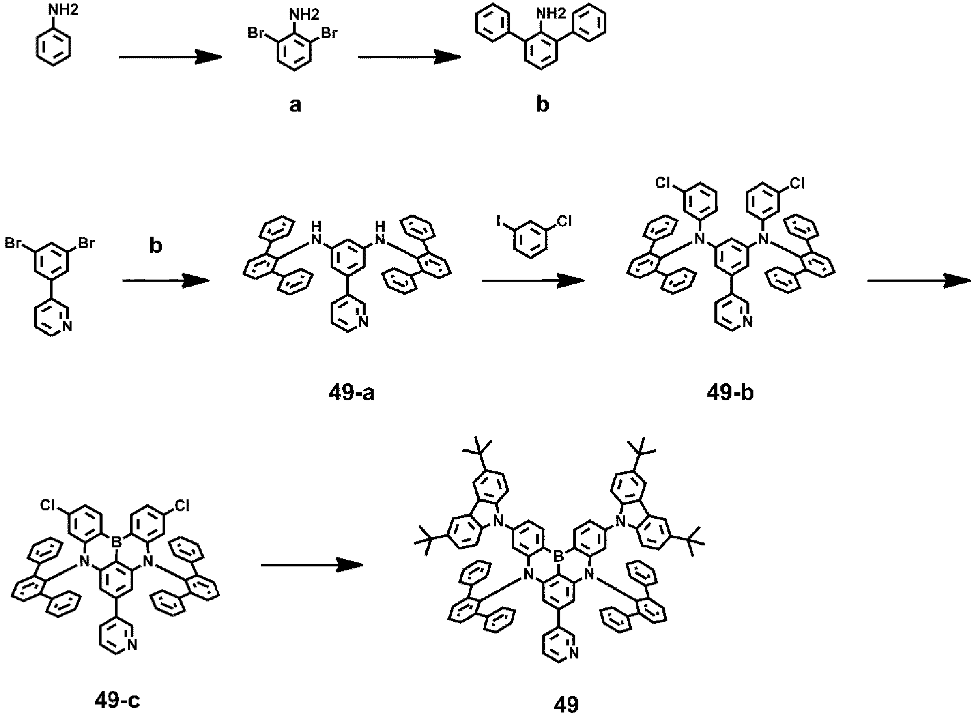

Intermediates **a** and **b** were each synthesized in the same manner as described above.

### Synthesis of Intermediate 49-a

In an argon atmosphere, Intermediate **b** (14 g, 57 mmol), 3-(3,5-dibromophenyl)pyridine (9.1 g, 29 mmol), Pd₂dba₃ (1.3 g, 1.5 mmol), tris-tert-butyl phosphine solution 50 % in toluene (1.4 ml, 2.9 mmol), and sodium tert-butoxide (8.4 g, 87 mmol) were placed in a 2 L flask and dissolved in 600 ml of o-xylene, and then, the resultant reaction solution was stirred at 140 °C for 12 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **49-a** (white solid, 12.8 g, 20 mmol, 70 %).

By ESI-LCMS, the obtained compound was identified as Intermediate **49-a.** (ESI-LCMS: [M]⁺: C₄₇H₃₅N₃. 641.28)

### Synthesis of Intermediate 49-b

In an argon atmosphere, Intermediate **49-a** (12.8 g, 20 mmol), 1-chloro-3-iodobenzene (29.7 g, 140 mmol), Pd₂dba₃ (1.3 g, 1.4 mmol), tris-tert-butyl phosphine solution 50 % in toluene (1.3 ml, 2.8 mmol), and sodium tert-butoxide (8.1 g, 84 mmol) were placed in a 500 ml flask and dissolved in 300 ml of o-xylene, and then, the resultant reaction solution was stirred at 140 °C for 72 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Intermediate **49-b** (white solid, 15.3 g, 17.8 mmol, 63 %).

By ESI-LCMS, the obtained compound was identified as Intermediate **49-b.** (ESI-LCMS: [M]⁺: C₅₉H₄₁Cl₂N₃. 861.27)

### Synthesis of Intermediate 49-c

In an argon condition, Intermediate **49-b** (15.3 g, 17.8 mmol) was placed in a 500 ml flask and dissolved in 300 ml of o-dichlorobenzene, followed by cooling by using water-ice, BBr₃ (5 equiv.) was slowly added dropwise, and then, the resultant reaction solution was stirred at 180 °C for 12 hours. After cooling the resultant mixture, triethylamine (5 equiv.) was added thereto to terminate the reaction, and an extraction process was performed thereon by using water/CH₂Cl₂ to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Intermediate **49-c** (yellow solid, 3.6 g, 4.2 mmol, 24 %).

By ESI-LCMS, the obtained compound was identified as Intermediate **49-c.** (ESI-LCMS: [M]⁺: C₅₉H₃₈BCl₂N₃. 869.25)

### Synthesis of Compound 49

In an argon condition, Intermediate **49-c** (3.6 g, 4.2 mmol), 3,6-di-tert-butyl-9H-carbazole (2.5 g, 9.0 mmol), Pd₂dba₃ (0.20 g, 0.22 mmol), tris-tert-butyl phosphine solution 50 % in toluene (0.20 ml, 0.43 mmol), and sodium tert-butoxide (1.24 g, 12.9 mmol) were placed in a 500 ml flask and dissolved in 50 ml of o-xylene, and then, the resultant reaction solution was stirred at 140 °C for 12 hours. After cooling the resultant mixture, an extraction process was performed thereon by adding water (300 ml) and ethyl acetate (300 ml) thereto to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Compound **49** (yellow solid, 3.8 g, 2.8 mmol, 65 %).

By ¹H-NMR and ESI-LCMS, the obtained compound was identified as Compound **49.** (ESI-LCMS: [M]⁺: C₉₉H₈₆BN₅. 1355.70)

### Synthesis Example 4: Synthesis of Compound 57

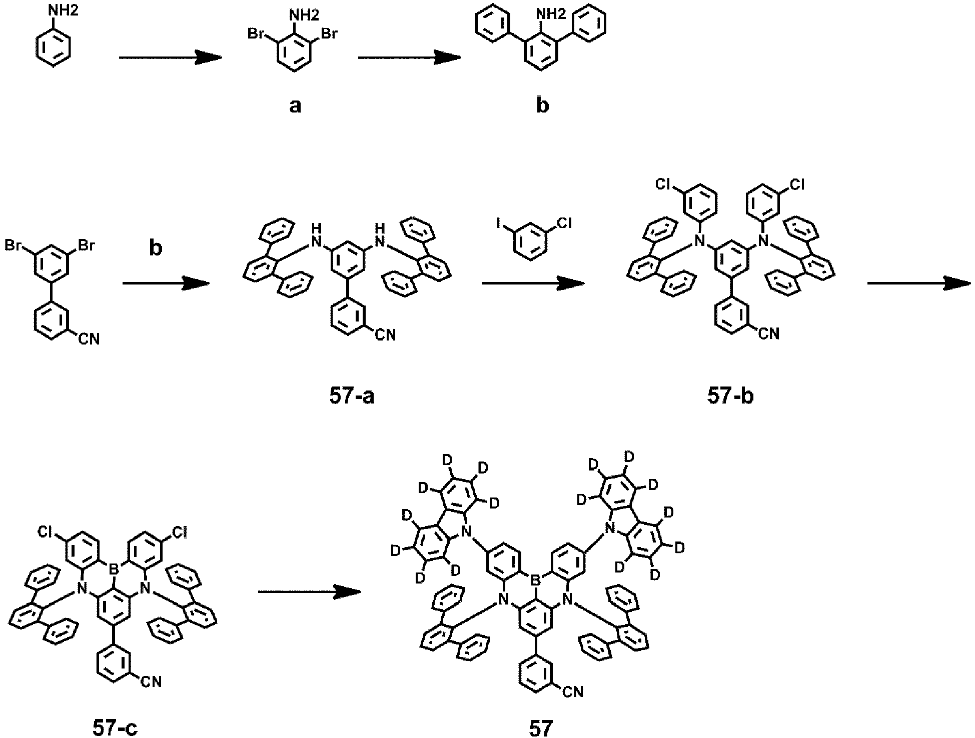

Intermediates **a** and **b** were each synthesized in the same manner as described above.

### Synthesis of Intermediate 57-a

In an argon atmosphere, Intermediate **b** (14 g, 57 mmol), 3',5'-dibromo-[1,1'-biphenyl]-3-carbonitrile (9.8 g, 29 mmol), pd₂dba₃ (1.3 g, 1.5 mmol), tris-tert-butyl phosphine solution 50 % in toluene (1.4 ml, 2.9 mmol), and sodium tert-butoxide (8.4 g, 87 mmol) were placed in a 2 L flask and dissolved in 600 ml of o-xylene, and then, the resultant reaction solution was stirred at 140 °C for 12 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **57-a** (white solid, 13.3 g, 20 mmol, 70 %).

By ESI-LCMS, the obtained compound was identified as Intermediate **57-a.** (ESI-LCMS: [M]⁺: C₄₉H₃₅N₃. 665.28)

### Synthesis of Intermediate 57-b

In an argon atmosphere, Intermediate **57-a** (13.3 g, 20 mmol), 1-chloro-3-iodobenzene (29.7 g, 140 mmol), Pd₂dba₃ (1.3 g, 1.4 mmol), tris-tert-butyl phosphine solution 50 % in toluene (1.3 ml, 2.8 mmol), and sodium tert-butoxide (8.1 g, 84 mmol) were placed in a 500 ml flask and dissolved in 300 ml of o-xylene, and then, the resultant reaction solution was stirred at 140 °C for 72 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Intermediate **57-b** (white solid, 15.7 g, 17.8 mmol, 63 %).

By ESI-LCMS, the obtained compound was identified as Intermediate **57-b.** (ESI-LCMS: [M]⁺: C₆₁H₄₁Cl₂N₃. 885.27)

### Synthesis of Intermediate 57-c

In an argon condition, Intermediate **57-b** (15.7 g, 17.8 mmol) was placed in a 500 ml flask and dissolved in 300 ml of o-dichlorobenzene, followed by cooling by using water-ice, BBr₃ (5 equiv.) was slowly added dropwise, and then, the resultant reaction solution was stirred at 180 °C for 12 hours. After cooling the resultant mixture, triethylamine (5 equiv.) was added thereto to terminate the reaction, and an extraction process was performed thereon by using water/CH₂Cl₂ to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Intermediate **57-c** (yellow solid, 3.7 g, 4.2 mmol, 24 %).

By ESI-LCMS, the obtained compound was identified as Intermediate **57-c.** (ESI-LCMS: [M]⁺: C₆₁H₃₈BCl₂N₃. 893.25)

### Synthesis of Compound 57

In an argon condition, Intermediate **57-c** (3.7 g, 4.2 mmol), 9H-carbazole-1,2,3,4,5,6,7,8-d8 (1.6 g, 9.0 mmol), Pd₂dba₃ (0.20 g, 0.22 mmol), tris-tert-butyl phosphine solution 50 % in toluene (0.20 ml, 0.43 mmol), and sodium tert-butoxide (1.24 g, 12.9 mmol) were placed in a 500 ml flask and dissolved in 50 ml of o-xylene, and then, the resultant reaction solution was stirred at 140 °C for 12 hours. After cooling the resultant mixture, an extraction process was performed thereon by adding water (300 ml) and ethyl acetate (300 ml) thereto to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Compound **57** (yellow solid, 3.3 g, 2.8 mmol, 65 %).

By ¹H-NMR and ESI-LCMS, the obtained compound was identified as Compound **57.** (ESI-LCMS: [M]⁺: C₈₅H₃₈D₁₈BN₅. 1171.55)

### Synthesis Example 5: Synthesis of Compound 72

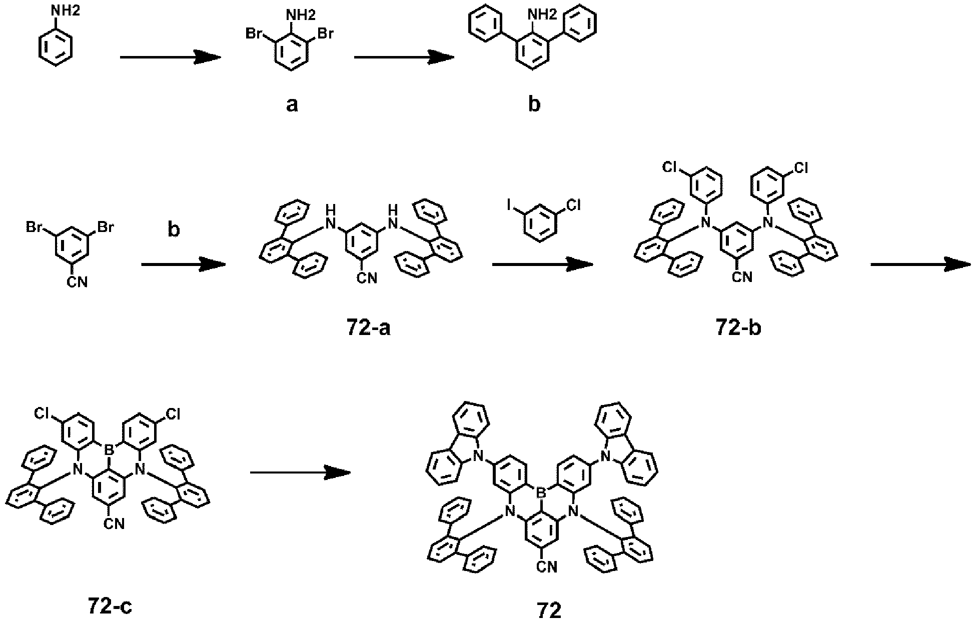

Intermediates **a** and **b** were each synthesized in the same manner as described above.

### Synthesis of Intermediate 72-a

In an argon atmosphere, Intermediate **b** (14 g, 57 mmol), 3,5-dibromobenzonitrile (7.5 g, 29 mmol), Pd₂dba₃ (1.3 g, 1.5 mmol), tris-tert-butyl phosphine solution 50 % in toluene (1.4 ml, 2.9 mmol), and sodium tert-butoxide (8.4 g, 87 mmol) were placed in a 2 L flask and dissolved in 600 ml of o-xylene, and then, the resultant reaction solution was stirred at 140 °C for 12 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was separated and purified by column chromatography by using CH₂Cl₂ and hexane to thereby obtain Intermediate **72-a** (white solid, 11.8 g, 20 mmol, 70 %).

By ESI-LCMS, the obtained compound was identified as Intermediate **72-a.** (ESI-LCMS: [M]⁺: C₄₃H₃₁N₃. 589.25)

### Synthesis of Intermediate 72-b

In an argon atmosphere, Intermediate **72-a** (11.8 g, 20 mmol), 1-chloro-3-iodobenzene (29.7 g, 140 mmol), Pd₂dba₃ (1.3 g, 1.4 mmol), tris-tert-butyl phosphine solution 50 % in toluene (1.3 ml, 2.8 mmol), and sodium tert-butoxide (8.1 g, 84 mmol) were placed in a 500 ml flask and dissolved in 300 ml of o-xylene, and then, the resultant reaction solution was stirred at 140 °C for 72 hours. After cooling the resultant mixture, an extraction process was performed thereon by adding water (500 ml) and ethyl acetate (300 ml) thereto to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Intermediate **72-b** (white solid, 14.4 g, 17.8 mmol, 63 %).

By ESI-LCMS, the obtained compound was identified as Intermediate **72-b.** (ESI-LCMS: [M]⁺: C₅₅H₃₇Cl₂N₃. 809.24)

### Synthesis of Intermediate 72-c

In an argon condition, Intermediate **72-b** (14.4 g, 17.8 mmol) was placed in a 500 ml flask and dissolved in 300 ml of o-dichlorobenzene, followed by cooling by using water-ice, BBr₃ (5 equiv.) was slowly added dropwise, and then, the resultant reaction solution was stirred at 180 °C for 12 hours. After cooling the resultant mixture, triethylamine (5 equiv.) was added thereto to terminate the reaction, and an extraction process was performed thereon by using water/CH₂Cl₂ to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Intermediate **72-c** (yellow solid, 3.4 g, 4.2 mmol, 24 %).

By ESI-LCMS, the obtained compound was identified as Intermediate **72-c.** (ESI-LCMS: [M]⁺: C₅₅H₃₄BCl₂N₃. 817.22)

### Synthesis of Compound 72

In an argon condition, Intermediate **72-c** (3.4 g, 4.2 mmol), 9H-carbazole (1.5 g, 9.0 mmol), Pd₂dba₃ (0.20 g, 0.22 mmol), tris-tert-butyl phosphine solution 50 % in toluene (0.20 ml, 0.43 mmol), and sodium tert-butoxide (1.24 g, 12.9 mmol) were placed in a 500 ml flask and dissolved in 50 ml of o-xylene, and then, the resultant reaction solution was stirred at 140 °C for 12 hours. After cooling the resultant mixture, an extraction process was performed thereon by adding water (300 ml) and ethyl acetate (300 ml) thereto to obtain an organic layer which was then dried by using MgSO₄, followed by filtration. A resultant solution thus filtered was depressurized to remove a solvent therefrom, and a solid thus obtained was purified and separated by silica gel column chromatography by using CH₂Cl₂ and hexane as developing solvents to thereby obtain Compound **72** (yellow solid, 3.0 g, 2.8 mmol, 65 %).

By ¹H-NMR and ESI-LCMS, the obtained compound was identified as Compound 72. (ESI-LCMS: [M]+: C₇₉H₅₀BN₅. 1079.42)

¹H NMR and MS/FAB of the compounds synthesized according to Synthesis Examples 1 to 5 are shown in Table 1. Synthesis methods of other compounds in addition to the compounds shown in Table 1 may be easily recognized by those skilled in the art by referring to the synthesis paths and source materials described herein.

**Table 1**

| Compo und | ¹H NMR (400 MHz, CdCl₃) (δ) | MS/FAB | |
|---|---|---|---|
| | | Calc | Found |
| 14 | δ = 8.95 (d, 2H), 8.20 (d, 4H). 8.02 (s, 2H), 7.85-7.72 (m, 6H), 7.68 (d, 2H), 7.63 (s, 2H), 7.62 (s, 2H), 7.55-7.43 (d, 4H), 7.50 (s, 2H), 7.43-7.39 (m, 14H), 7.55 (s, 2H), 7.43 (d, 2H), 7.43-7.39 (m, 14H), 7.08 (m, 4H) , 6.89 (d, 2H), 1.43 (s, 36H) | 1203.54 | 1203.54 |
| 25 | δ = 9.24 (s, 2H), 8.70 (s, 2H), 8.55 (d, 2H), 8.42 (s, 2H), 8.20 (d, 4H), 7.90 (d, 2H), 7.57 (s, 2H), 7.43 (d, 2H), 7.43-7.39 (m, 14H), 7.27 (d, 2H), 7.20 (d, 2H), 7.08 (m, 4H), 6.89 (d, 2H) | 1043.42 | 1043.42 |
| 49 | δ = 9.24 (s, 1H), 8.95 (d, 2H), 8.70 (s, 1H), 8.42 (s, 1H), 8.36 (d, 2H), 8.20 (m, 4H), 7.86 (d, 2H), 7.85 (d, 2H), 7.65 (d, 2H), 7.57 (s, 1H), 7.43-7.39 (m, 14H), 7.39 (d, 2H), 7.23 (d, 2H), 7.08 (m, 8H), 6.93 (s, 2H), 1.43 (s, 36H) | 1355.70 | 1355.70 |
| 57 | δ = 8.20 (d, 2H), 8.02 (s, 1H), 7.85 (d, 2H), 7.85-7.72 (m, 3H), 7.43-7.39 (m, 16H), 7.23 (d, 2H), 7.08 (m, 8H), 6.93 (s, 2H) | 1171.55 | 1171.55 |
| 72 | δ = 8.55 (d, 2H), 8.20 (s, 4H), 8.19 (m, 2H), 7.94 (m, 2H), 7.85 (d, 2H), 7.58 (m, 2H), 7.50 (m, 2H), 7.43 (m. 8H), 7.41 (m, 4H), 7.39 (d, 2H), 7.23 (s, 2H), 7.08 (s, 8H) | 1079.42 | 1079.42 |

### Evaluation Example 1

In order to evaluate physical properties of Compounds 14, 25, 49, 57, and 72, which were condensed cyclic compounds of embodiments of the present application, and DABNA-1, DABNA-2, and Compounds C1 to C6, which were comparative example compounds, HOMO and LUMO energy levels (eV), oscillator strength (f), up-conversion rate constant (k_{RlSC}) from triplet state to singlet state, and C-N binding energy (eV) between carbon of a core of a compound and nitrogen of an electron donating group connected to the carbon was evaluated, and results thereof are shown in Table 2. (C-N binding energy: indicated as "-" when the measurement is impossible due to the absence of a C-N bond)

**Table 2**

| Compound | HOMO (eV) | LUMO (eV) | Oscillator strength (f) | k_{RISC} (s⁻¹) | C-N binding energy (eV) |
|---|---|---|---|---|---|
| Compound 14 | -5.48 | -1.96 | 0.42 | 4.28E+05 | 2.48 |
| Compound 25 | -5.36 | -1.91 | 0.43 | 8.84E+04 | 2.45 |
| Compound 49 | -5.35 | -1.89 | 0.47 | 3.79E+04 | 2.46 |
| Compound 57 | -5.41 | -2.01 | 0.46 | 5.37E+04 | 2.60 |
| Compound 72 | -5.52 | -2.15 | 0.55 | 5.78E+04 | 2.65 |
| DABNA-1 | -5.00 | -1.37 | 0.20 | 2.26E+03 | - |
| DABNA-2 | -4.95 | -1.48 | 0.41 | 1.63E+04 | 1.70 |
| C1 | -5.15 | -1.61 | 0.29 | 1.52E+04 | 2.07 |
| C2 | -5.62 | -2.31 | 0.16 | 1.75E+03 | 2.21 |
| C3 | -4.86 | -2.02 | 0.12 | 8.68E+03 | 2.33 |
| C4 | -4.76 | -1.64 | 0.17 | 1.27E+04 | 2.22 |
| C5 | -5.14 | -1.74 | 0.32 | 1.40E+04 | - |
| C6 | -4.75 | -1.58 | 0.15 | 5.10E+03 | 2.26 |

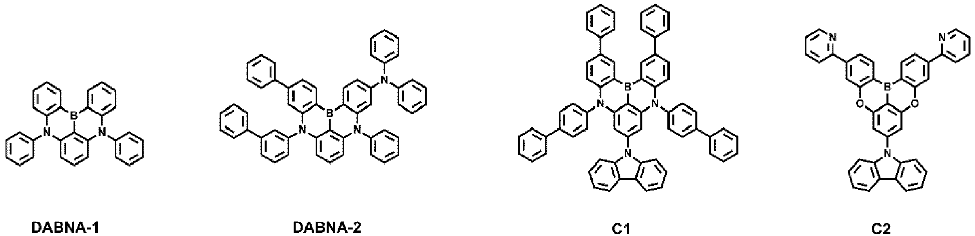

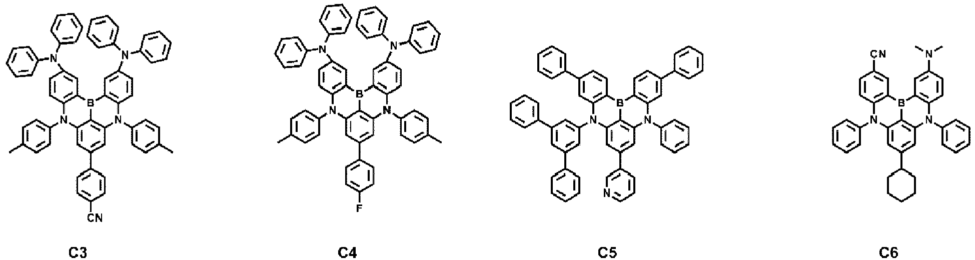

From Table 2, it can be seen that Compounds 14, 25, 49, 57, and 72, which were the condensed cyclic compounds of the present application, had higher oscillator strength, higher K_{RISC}, higher binding energy, and higher material stability than those of DABNA-1, DABNA-2, and Compounds C1 to C6.

### Example 1

As an anode, a glass substrate (available from Corning Co., Ltd) on which an ITO electrode of 15 Ω/cm² (1,200 Å, that is 120 nm) was formed was cut to a size of 50 mm×50 mm×0.7 mm, sonicated in isopropyl alcohol and pure water for 5 minutes in each solvent, cleaned by irradiation of ultraviolet rays and exposure of ozone thereto for 30 minutes, and then mounted on a vacuum deposition apparatus.

NPB was deposited on the anode to form a hole injection layer having a thickness of 30 nm (300 Å), HT6 was deposited on the hole injection layer to form a hole transport layer having a thickness of 20 nm (200 Å), and then, CzSi was deposited on the hole transport layer to form an emission auxiliary layer having a thickness of 10 nm (100 Å).

A mixture of HTH53 and ETH85 (pre-mixed at 1:1), PD40, and Compound 14 were co-deposited on the emission auxiliary layer at a weight ratio of 82:15:3 to form an emission layer having a thickness of 20 nm (200 Å).

Next, TSPO1 was deposited on the emission layer to form a hole blocking layer having a thickness of 20 nm (200 Å), TPBI was deposited on the hole blocking layer to form an electron transport layer having a thickness of 30 nm (300 Å), LiF was deposited on the electron transport layer to form an electron injection layer having a thickness of 1 nm (10 Å), Al was deposited on the electron injection layer to form a cathode having a thickness of 300 nm (3,000 Å), and HT28 was deposited on the electrode to form a capping layer having a thickness of 70 nm (700 Å), thereby completing manufacture of a light-emitting device.

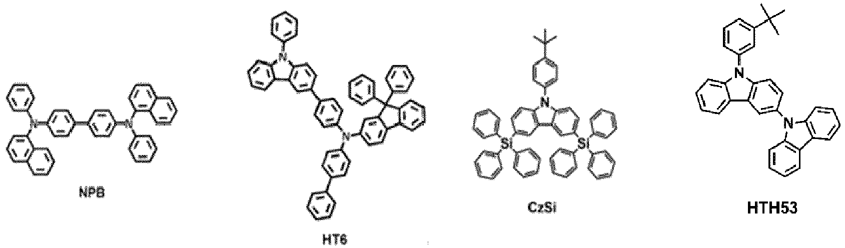

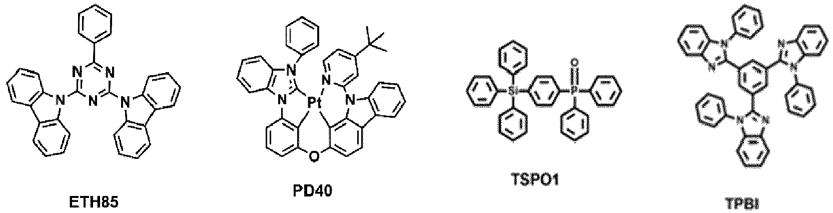

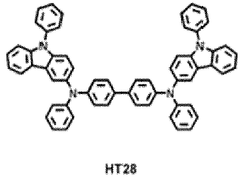

### Examples 2 to 5 and Comparative Examples 1 to 8

Light-emitting devices were manufactured in substantially the same manner as in Example 1, except that, in forming the emission layer, the compounds shown in Table 3 were used as luminescent materials.

### Evaluation Example 2

In order to evaluate characteristics of the light-emitting devices manufactured in Examples 1 to 5 and Comparative Examples 1 to 8, each of driving voltage (V) at 1,000cd/m² of luminance, emission efficiency (Cd/A), and emission wavelength was measured by using a Keithley MU 236 and a luminance meter PR650, the lifespan (T₉₅) was obtained by measuring the time taken for the luminance to reach 95 % relative to the initial luminance and calculated as a relative value based on the lifespan value of Comparative Example 1 as 1, and results thereof are shown in Table 3.

**Table 3**

| | Hole transpor t layer | Host (HT:ET = 5:5) | Sensitizer (15%) | Luminesce nt material (3 %) | Driving voltage (V) | Emissi on efficien cy (cd/A) | Emissi on wavele ngth (nm) | Lifespan ratio (T₉₅) |
|---|---|---|---|---|---|---|---|---|
| Example 1 | HT6 | HT-1/ET-1 | PS-1 | 14 | 4.1 | 32.2 | 457 | 7.5 |
| Example 2 | HT6 | HT-1/ET-1 | PS-1 | 25 | 4.2 | 31.7 | 457 | 7.3 |
| Example 3 | HT6 | HT-1/ET-1 | PS-1 | 49 | 4.0 | 32.5 | 460 | 7.4 |
| Example 4 | HT6 | HT-1/ET-1 | PS-1 | 57 | 4.2 | 31.3 | 461 | 8.0 |
| Example 5 | HT6 | HT-1/ET-1 | PS-1 | 72 | 4.3 | 30.9 | 462 | 8.3 |
| Comparative Example 1 | HT6 | HT-1/ET-1 | PS-1 | DABNA-1 | 4.8 | 19.2 | 457 | 1 |
| Comparative Example 2 | HT6 | HT-1/ET-1 | PS-1 | DABNA-2 | 4.7 | 21.3 | 456 | 0.8 |
| Comparative Example 3 | HT6 | HT-1/ET-1 | PS-1 | C1 | 4.6 | 24.6 | 462 | 2.5 |
| Comparative Example 4 | HT6 | HT-1/ET-1 | PS-1 | C2 | 5.5 | 18.8 | 450 | 0.2 |
| Comparative Example 5 | HT6 | HT-1/ET-1 | PS-1 | C3 | 5.2 | 16.2 | 470 | 0.7 |
| Comparative Example 6 | HT6 | HT-1/ET-1 | PS-1 | C4 | 5.1 | 19.1. | 466 | 0.2 |
| Comparative Example 7 | HT6 | HT-1/ET-1 | PS-1 | C5 | 5.3 | 20.8 | 464 | 0.3 |
| Comparative Example 8 | HT6 | HT-1/ET-1 | PS-1 | C6 | 5.1 | 18.5 | 465 | 0.3 |

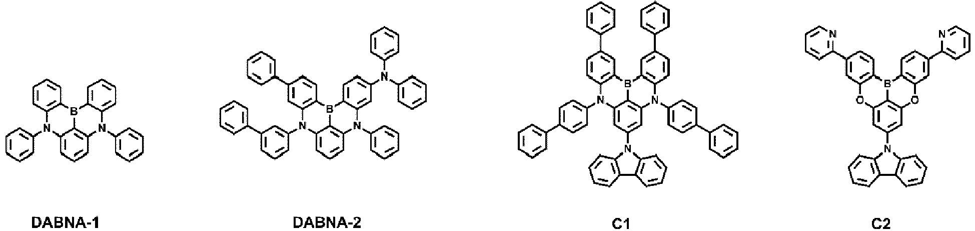

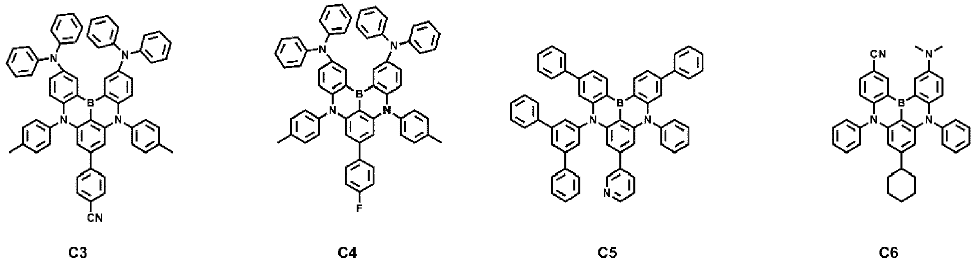

From Table 3, it can be seen that the light-emitting devices of Examples 1 to 5 had lower driving voltage, better emission efficiency, and longer lifespan than those of the light-emitting devices of Comparative Examples 1 to 8.

Embodiments of the disclosure relate to a condensed cyclic compound, a light-emitting device including the same, and an electronic apparatus including the same, wherein the condensed cyclic compound of the present application may have excellent thermal stability and excellent radical stability, and the light-emitting device and the electronic apparatus including the same may have high emission efficiency and long lifespan.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A condensed cyclic compound represented by Formula 1: 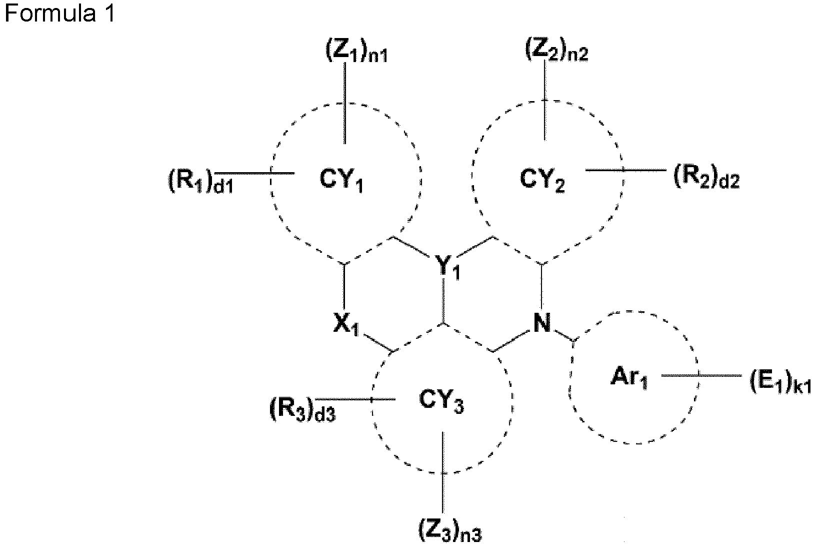 wherein, in Formula 1,
CY₁ to CY₃ are each independently a C₅-C₃₀ carbocyclic group or a C₂-C₃₀ heterocyclic group,
X₁ is O, S, Se, C(R₄)(R₅), Si(R₄)(R₅), or N(R₄),
Y₁ is B, P(=O), or P(=S),
Z₁ to Z₃ satisfy Condition 1 or Condition 2,
Condition 1
Z₁ and Z₂ are each independently an electron withdrawing group, and Z₃ is an electron donating group
Condition 2
Z₁ and Z₂ are each independently an electron donating group, and Z₃ is an electron withdrawing group
wherein the electron withdrawing group is: -F or a cyano group; a C₁-C₆₀ alkyl group, a C₂-C₆₀ alkenyl group, a C₂-C₆₀ alkynyl group, a C₃-C₆₀ carbocyclic group, or a C₁-C₆₀ heterocyclic group, each substituted with -F, a cyano group, or any combination thereof; or a π electron-deficient nitrogen-containing C₁-C₆₀ cyclic group, and
the electron donating group is -N(R₆)(R₇) or a π electron-rich C₃-C₆₀ cyclic group that is unsubstituted or substituted with at least one R₁₀ₐ, wherein a benzene group and a cyclohexene group, each unsubstituted or substituted with at least one R₁₀ₐ, are excluded,
n1 and n2 are each independently an integer from 0 to 10, wherein a sum of n1 and n2 is an integer of 1 or more,
n3 is an integer from 1 to 10,
R₁ to R₇ are each independently hydrogen, deuterium, -F, -Cl, -Br, -I, a hydroxyl group, a cyano group, a nitro group, a C₁-C₆₀ alkyl group that is unsubstituted or substituted with at least one R₁₀ₐ, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
d1 to d3 are each independently an integer from 0 to 10,
two or more neighboring groups of R₁ to R₇ are optionally bonded to each other to form a C₅-C₃₀ carbocyclic group that is unsubstituted or substituted with at least one R₁₀ₐ or a C₂-C₃₀ heterocyclic group that is unsubstituted or substituted with at least one R₁₀ₐ,
Ar₁ is a C₅-C₃₀ carbocyclic group or a C₂-C₃₀ heterocyclic group,
E₁ is hydrogen, deuterium, -F, -Cl, -Br, -I, a hydroxyl group, a cyano group, a nitro group, a C₂-C₆₀ alkenyl group that is unsubstituted or substituted with at least one R₁₀ₐ, a C₂-C₆₀ alkynyl group that is unsubstituted or substituted with at least one R₁₀ₐ, a C₁-C₆₀ alkoxy group that is unsubstituted or substituted with at least one R₁₀ₐ, a C₃-C₆₀ carbocyclic group that is unsubstituted or substituted with at least one R₁₀ₐ, a C₁-C₆₀ heterocyclic group that is unsubstituted or substituted with at least one R₁₀ₐ, a C₆-C₆₀ aryloxy group that is unsubstituted or substituted with at least one R₁₀ₐ, a C₆-C₆₀ arylthio group that is unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂),
k1 is an integer from 0 to 10,
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(O₁₁), -S(=O)₂(O₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇₋C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇₋C₆₀ aryl alkyl group; or a C₂-C₆₀ heteroaryl alkyl group.

2. The condensed cyclic compound of claim 1, wherein E₁ is not hydrogen, and k1 is an integer of 1 or more.

3. The condensed cyclic compound of claim 1 or 2, wherein R₄ is a C₅-C₃₀ carbocyclic group that is unsubstituted or substituted with at least one R₁₀ₐ or a C₂-C₃₀ heterocyclic group that is unsubstituted or substituted with at least one R₁₀ₐ, and
R₁₀ₐ is the same as described with respect to Formula 1.

4. The condensed cyclic compound of at least one of claims 1 to 3, wherein the π electron-deficient nitrogen-containing C₁-C₆₀ cyclic group is a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, or an azadibenzofuran group, and
the π electron-rich C₃-C₆₀ cyclic group is a cyclopentadiene group, an adamantane group, a norbornane group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indeno phenanthrene group, an indenoanthracene group, a 1H-pyrrole group, a silole group, a borole group, a 2H-pyrrole group, a 3H-pyrrole group, a thiophene group, a furan group, an indole group, a benzoindole group, a naphthoindole group, an iso-indole group, a benzoiso-indole group, a naphthoiso-indole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, or a benzothienodibenzothiophene group.

5. The condensed cyclic compound of at least one of claims 1 to 4, wherein a sum of n1 and n2 is an integer of 2 or more.

6. The condensed cyclic compound of at least one of claims 1 to 5, wherein Z₁ and Z₂ are identical to or different from each other.

7. The condensed cyclic compound of at least one of claims 1 to 6, wherein a moiety represented by 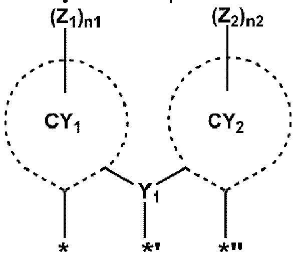 in Formula 1 is one of Formulae 2-1 to 2-16: 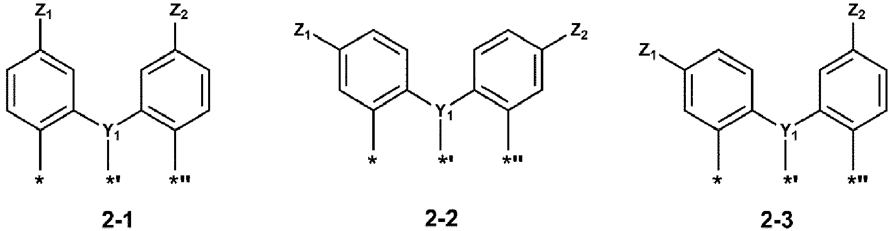 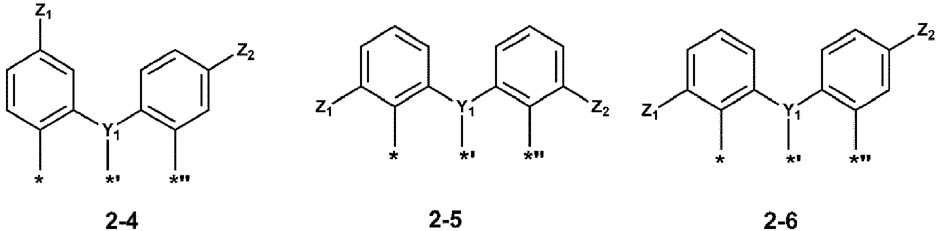 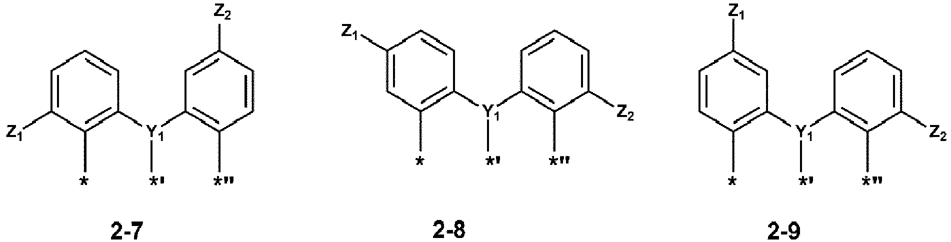 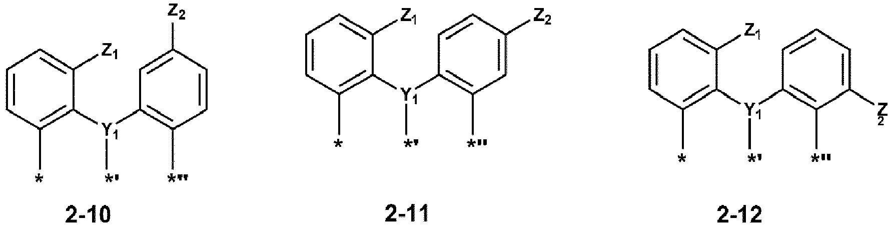 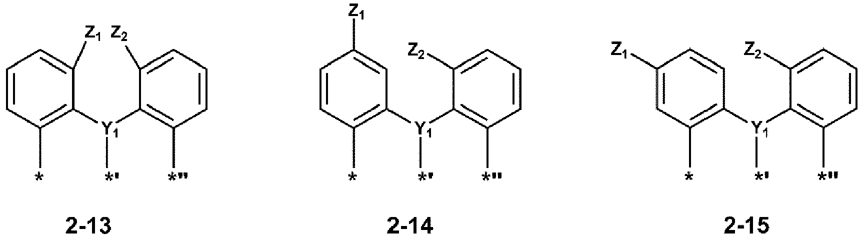 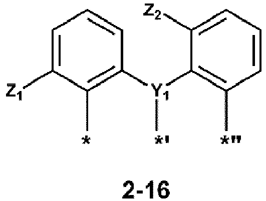 wherein, in Formulae 2-1 to 2-16,
Z₁, Z₂, and Y₁ are each independently the same as described with respect to Formula 1, and
*, *', and *" each indicate a binding site to a neighboring atom.

8. The condensed cyclic compound of at least one of claims 1 to 7, wherein a moiety represented by 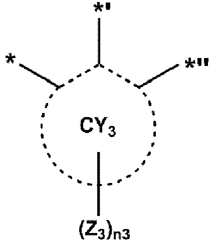 in Formula 1 is one of Formulae 3-1 to 3-3: 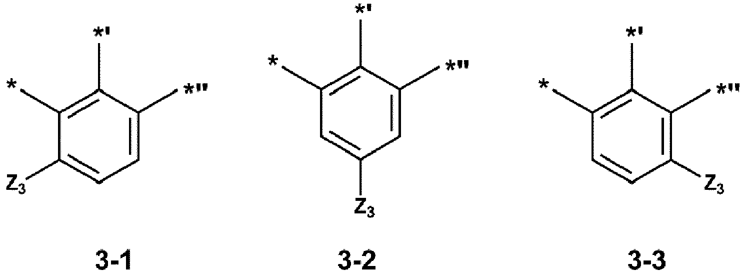 wherein, in Formulae 3-1 to 3-3,
Z₃ is the same as described with respect to Formula 1, and
*, *', and *" each indicate a binding site to a neighboring atom.

9. The condensed cyclic compound of at least one of claims 1 to 8, wherein the condensed cyclic compound represented by Formula 1 satisfies at least one of Condition 3 and Condition 4:
Condition 3
a highest occupied molecular orbital (HOMO) energy of the condensed cyclic compound is -4.80 eV or less; and
Condition 4
a lowest unoccupied molecular orbital (LUMO) energy of the condensed cyclic compound is -1.30 eV or less.

10. The condensed cyclic compound of at least one of claims 1 to 9, wherein the condensed cyclic compound is one of Compounds 1 to 72:

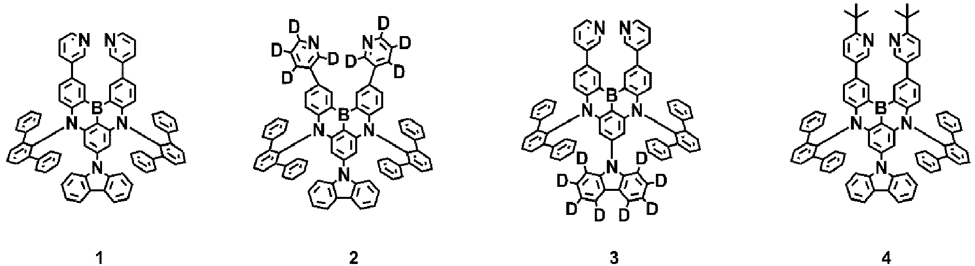

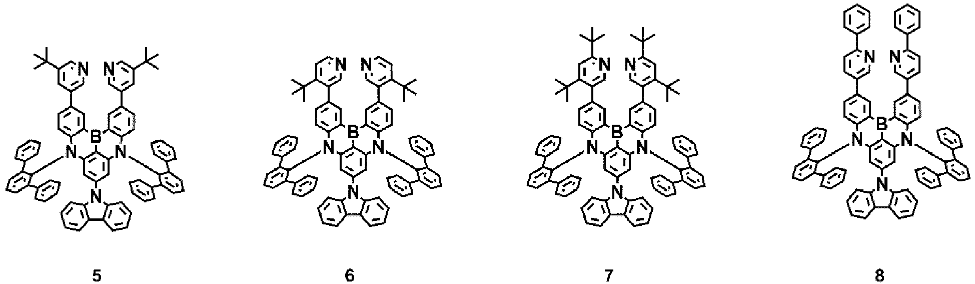

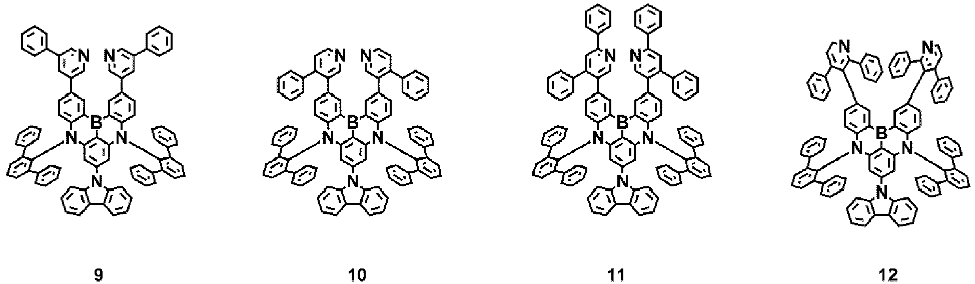

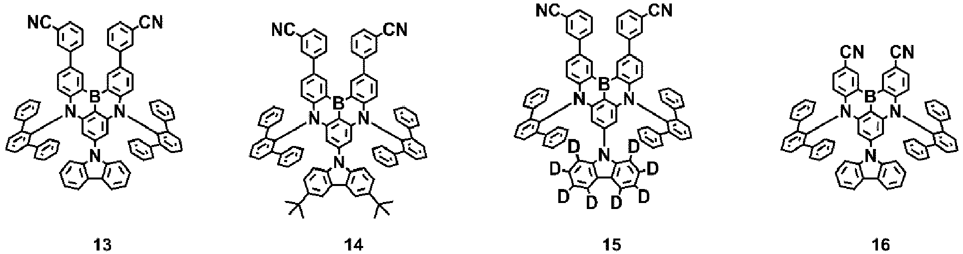

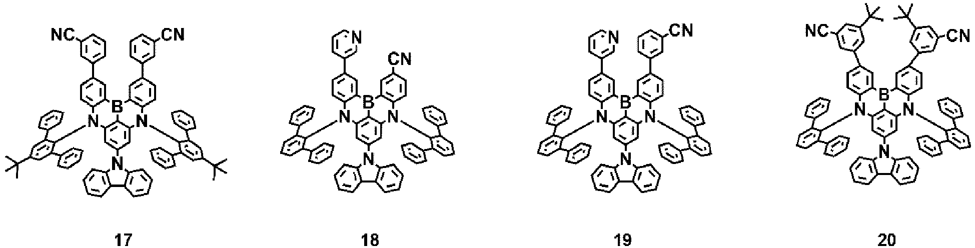

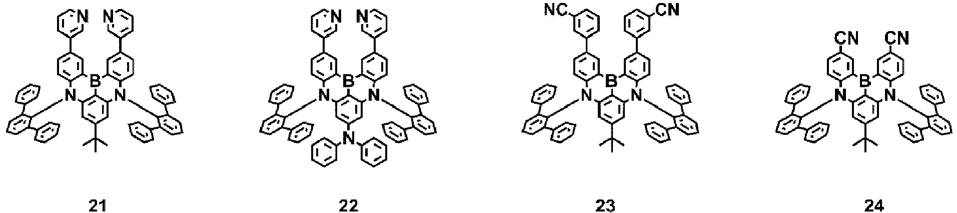

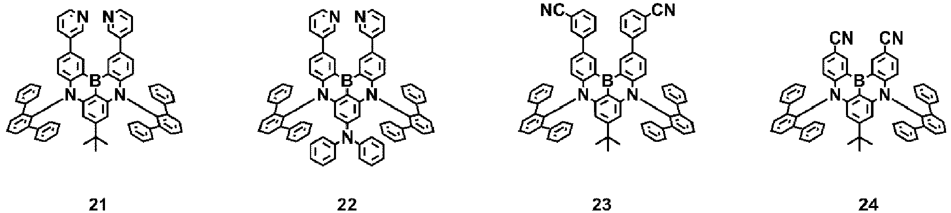

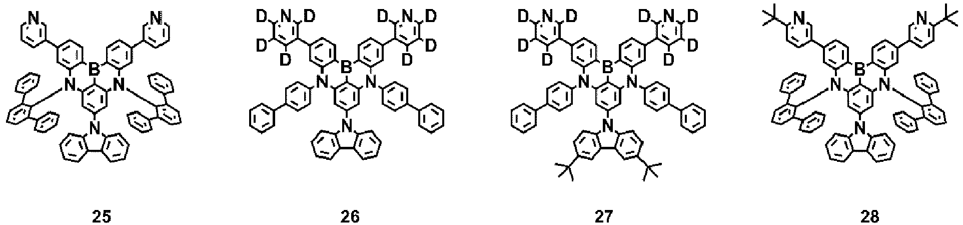

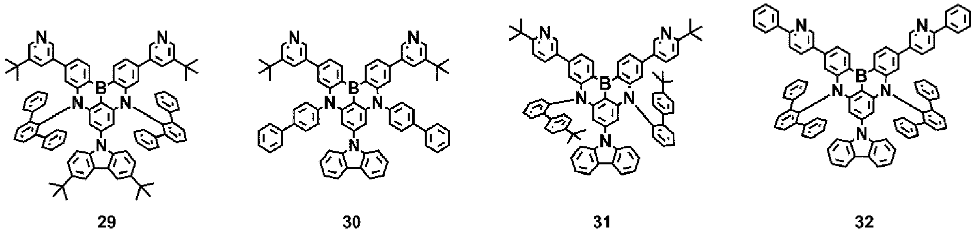

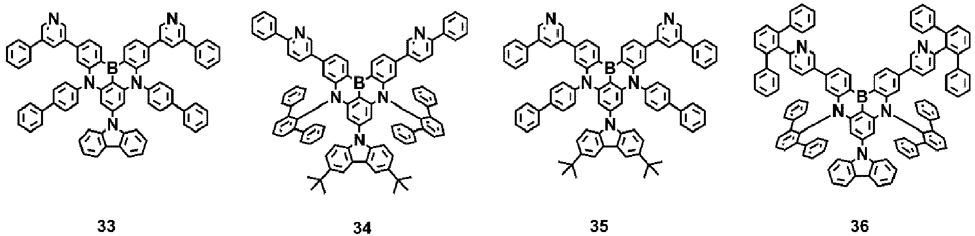

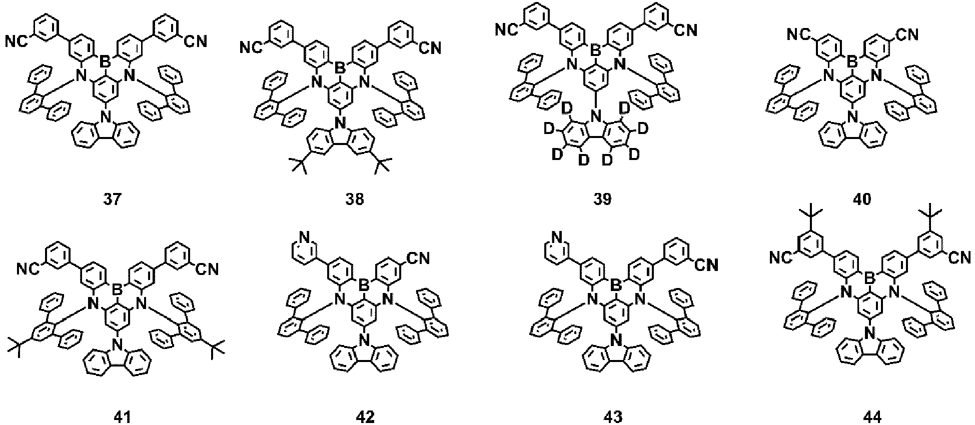

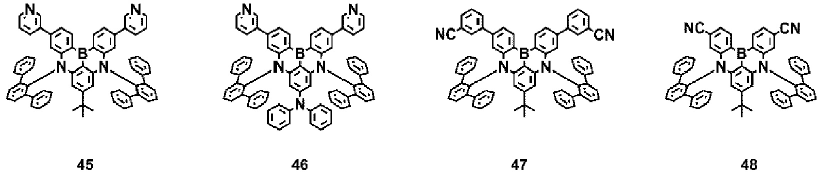

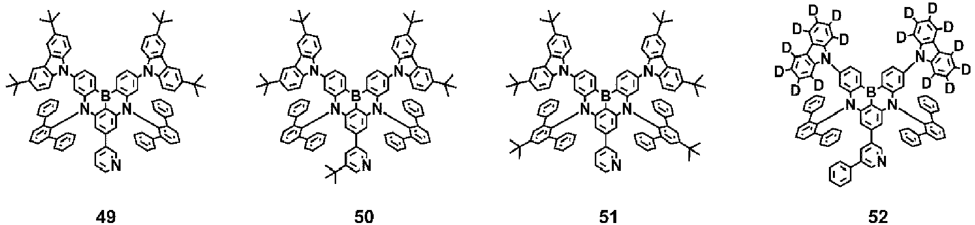

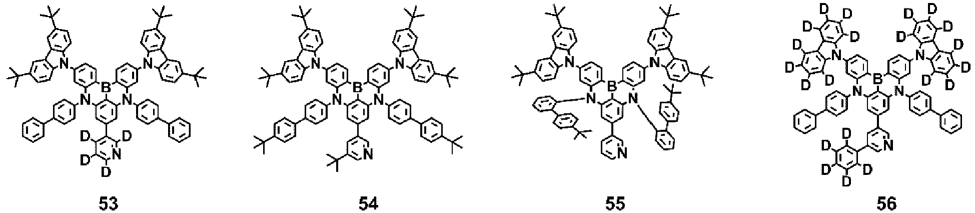

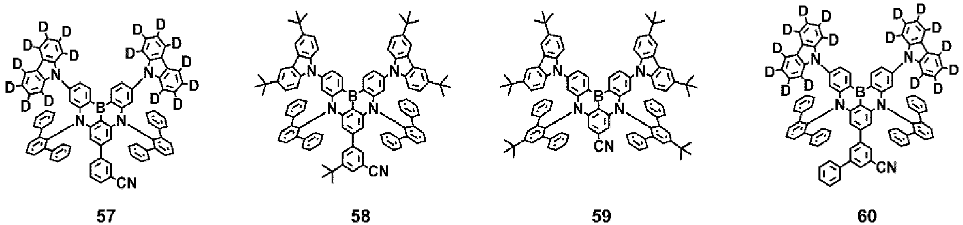

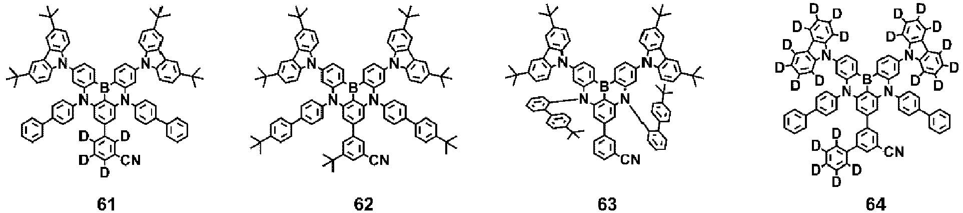

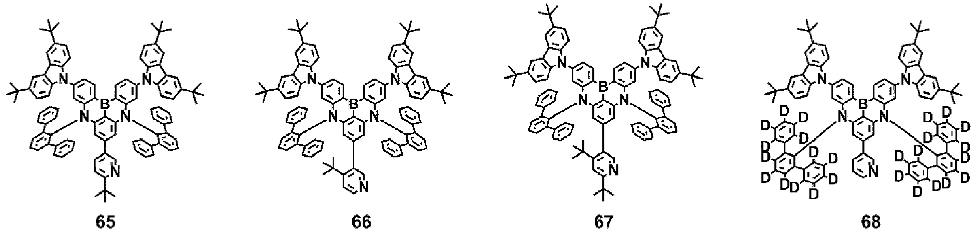

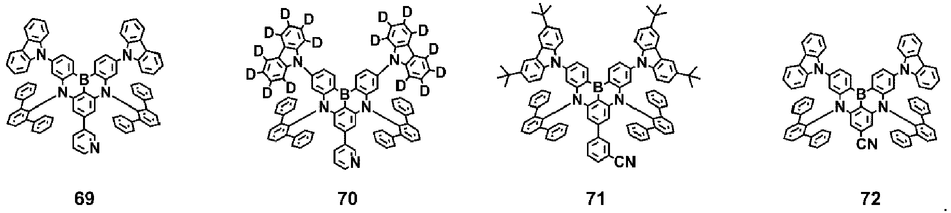

11. A light-emitting device (10) comprising:
a first electrode (110);
a second electrode (150) facing the first electrode (110);
an interlayer (130) between the first electrode (110) and the second electrode (150) and comprising an emission layer; and
at least one condensed cyclic compound according to at least one of claims 1 to 10.

12. The light-emitting device (10) of claim 11, wherein the first electrode (110) is an anode,
the second electrode (150) is a cathode,
the interlayer (130) comprises the at least one condensed cyclic compound,
the interlayer (130) further comprises a hole transport region between the first electrode (110) and the emission layer and an electron transport region between the emission layer and the second electrode (150),
the hole transport region comprises a hole injection layer, a hole transport layer, an emission auxiliary layer, an electron blocking layer, or any combination thereof, and
the electron transport region comprises a hole blocking layer, an electron transport layer, an electron injection layer, or any combination thereof.

13. The light-emitting device (10) of claim 11 or 12, wherein the emission layer comprises the at least one condensed cyclic compound represented by Formula 1.

14. The light-emitting device (10) of claim 13, wherein an amount of the at least one condensed cyclic compound is 0.01 parts by weight to 49.99 parts by weight, based on 100 parts by weight of the emission layer.

15. The light-emitting device (10) of claim 13 or 14, wherein the emission layer further comprises a first compound and a second compound,
the first compound is a hole-transporting compound, and
the second compound is an electron-transporting compound.

16. The light-emitting device (10) of at least one of claims 13 to 15, wherein the emission layer further comprises a third compound, and
the third compound is a metal-containing compound.

17. The light-emitting device (10) of at least one of claims 11 to 16, wherein the emission layer emits light having a maximum emission wavelength of 400 nm to 500 nm.

18. An electronic apparatus comprising the light-emitting device (10) of any one of claims 11 to 17.

19. The electronic apparatus of claim 18, further comprising a thin-film transistor,
wherein the thin-film transistor comprises a source electrode (260) and a drain electrode (270), and
the first electrode (110) of the light-emitting device (10) is electrically connected to at least one of the source electrode (260) and the drain electrode (270) of the thin-film transistor.

20. The electronic apparatus of claim 8 or 9, further comprising a color filter, a color conversion layer, a touch screen layer, a polarizing layer, or any combination thereof.
